# EUROPEAN PATENT APPLICATION

(11) **EP 2 202 257 A1**
(43) Date of publication of application: **30.06.2010**
(21) Application number: 08837905.2
(22) Date of filing: 09.10.2008
(51) Int. Cl.: C08G 61/12, C09K 11/06, H01L 29/786, H01L 51/05, H01L 51/30, H01L 51/42, H01L 51/50

(54) **POLYMER COMPOUND AND POLYMER LIGHT-EMITTING DEVICE USING THE SAME**

(30) Priority: 10.10.2007 JP 2007264157
(71) Applicant: Sumitomo Chemical Company, Limited, Tokyo 104-8260 (JP)
(72) Inventor: MORIWAKI, Shota, Tsukuba-shi Ibaraki 305-0821 (JP); FUKUSHIMA, Daisuke, Tsukuba-shi Ibaraki 305-0045 (JP)
(74) Representative: Duckworth, Timothy John
(86) International application number: PCT/JP2008/068805
(87) International publication number: WO 2009/048164

(57) **Abstract**

A polymer compound comprising a repeating unit of the formula (1), and a repeating unit selected from the group consisting of a repeating unit of the formula (2) and a repeating unit of the formula (3): 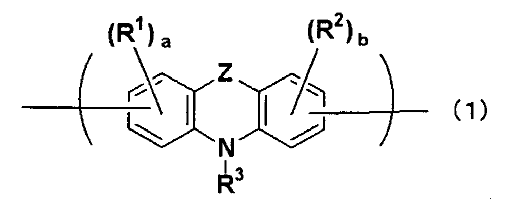 [wherein, R³ represents an alkyl group, R¹ and R² represent an alkyl group, alkoxy group or the like, a and b represent an integer of 0 to 3. Z represents -O- or -S-.] 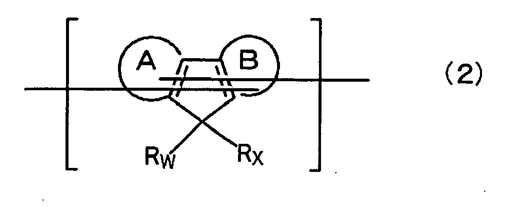 [wherein, ring A and ring B represent an aromatic hydrocarbon ring, and at least one of ring A and ring B is an aromatic hydrocarbon ring obtained by condensation of two or more benzene rings. R_{w} and Rₓ represent a hydrogen atom, alkyl group or the like. R_{w} and Rₓ may be mutually connected to form a ring.] 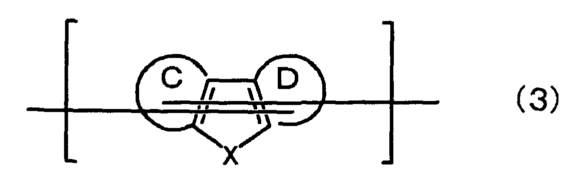 [wherein, ring C and ring D represent an aromatic ring, X represents -O-, -S- or the like.]

## Description

### Technical Field

The present invention relates to a polymer compound and a polymer light-emitting device using the same.

### Background Art

Various polymer compounds have been investigated as a material to be used in a polymer light-emitting device, and as an example thereof, a polymer compound containing a fluorenediyl group and a phenoxazinediyl group having an alkyl group at the N-position, as a repeating unit, is known (see, non-patent document 1).
[Non-patent document 1] Macromolecules; 2005, 38, 7983-7991

### Disclosure of the Invention

When the above-described polymer compound is used in a polymer light-emitting device, however, its light emitting efficiency is not necessarily sufficient.
An object of the present invention is to provide a polymer compound which gives a polymer light-emitting device of high light emitting efficiency.
That is, in the first aspect, the present invention provides a polymer compound comprising a repeating unit of the formula (1), and at least one repeating unit selected from the group consisting of a repeating unit of the formula (2) and a repeating unit of the formula (3): 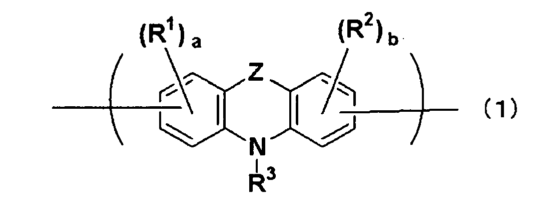 [in the formula (1), R³ represents an alkyl group, R¹ and R² represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group or nitro group, a and b represent each independently an integer of 0 to 3. Z represents -O- or - S-. When there exists a plurality of R¹, they may be the same or different. When there exists a plurality of R², they may be the same or different.] 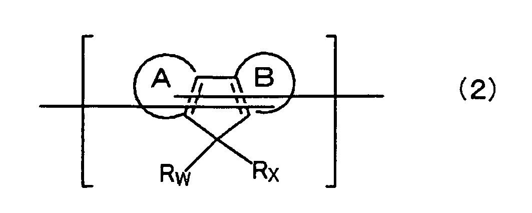 [in the formula (2), ring A and ring B represent each independently an aromatic hydrocarbon ring optionally having a substituent, at least one of ring A and ring B is an aromatic hydrocarbon ring obtained by condensation of two or more benzene rings, two connecting bonds are respectively present on ring A or ring B. R_{w} and Rₓ represent each independently a hydrogen atom, alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group or cyano group. R_{w} and Rₓ may be mutually connected to form a ring.] 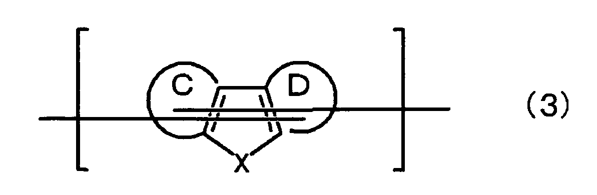 [in the formula (3), ring C and ring D represent each independently an aromatic ring optionally having a substituent, two connecting bonds are respectively present on ring C or ring D. X represents -O-, -S-, -S(=O)-, - S(=O)₂-, -Si(R⁴)₂-Si(R⁴)₂-, -Si(R⁴)2-, -B(R⁴)-, -P(R⁴)-, - P(=O)(R⁴)-, -O-C(R⁴)₂- or -N=C(R⁴)-, R⁴ represents a hydrogen atom, alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group or cyano group. When there exists a plurality of R⁴, they may be the same or different.]

In the second aspect, the present invention provides a composition comprising the above-described polymer compound.

In the third aspect, the present invention provides a polymer light-emitting device having electrodes consisting of an anode and a cathode, and a layer containing the above-described polymer compound between the electrodes.

In the fourth aspect, the present invention provides a liquid composition comprising the above-described polymer compound and a solvent.

In the fifth aspect, the present invention provides a thin film comprising the above-described polymer compound.

In the sixth aspect, the present invention provides an organic transistor comprising the above-described polymer compound.

In the seventh aspect, the present invention provides a solar battery comprising the above-described polymer compound.

### Embodiments for Carrying Out the Invention

The polymer compound of the present invention comprises a repeating unit of the formula (1). In the above-described formula (1), R¹ and R² represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group or nitro group. When there exists a plurality of R¹, they may be the same or different. When there exists a plurality of R², they may be the same or different.

Here, the alkyl group may be linear or branched, and may also be a cycloalkyl group. The carbon number thereof is usually about 1 to 20, and the alkyl group includes a methyl group, ethyl group, n-propyl group, i-propyl group, n-butyl group, i-butyl group, t-butyl group, s-butyl group, 3-methylbutyl group, n-pentyl group, n-hexyl group, 2-ethylhexyl group, n-heptyl group, n-octyl group, n-nonyl group, n-decyl group, 3,7-dimethyloctyl group and n-lauryl group. A hydrogen atom in the above-described alkyl group may be substituted by a fluorine atom. The alkyl group substituted by a fluorine atom includes a trifluoromethyl group, pentafluoroethyl group, perfluorobutyl group, perfluorohexyl group and perfluorooctyl group.

The alkoxy group may be linear or branched, and may also be a cycloalkyloxy group. The carbon number thereof is usually about 1 to 20, and the alkoxy group includes a methoxy group, ethoxy group, n-propyloxy group, i-propyloxy group, n-butoxy group, i-butoxy group, s-butoxy group, t-butoxy group, n-pentyloxy group, n-hexyloxy group, cyclohexyloxy group, n-heptyloxy group, n-octyloxy group, 2-ethylhexyloxy group, n-nonyloxy group, n-decyloxy group, 3,7-dimethyloctyloxy group and n-lauryloxy group. A hydrogen atom in the above-described alkoxy group may be substituted by a fluorine atom. The alkoxy group substituted by a fluorine atom includes a trifluoromethoxy group, pentafluoroethoxy group, perfluorobutoxy group, perfluorohexyl group and perfluorooctyl group.

The alkylthio group may be linear or branched, and may also be a cyclo alkylthio group. The carbon number thereof is usually about 1 to 20, and the alkylthio group includes a methylthio group, ethylthio group, n-propylthio group, isopropylthio group, n-butylthio group, isobutylthio group, s-butylthio group, t-butylthio group, n-pentylthio group, n-hexylthio group, cyclohexylthio group, n-heptylthio group, n-octylthio group, 2-ethylhexylthio group, n-nonylthio group, n-decylthio group, 3,7-dimethyloctylthio group, n-laurylthio group and the like. A hydrogen atom in the above-described alkylthio group may be substituted by a fluorine atom. The alkylthio group substituted by a fluorine atom includes a trifluoromethylthio group.

The aryl group means an atomic group derived from an aromatic hydrocarbon by removal of a hydrogen atom, and includes also those having a benzene ring, those having a condensed ring, and those having two or more independent benzene rings or condensed rings bonded directly or via a di-valent group such as a vinylene group and the like. The aryl group has a carbon number of usually about 6 to 60, preferably 6 to 48. The above-described aryl group may have a substituent. This substituent includes linear or branched alkyl groups having a carbon number of 1 to 20 or cycloalkyl groups having a carbon number of 1 to 20, alkoxy groups containing in its structure a linear or branched alkyl group having a carbon number of 1 to 20 or a cycloalkyl group having a carbon number of 1 to 20, and groups of the following formula (5).

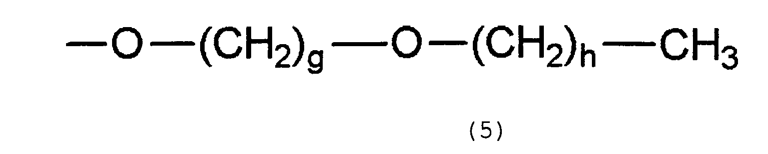

### (in the formula (5), g represents an integer of 1 to 6, h represents an integer of 0 to 5.)

The aryl group includes a phenyl group, C₁ to C₁₂ alkoxyphenyl group (C₁ to C₁₂ means that the carbon number thereof is 1 to 12; hereinafter, the same shall apply in this specification.), C₁ to C₁₂ alkylphenyl group, 1-naphthyl group, 2-naphthyl group, 1-anthracenyl group, 2-anthracenyl group, 9-anthracenyl group, pentafluorophenyl group and the like, and preferable are a C₁ to C₁₂ alkoxyphenyl group and C₁ to C₁₂ alkylphenyl group. The C₁ to C₁₂ alkoxyphenyl group includes a methoxyphenyl group, ethoxyphenyl group, n-propyloxyphenyl group, isopropyloxyphenyl group, n-butoxyphenyl group, isobutoxyphenyl group, s-butoxyphenyl group, t-butoxyphenyl group, n-pentyloxyphenyl group, n-hexyloxyphenyl group, cyclohexyloxyphenyl group, n-heptyloxyphenyl group, n-octyloxyphenyl group, 2-ethylhexyloxyphenyl group, n-nonyloxyphenyl group, n-decyloxyphenyl group, 3,7-dimethyloctyloxyphenyl group and n-lauryloxyphenyl group. The C₁ to C₁₂ alkylphenyl group includes a methylphenyl group, ethylphenyl group, dimethylphenyl group, n-propylphenyl group, mesityl group, methylethylphenyl group, isopropylphenyl group, n-butylphenyl group, isobutylphenyl group, s-butylphenyl group, t-butylphenyl group, n-pentylphenyl group, isoamylphenyl group, hexylphenyl group, n-heptylphenyl group, n-octylphenyl group, n-nonylphenyl group, n-decylphenyl group and n-dodecylphenyl group. A hydrogen atom in the above-described aryl group may be substituted by a fluorine atom.
The aryloxy group has a carbon number of usually about 6 to 60, preferably 6 to 48, and the aryloxy group includes a phenoxy group, C₁ to C₁₂ alkoxyphenoxy group, C₁ to C₁₂ alkylphenoxy group, 1-naphthyloxy group, 2-naphthyloxy group and pentafluorophenyloxy group, and preferable are a C₁ to C₁₂ alkoxyphenoxy group and C₁ to C₁₂ alkylphenoxy group. The C₁ to C₁₂ alkoxy includes methoxy, ethoxy, n-propyloxy, isopropyloxy, n-butoxy, isobutoxy, s-butoxy, t-butoxy, n-pentyloxy, n-hexyloxy, cyclohexyloxy, n-heptyloxy, n-octyloxy, 2-ethylhexyloxy, n-nonyloxy, n-decyloxy, 3,7-dimethyloctyloxy, n-lauryloxy and the like. The C₁ to C₁₂ alkylphenoxy group includes a methylphenoxy group, ethylphenoxy group, dimethylphenoxy group, n-propylphenoxy group, 1,3,5-trimethylphenoxy group, methylethylphenoxy group, isopropylphenoxy group, n-butylphenoxy group,
isobutylphenoxy group, s-butylphenoxy group, t-butylphenoxy group, n-pentylphenoxy group, isoamylphenoxy group, n-hexylphenoxy group, n-heptylphenoxy group, n-octylphenoxy group, n-nonylphenoxy group, n-decylphenoxy group and n-dodecylphenoxy group.

The arylthio group may have a substituent on an aromatic ring, the carbon number thereof is usually about 6 to 60, and the arylthio group includes a phenylthio group, C₁ to C₁₂ alkoxyphenylthio group, C₁ to C₁₂ alkylphenylthio group,
1-naphthylthio group, 2-naphthylthio group, pentafluorophenylthio group, pyridylthio group, pyridazinylthio group, pyrimidylthio group, pyrazylthio group, triazylthio group and the like.

The arylalkyl group may have a substituent, the carbon number thereof is usually about 7 to 60, and the arylalkyl group includes a phenyl-C₁ to C₁₂alkyl group, C₁ to C₁₂ alkoxyphenyl-C₁ to C₁₂alkyl group, C₁ to C₁₂ alkylphenyl-C₁ to C₁₂ alkyl group, 1-naphthyl-C₁ to C₁₂ alkyl group and 2-naphthyl-C₁ to C₁₂ alkyl group.

The arylalkoxy group may have a substituent, the carbon number thereof is usually about 7 to 60, and the arylalkoxy group includes a phenyl-C₁ to C₁₂ alkoxy group, C₁ to C₁₂ alkoxyphenyl-C₁ to C₁₂ alkoxy group, C₁ to C₁₂ alkylphenyl-C₁ to C₁₂ alkoxy group, 1-naphthyl-C₁ to C₁₂ alkoxy group and 2-naphthyl-C₁ to C₁₂ alkoxy group.

The aryl alkylthio group may have a substituent, the carbon number thereof is usually about 7 to 60, and the aryl alkylthio group includes a phenyl-C₁ to C₁₂ alkylthio group, C₁ to C₁₂ alkoxyphenyl-C₁ to C₁₂ alkylthio group, C₁ to C₁₂ alkylphenyl-C₁ to C₁₂ alkylthio group, 1-naphthyl-C₁ to C₁₂ alkylthio group, 2-naphthyl-C₁ to C₁₂ alkylthio group and the like.

The arylalkenyl group has a carbon number of usually about 8 to 60, and the arylalkenyl group includes a phenyl-C₂ to C₁₂ alkenyl group, C₁ to C₁₂ alkoxyphenyl-C₂ to C₁₂ alkenyl group, C₁ to C₁₂ alkylphenyl-C₂ to C₁₂ alkenyl group, 1-naphthyl-C₂ to C₁₂ alkenyl group and 2-naphthyl-C₂ to C₁₂ alkenyl group, and preferable are a C₁ to C₁₂ alkoxyphenyl-C₂ to C₁₂ alkenyl group and C₂ to C₁₂ alkylphenyl-C₁ to C₁₂ alkenyl group.

The arylalkynyl group has a carbon number of usually about 8 to 60, and the arylalkynyl group includes a phenyl-C₂ to C₁₂ alkynyl group, C₁ to C₁₂ alkoxyphenyl-C₂ to C₁₂ alkynyl group, C₁ to C₁₂ alkylphenyl-C₂ to C₁₂ alkynyl group, 1-naphthyl-C₂ to C₁₂ alkynyl group and 2-naphthyl-C₂ to C₁₂ alkynyl group, and preferable are a C₁ to C₁₂ alkoxyphenyl-C₂ to C₁₂ alkynyl group and C₁ to C₁₂ alkylphenyl-C₂ to C₁₂ alkynyl group.

The substituted amino group includes amino groups substituted by one or two groups selected from alkyl groups, aryl groups, arylalkyl groups and mono-valent heterocyclic groups. When the substituted amino group is an amino group substituted by two groups, these two groups may be connected to form a ring. The above-described alkyl group, aryl group, arylalkyl group or mono-valent heterocyclic group may have a substituent. The carbon number of the substituted amino group is usually about 1 to 60, preferably 2 to 48 not including the carbon number of the substituent. The substituted amino group includes a methylamino group, dimethylamino group, ethylamino group, diethylamino group, n-propylamino group, di-n-propylamino group, isopropylamino group, diisopropylamino group, n-butylamino group, s-butylamino group, isobutylamino group, t-butylamino group, n-pentylamino group, n-hexylamino group, cyclohexylamino group, n-heptylamino group, n-octylamino group, 2-ethylhexylamino group, n-nonylamino group, n-decylamino group, 3,7-dimethyloctylamino group, n-laurylamino group, cyclopentylamino group, dicyclopentylamino group, cyclohexylamino group, dicyclohexylamino group, pyrrolidyl group, piperidyl group, ditrifluoromethylamino group, phenylamino group, diphenylamino group, C₁ to C₁₂ alkoxyphenylamino group, di(C₁ to C₁₂ alkoxyphenyl)amino group, di(C₁ to C₁₂ alkylphenyl)amino group, 1-naphthylamino group, 2-naphthylamino group, pentafluorophenylamino group, pyridylamino group, pyridazinylamino group, pyrimidylamino group, pyrazylamino group, triazylamino group, phenyl-C₁ to C₁₂ alkylamino group, C₁ to C₁₂ alkoxyphenyl-C₁ to C₁₂ alkylamino group, C₁ to C₁₂ alkylphenyl-C₁ to C₁₂ alkylamino group, di(C₁ to C₁₂ alkoxyphenyl-C₁ to C₁₂ alkyl) amino group, di (C₁ to C₁₂ alkylphenyl-C₁ to C₁₂alkyl)amino group, 1-naphthyl-C₁ to C₁₂ alkylamino group and 2-naphthyl-C₁ to C₁₂ alkylamino group.

The substituted silyl group includes silyl groups substituted by one, two or three groups selected from alkyl groups, aryl groups, arylalkyl groups and mono-valent heterocyclic groups. The substituted silyl group has a carbon number of usually about 1 to 60, preferably 3 to 48. The alkyl group, aryl group, arylalkyl group or mono-valent heterocyclic group may have a substituent. The substituted silyl group includes a trimethylsilyl group, triethylsilyl group, tri-n-propylsilyl group, triisopropylsilyl group, dimethyl-isopropylsilyl group, diethyl-isopropylsilyl group, t-butylsilyldimethylsilyl group, n-pentyldimethylsilyl group, n-hexyldimethylsilyl group, n-heptyldimethylsilyl group, n-octyldimethylsilyl group, 2-ethylhexyl-dimethylsilyl group, n-nonyldimethylsilyl group, n-decyldimethylsilyl group, 3,7-dimethyloctyl-dimethylsilyl group, n-lauryldimethylsilyl group, phenyl-C₁ to C₁₂ alkylsilyl group, C₁ to C₁₂ alkoxyphenyl-C₁ to C₁₂ alkylsilyl group, C₁ to C₁₂ alkylphenyl-C₁ to C₁₂ alkylsilyl group, 1-naphthyl-C₁ to C₁₂ alkylsilyl group, 2-naphthyl-C₁ to C₁₂ alkylsilyl group, phenyl-C₁ to C₁₂ alkyldimethylsilyl group, triphenylsilyl group, tri-p-xylylsilyl group, tribenzylsilyl group, diphenylmethylsilyl group, t-butyldiphenylsilyl group, dimethylphenylsilyl group and the like.

The halogen atom includes a fluorine atom, chlorine atom, bromine atom and iodine atom.

The acyl group has a carbon number of usually about 2 to 20, preferably 2 to 18, and the acyl group includes an acetyl group, propionyl group, butyryl group, isobutyryl group, pivaloyl group, benzoyl group, trifluoroacetyl group and pentafluorobenzoyl group.

The acyloxy group has a carbon number of usually about 2 to 20, preferably 2 to 18, and the acyloxy group includes an acetoxy group, propionyloxy group, butyryloxy group, isobutyryloxy group, pivaloyloxy group, benzoyloxy group, trifluoroacetyloxy group and pentafluorobenzoyloxy group.

The imine residue includes residues obtained by removing one hydrogen atom from imine compounds (namely, meaning organic compounds having -N=C- in the molecule. Examples thereof include aldimines, ketimines, and compounds obtained by substituting a hydrogen atom on N in these compounds by an alkyl group or the like). The imine residue has a carbon number of usually about 2 to 20, preferably 2 to 18.

The imine residue includes groups of the following structural formulae. 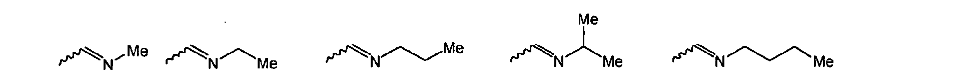 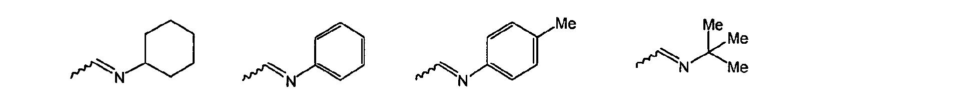 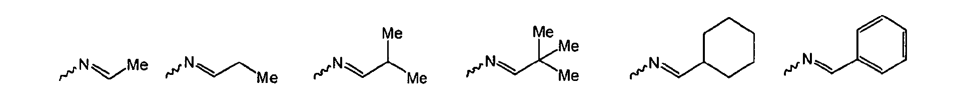 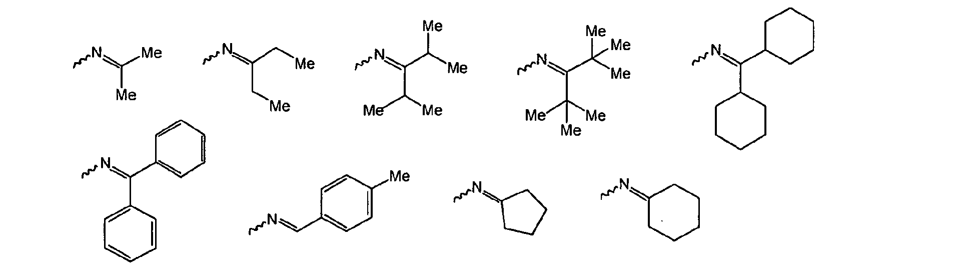 (In the formulae, Me represents a methyl group. The wavy line represents a connecting bond, and means a possibility of a geometric isomer such as a cis body, trans body or the like depending on the kind of the imine residue.)

The amide group has a carbon number of usually about 2 to 20, preferably 2 to 18. The amide group includes a formamide group, acetamide group, propioamide group, butyroamide group, benzamide group, trifluoroacetamide group, pentafluorobenzamide group, diformamide group, diacetamide group, dipropioamide group, dibutyroamide group, dibenzamide group, ditrifluoroacetamide group and dipentafluorobenzamide group.

The acid imide group includes residues obtained by removing from an acid imide one hydrogen atom bonded to its nitrogen atom, and has a carbon number of about 4 to 20. The acid imide group includes groups shown below.

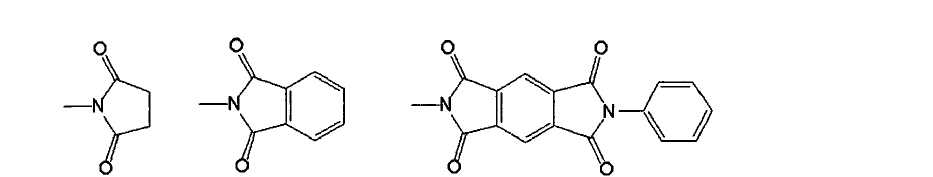

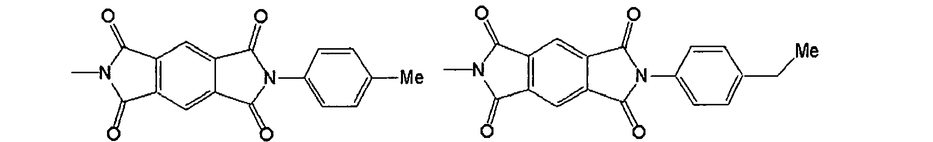

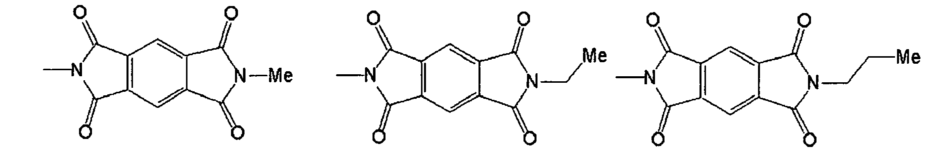

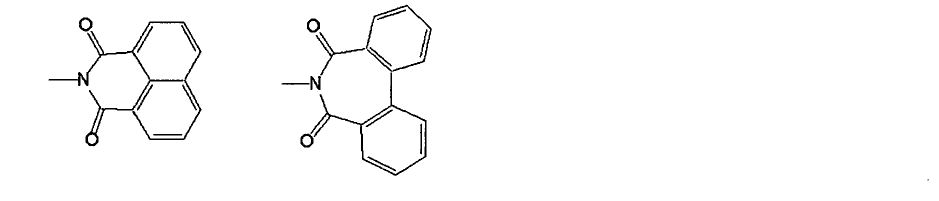

The above-described mono-valent heterocyclic group means an atomic group remaining after removing one hydrogen atom from a heterocyclic compound. The carbon number of the mono-valent heterocyclic group is usually about 4 to 60, preferably 4 to 20. The carbon number of the mono-valent heterocyclic group does not include the carbon number of the substituent. The above-described heterocyclic compound refers to organic compounds having a cyclic structure in which elements constituting the ring include not only a carbon atom, but also a hetero atom such as oxygen, sulfur, nitrogen, phosphorus, boron, silicon and the like contained in the ring. The mono-valent heterocyclic group includes a thienyl group, C₁ to C₁₂ alkylthienyl group, pyrrolyl group, furyl group, pyridyl group, C₁ to C₁₂ alkylpyridyl group, piperidyl group, quinolyl group and isoquinolyl group, and preferable are a thienyl group, C₁ to C₁₂ alkylthienyl group, pyridyl group and C₁ to C₁₂ alkylpyridyl group. Of the mono-valent heterocyclic groups, mono-valent aromatic heterocyclic groups are preferable.

The substituted carboxyl group includes carboxyl groups substituted with an alkyl group, aryl group, arylalkyl group or mono-valent heterocyclic group. The above-described alkyl group, aryl group, arylalkyl group or mono-valent heterocyclic group may have a substituent. The carbon number of the substituted carboxyl group is usually about 2 to 60, preferably 2 to 48. The carbon number of the substituted carboxyl group does not include the carbon number of the substituent. The substituted carboxyl group includes a methoxycarbonyl group, ethoxycarbonyl group, n-propoxycarbonyl group, isopropoxycarbonyl group, n-butoxycarbonyl group, isobutoxycarbonyl group, t-butoxycarbonyl group, n-pentyloxycarbonyl group, n-hexyloxycarbonyl group, cyclohexyloxycarbonyl group, n-heptyloxycarbonyl group, n-octyloxycarbonyl group, 2-ethylhexyloxycarbonyl group, n-nonyloxycarbonyl group, n-decyloxycarbonyl group, 3,7-dimethyloctyloxycarbonyl group, n-dodecyloxycarbonyl group, trifluoromethoxycarbonyl group, pentafluoroethoxycarbonyl group, perfluorobutoxycarbonyl group, perfluorohexyloxycarbonyl group, perfluorooctyloxycarbonyl group, phenoxycarbonyl group, naphthoxycarbonyl group, pyridyloxycarbonyl group and the like.

In the formula (1), R³ represents an alkyl group. The definition and specific examples of this alkyl group are the same as the definition and specific examples of the alkyl group in the explanation for the above-described R¹.

In the formula (1), a and b represent each independently an integer of 0 to 3. Z represents -O- or - S-.

From the standpoint of easiness of synthesis of a monomer, repeating units of the formula (4) are preferable among repeating units of the formula (1).

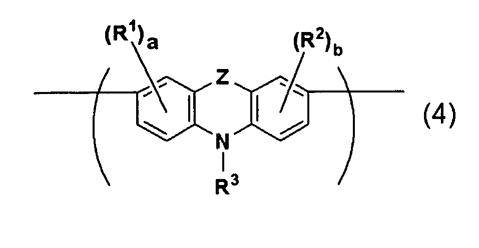

### [in the formula (4), R¹, R², R³, a, b and Z represent the same meaning as described above.]

From the standpoint of the solubility in an organic solvent of the polymer compound of the present invention, R¹ and R² in the formula (4) each independently represent preferably an alkyl group, alkoxy group, alkylthio group, aryl group, aryloxy group, arylthio group, arylalkyl group, arylalkoxy group, arylalkylthio group, arylalkenyl group, arylalkynyl group or mono-valent heterocyclic group, more preferably an alkyl group, alkoxy group, alkylthio group, aryl group, aryloxy group, arylthio group, arylalkyl group, arylalkoxy group or arylalkylthio group, preferably an alkyl group, alkoxy group, aryl group or aryloxy group, and more preferably an alkyl group or aryl group.

The repeating unit of the formula (4) includes repeating units of the formulae (4-1) to (4-16).

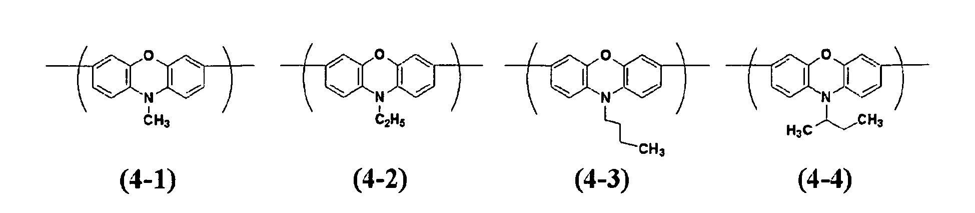

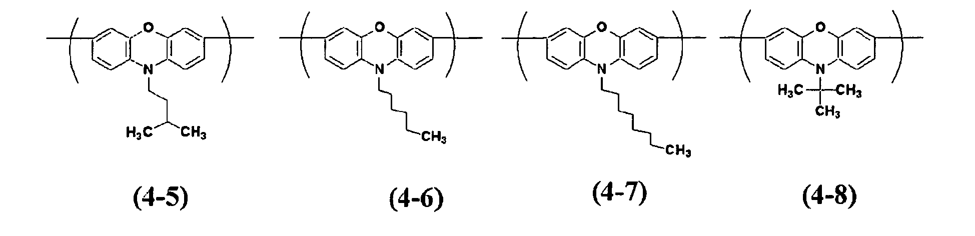

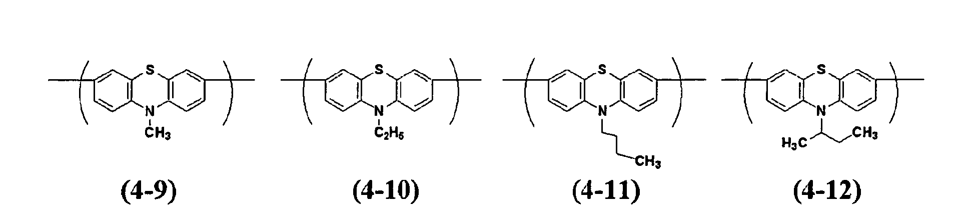

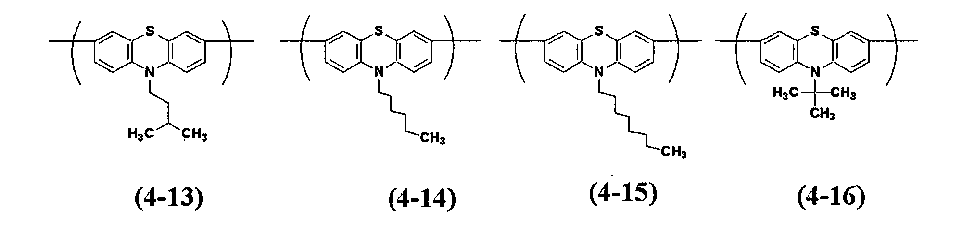

From the standpoint of easiness of synthesis of a monomer, a represents preferably 0 or 1, more preferably 0, and b represents preferably 0 or 1, more preferably 0, in the formula (4).

From the standpoint of light emitting efficiency in the case of use of the polymer compound of the present invention in a polymer light-emitting device, Z is preferably -O- in the formula (4).

The polymer compound of the present invention contains at least one repeating unit selected from the group consisting of a repeating unit of the formula (2) and a repeating unit of the formula (3), in addition to the repeating unit of the formula (1). In the formula (2), ring A and ring B represent each independently an aromatic hydrocarbon ring optionally having a substituent, and at least one of ring A and ring B is an aromatic hydrocarbon ring composed of a plurality of condensed benzene rings.

The above-described aromatic hydrocarbon ring includes a benzene ring, naphthalene ring, anthracene ring, tetracene ring, pentacene ring, pyrene ring and phenanthrene ring, preferably a benzene ring, naphthalene ring, anthracene ring and phenanthrene ring.
The combination of ring A and ring B includes preferably a combination of a benzene ring and a naphthalene ring, a combination of a benzene ring and an anthracene ring, a combination of a benzene ring and a phenanthrene ring, a combination of a naphthalene ring and a naphthalene ring, a combination of a naphthalene ring and an anthracene ring, a combination of a naphthalene ring and a phenanthrene ring, and a combination of an anthracene ring and a phenanthrene ring, more preferably a combination of a benzene ring and a naphthalene ring.

When the above-described aromatic hydrocarbon ring has a substituent, it is preferable that this substituent is a substituent selected from the group consisting of an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group and nitro group.

Here, the definition and specific examples of the alkyl group, alkoxy group, alkylthio group, aryl group, aryloxy group, arylthio group, arylalkyl group, arylalkoxy group, arylalkylthio group, arylalkenyl group, arylalkynyl group, substituted amino group, substituted silyl group, halogen atom, acyl group, acyloxy group, imine residue, amide group, acid imide group, mono-valent heterocyclic group and substituted carboxyl group are the same as the definition and specific examples of these groups in the explanation for the above-described R¹.

In the formula (2), R_{w} and Rₓ represent each independently a hydrogen atom, alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group or cyano group. Here, the definition and specific examples of the alkyl group, alkoxy group, alkylthio group, aryl group, aryloxy group, arylthio group, arylalkyl group, arylalkoxy group, arylalkylthio group, arylalkenyl group, arylalkynyl group, substituted amino group, substituted silyl group, halogen atom, acyl group, acyloxy group, imine residue, amide group, acid imide group, mono-valent heterocyclic group and substituted carboxyl group are the same as the definition and specific examples of these groups in the explanation for the above-described R¹.

R_{w} and Rₓ may be connected to form a ring, and this ring includes a C₄ to C₁₀ cycloalkyl ring optionally having a substituent, a C₄ to C₁₀ cycloalkenyl ring optionally having a substituent, a C₆ to C₁₀ aromatic hydrocarbon ring optionally having a substituent and a C₄ to C₁₀ heterocyclic ring optionally having a substituent. From the standpoint of easiness of synthesis of a monomer, it is prpeferable that R_{w} and Rₓ do not form a ring.

The cycloalkyl ring includes a cyclobutane ring, cyclopentane ring, cyclohexane ring, cycloheptane ring, cyclooctane ring, cyclononane ring, cyclodecane ring and the like.

The cyclo alkenyl ring includes also those having two or more double bonds, and examples thereof include a cyclohexene ring, cyclohexadiene ring, cyclooctatriene ring and the like.

The heterocyclic ring includes a tetrahydrofuran ring, tetrahydrothiophene ring, tetrahydroindole ring, tetrahydroquinoline ring, hexahydropyridine ring, tetrahydroisoquinoline ring and the like.

The repeating unit of the formula (2) includes repeating units of the following formulae 2A-1 to 2A-64, 2B-1 to 2B-64 and 2C-1 to 2C-64, and repeating units obtained by bonding of an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group or nitro group as a substituent to the above-described repeating units.
In the following formulae, the bonding position of an aromatic hydrocarbon ring is an arbitrary position on the ring. R_{w} and Rₓ represent the same meaning as described above.

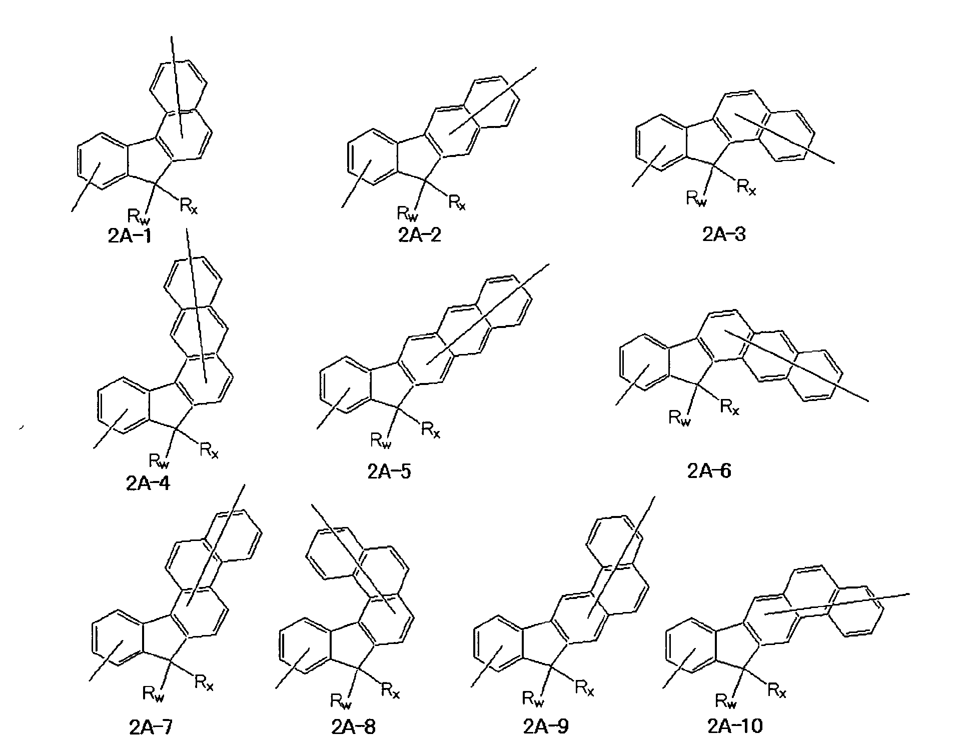

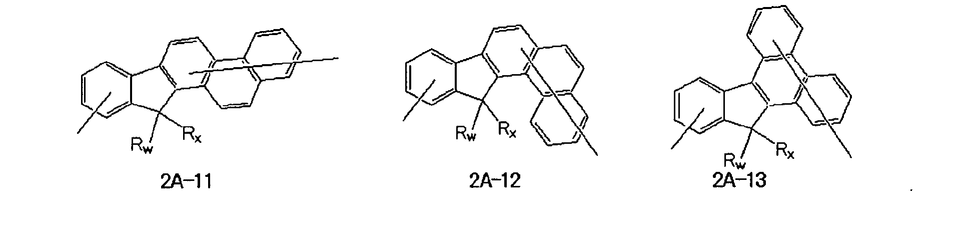

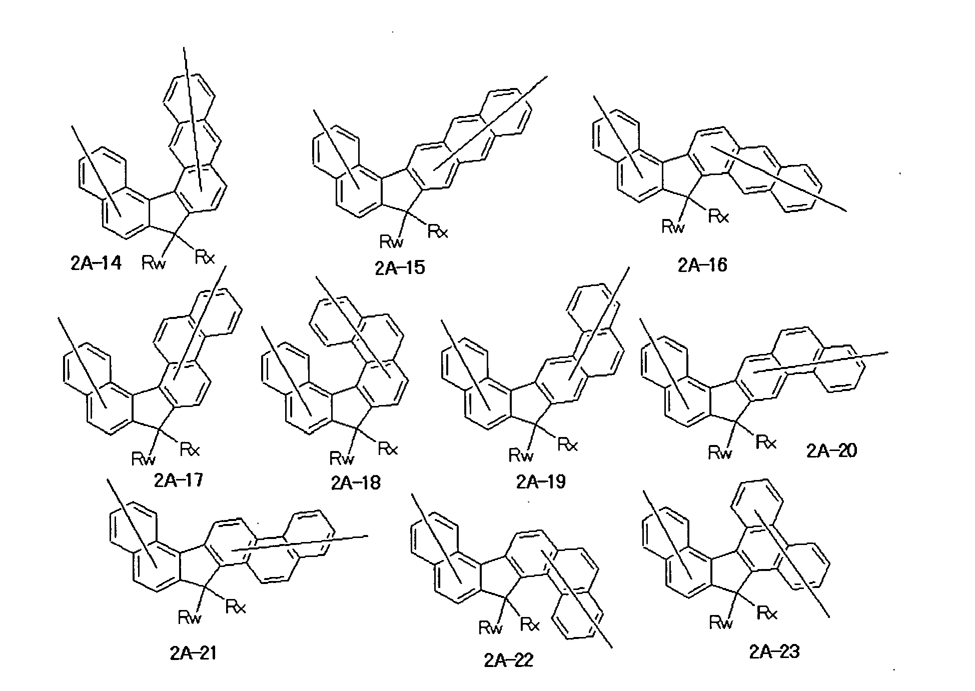

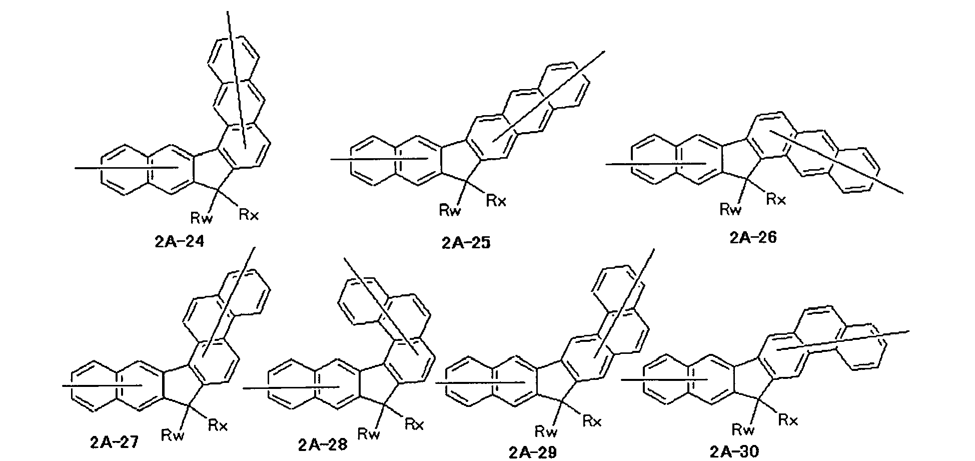

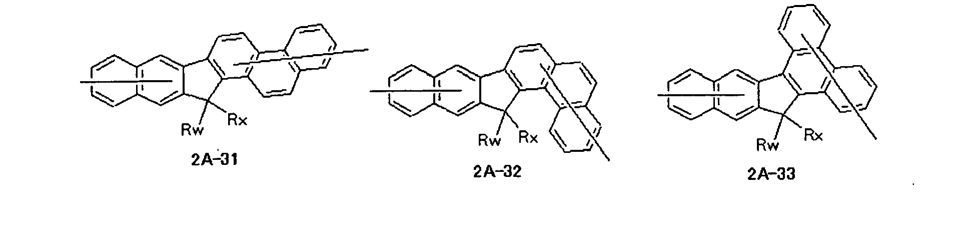

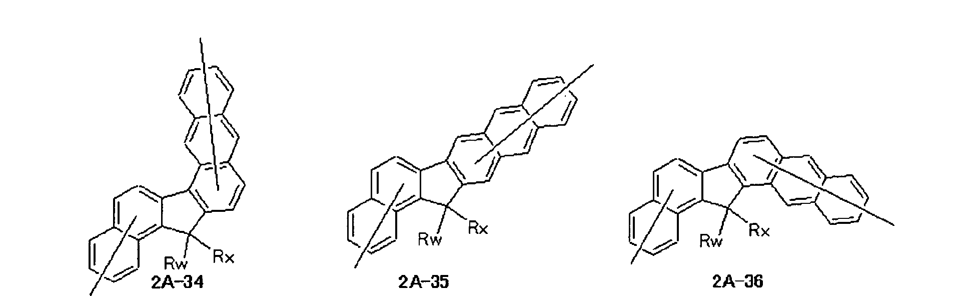

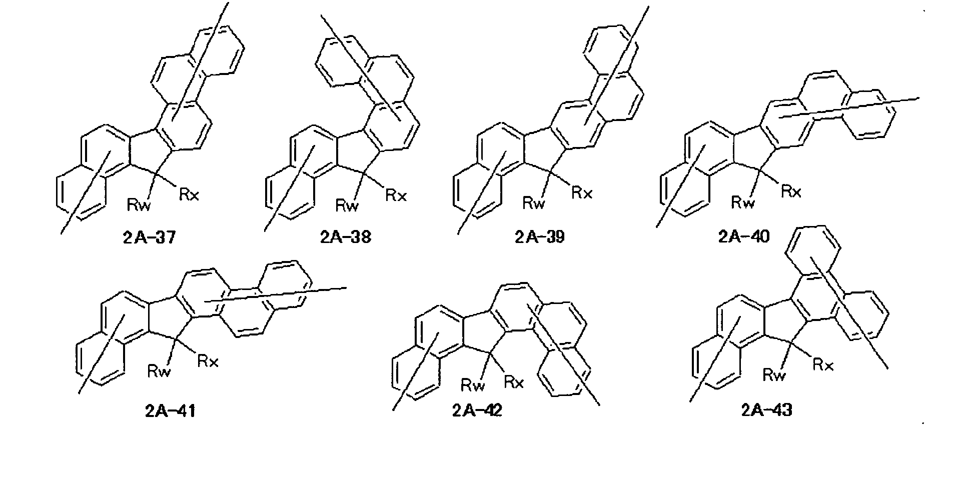

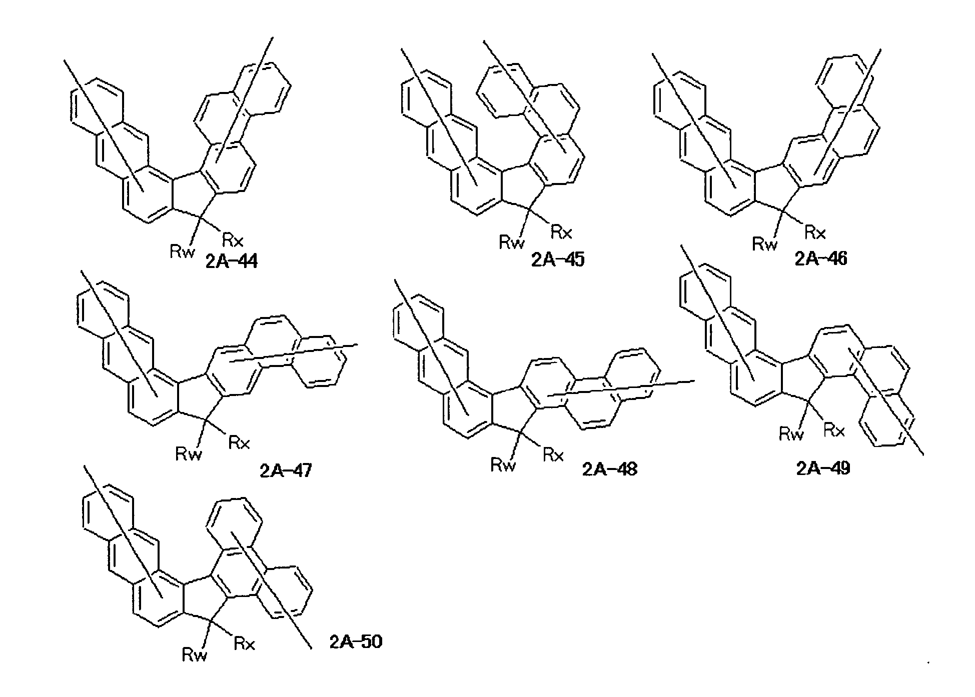

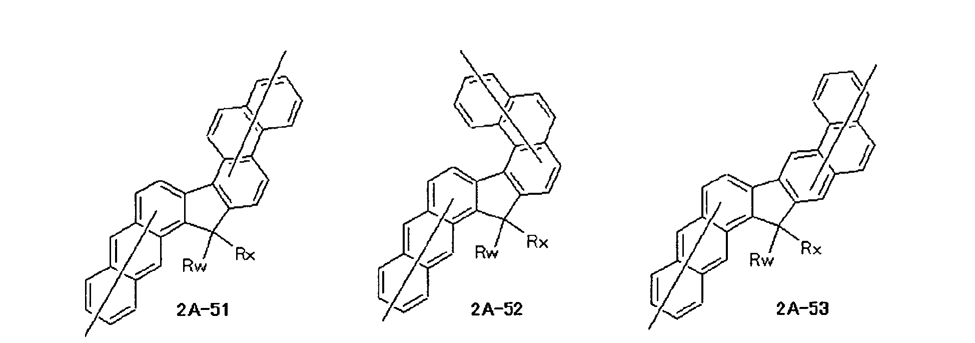

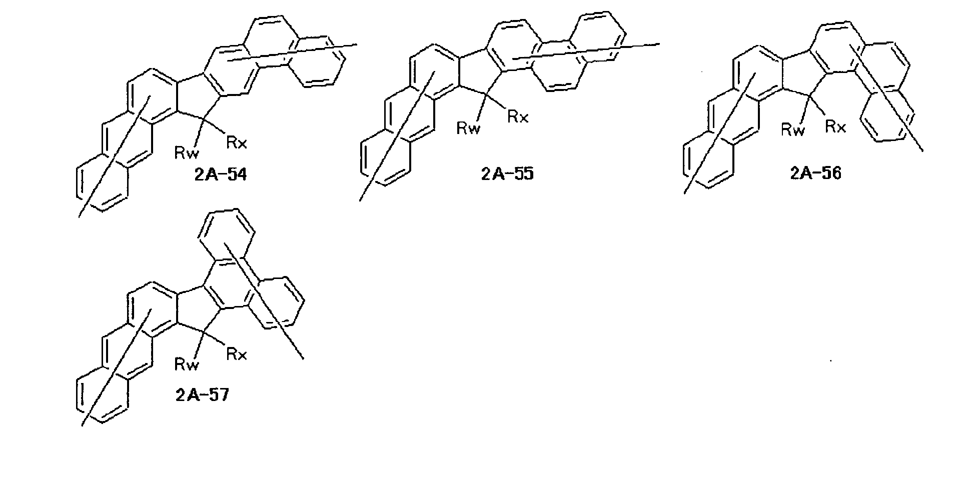

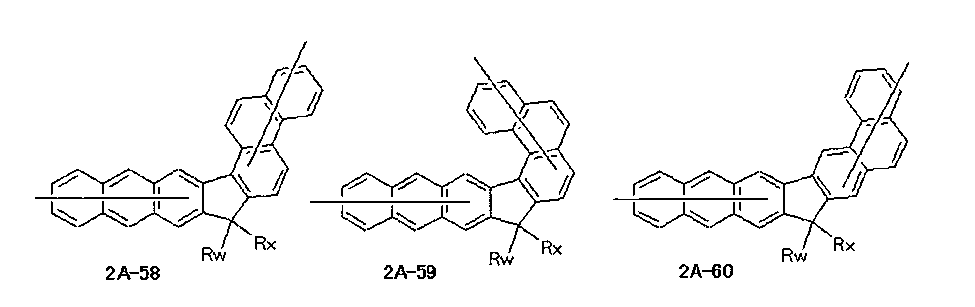

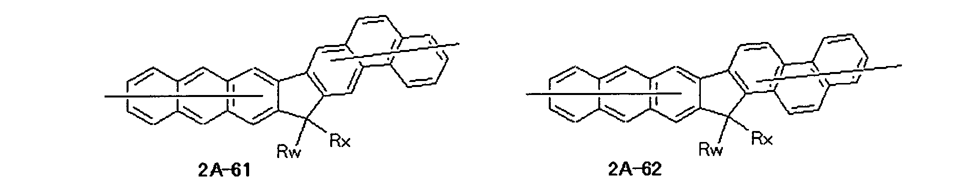

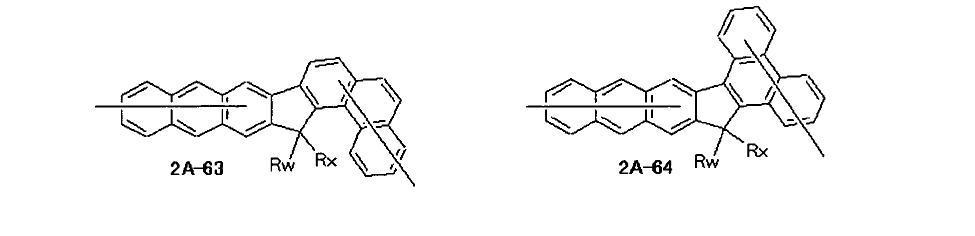

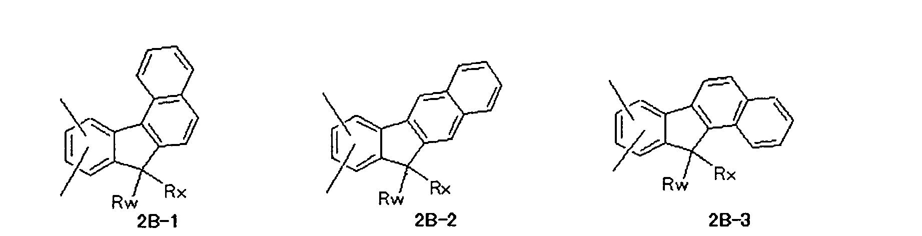

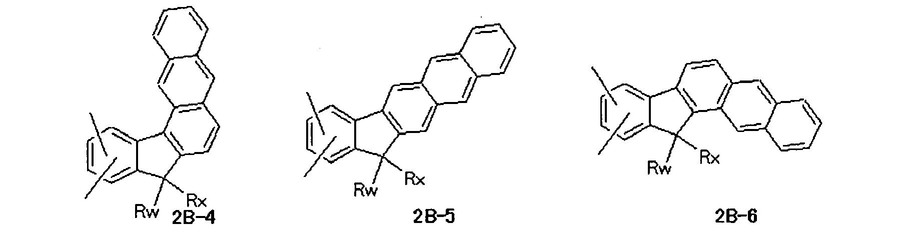

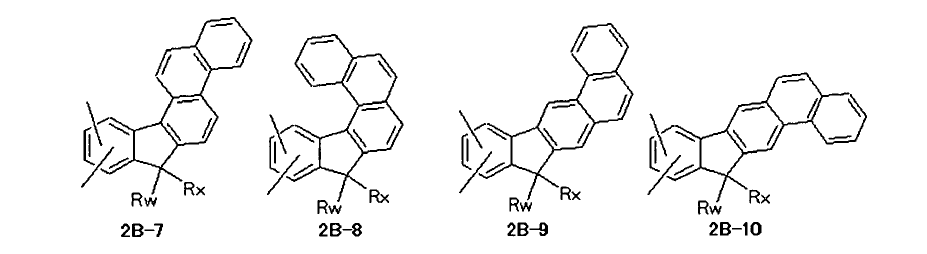

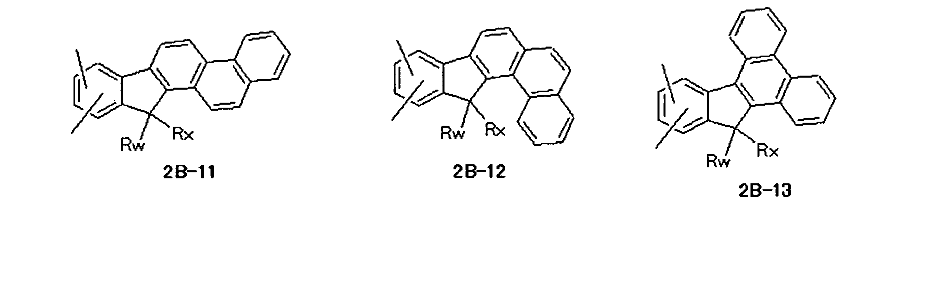

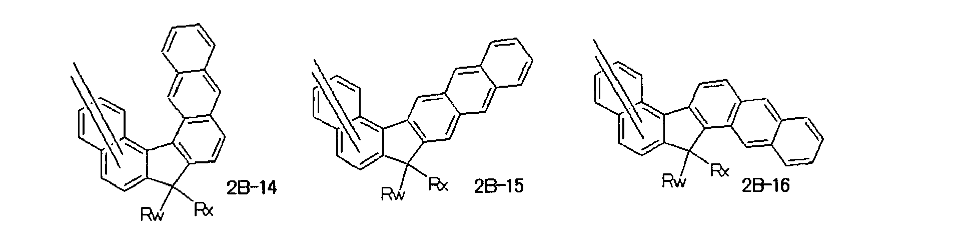

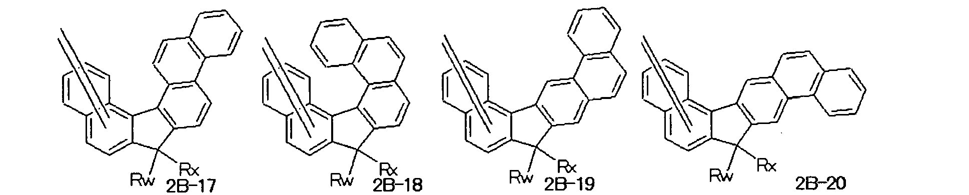

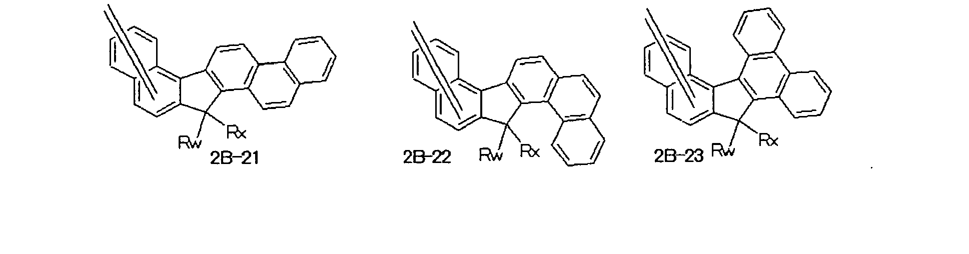

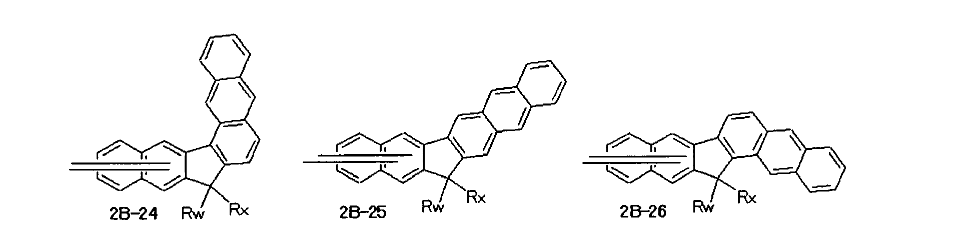

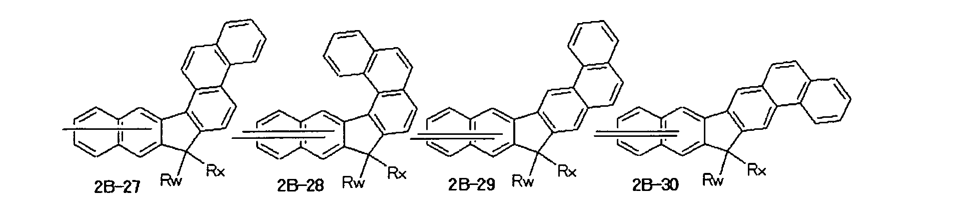

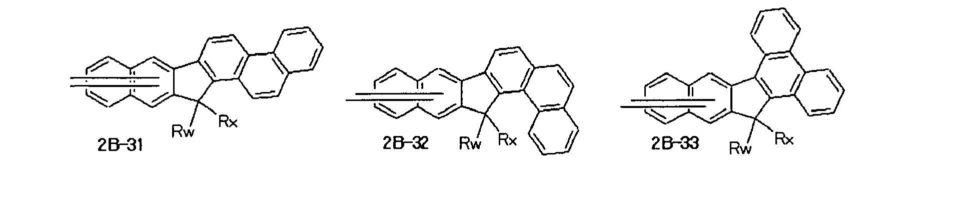

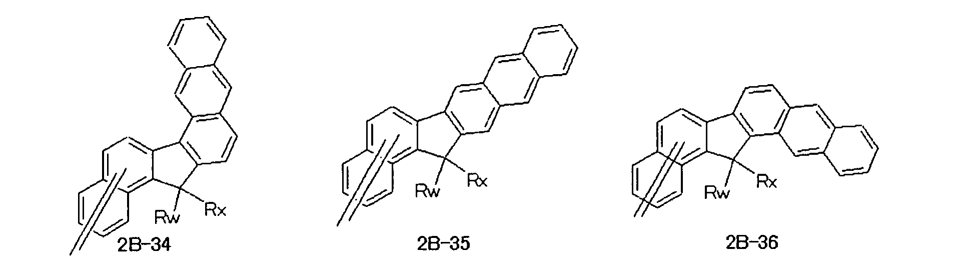

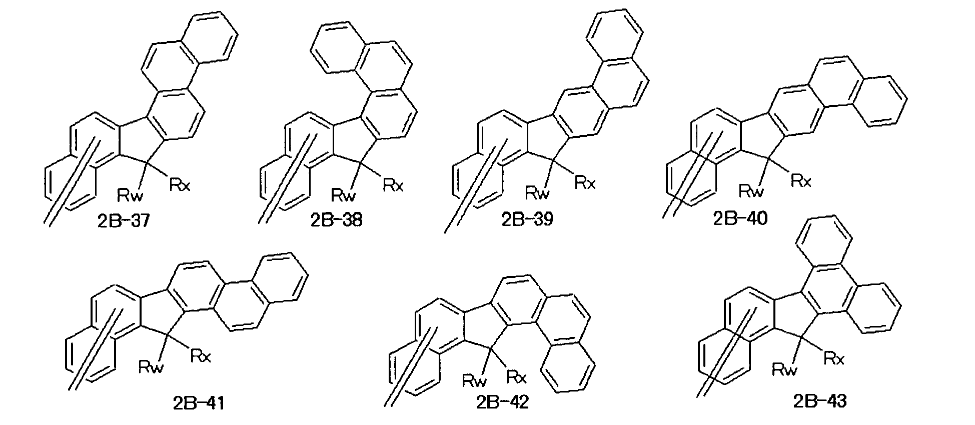

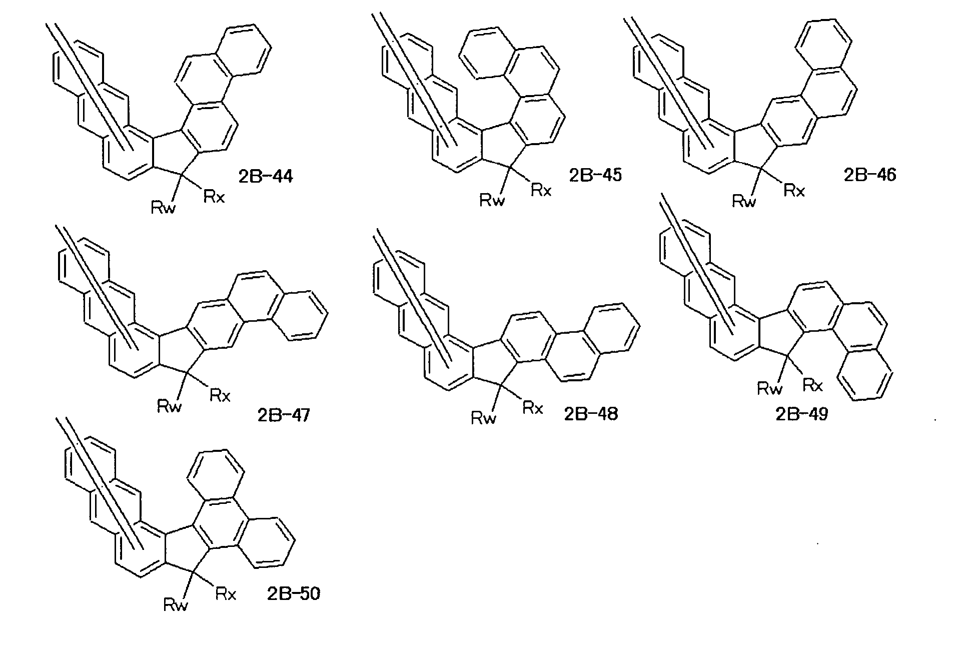

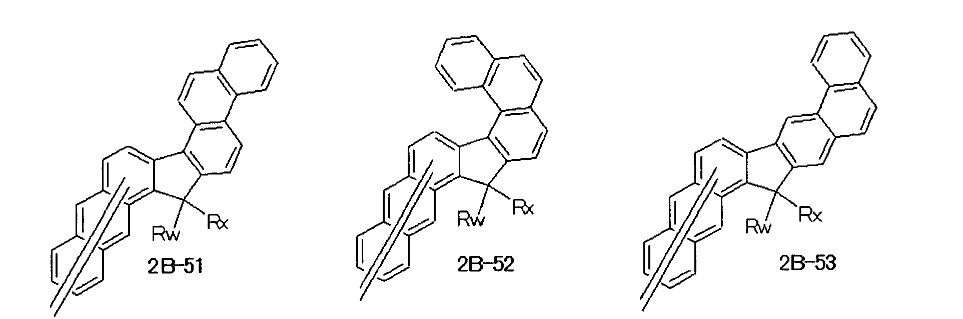

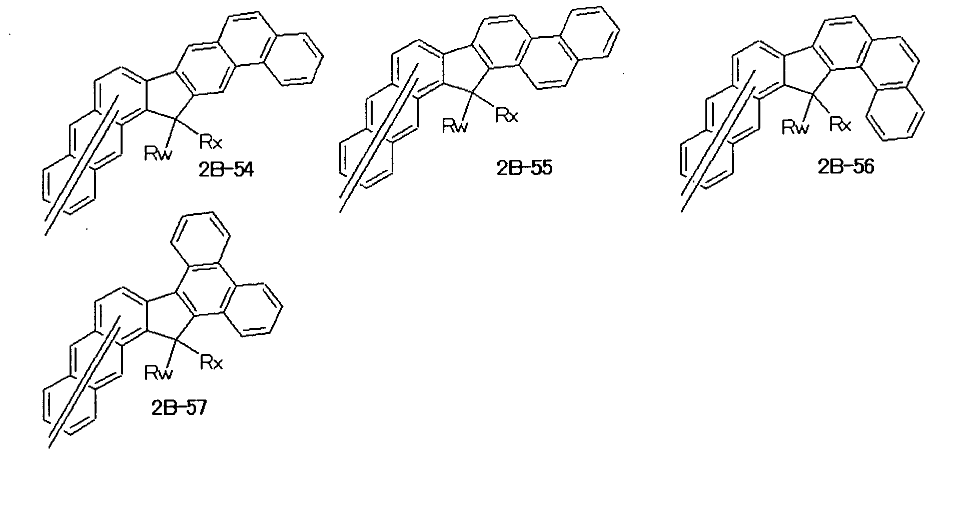

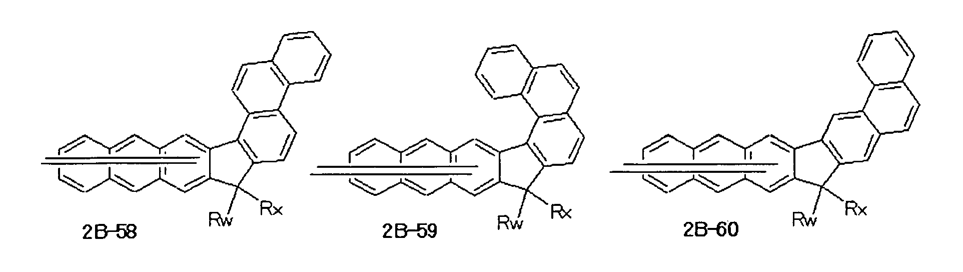

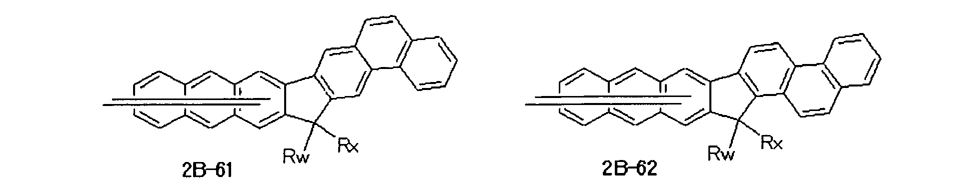

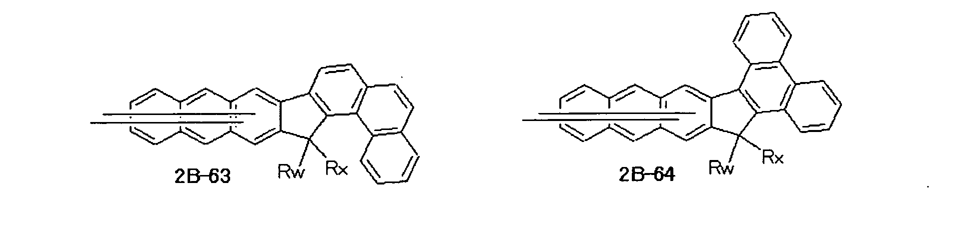

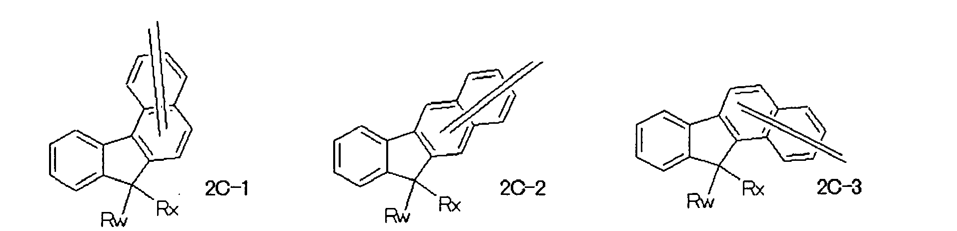

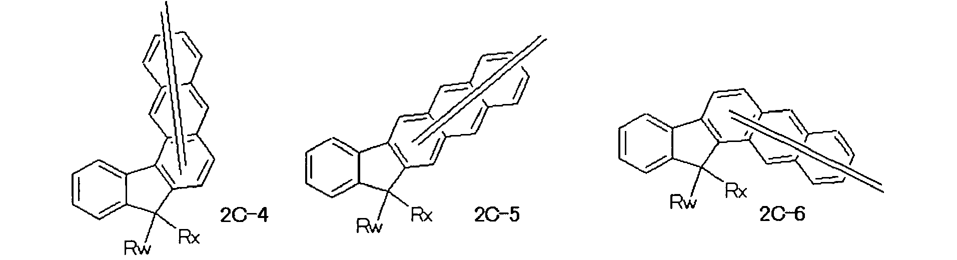

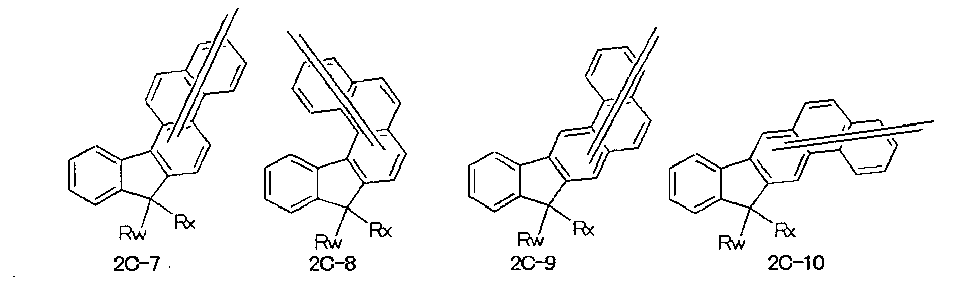

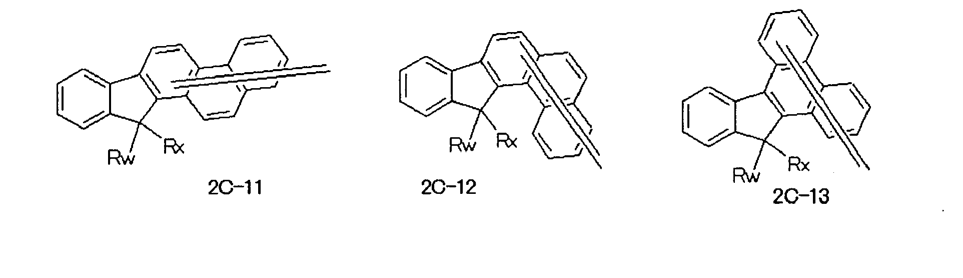

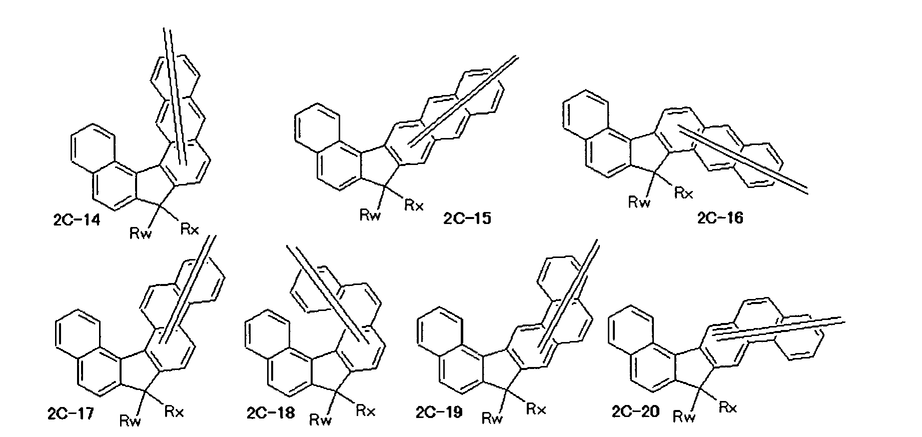

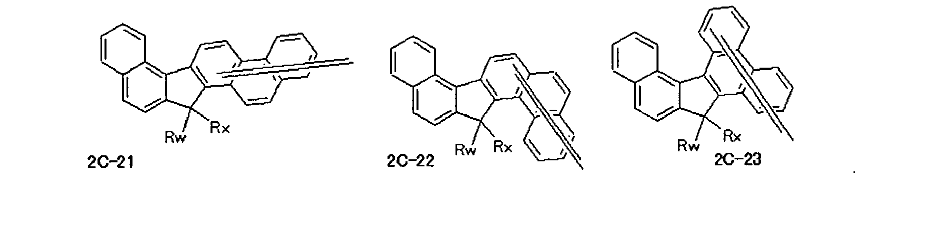

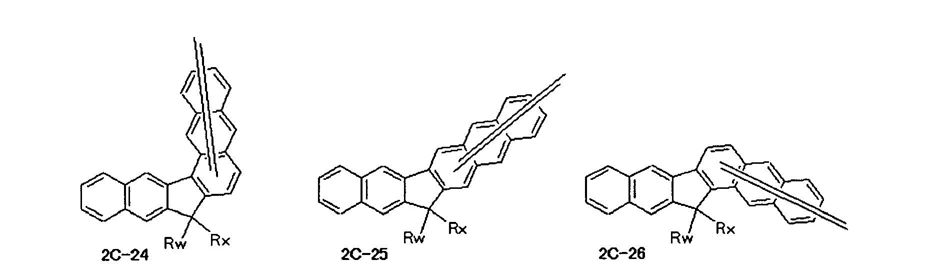

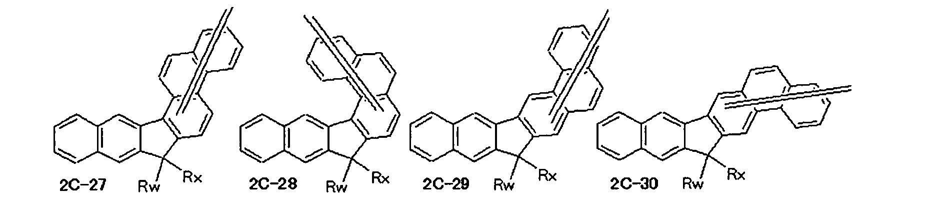

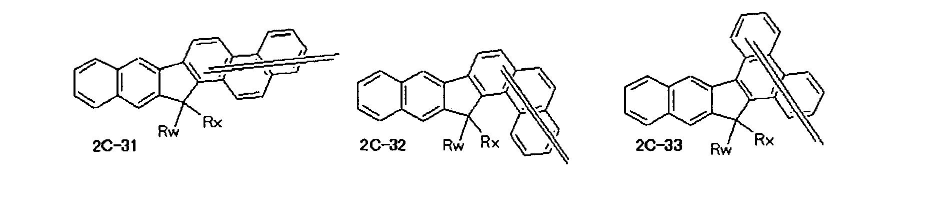

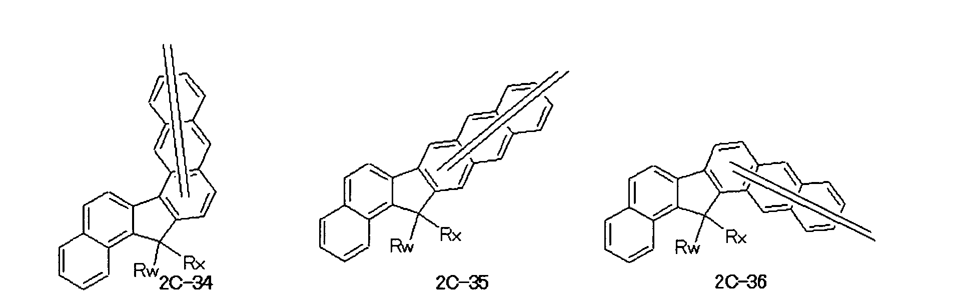

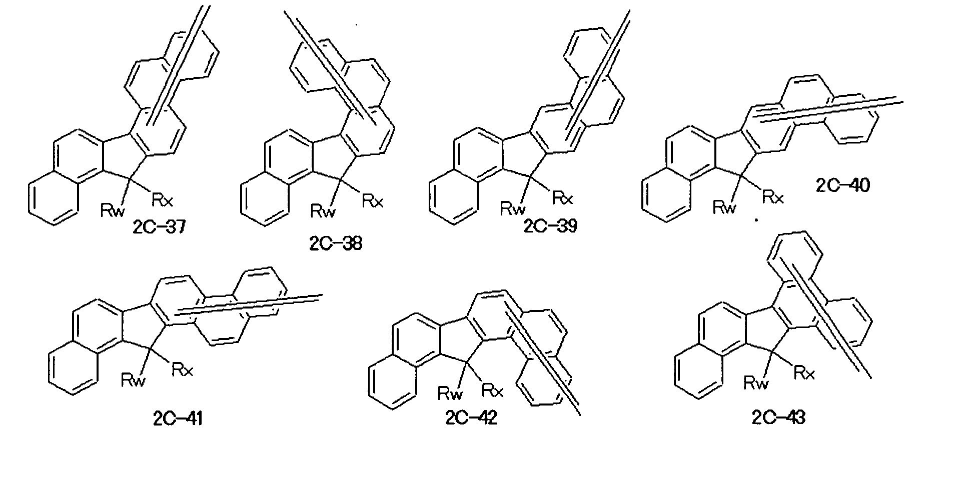

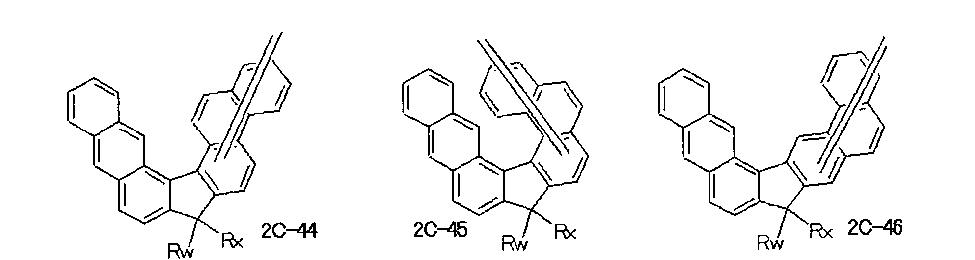

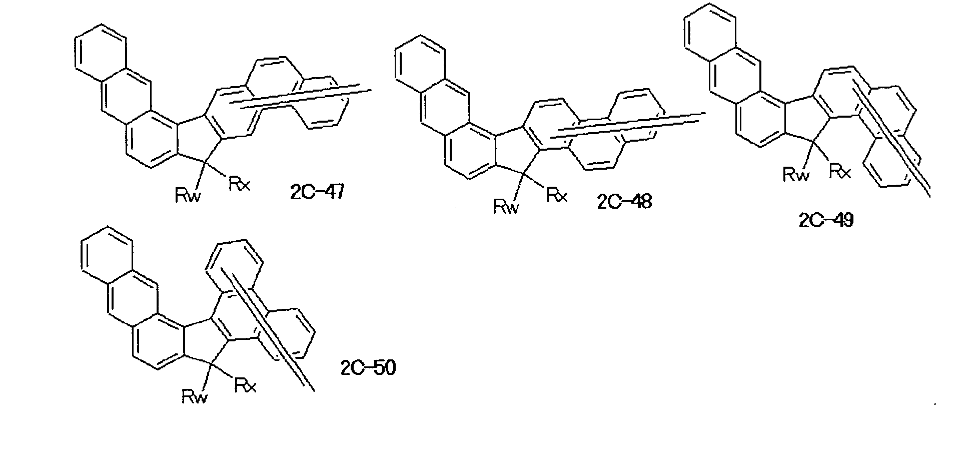

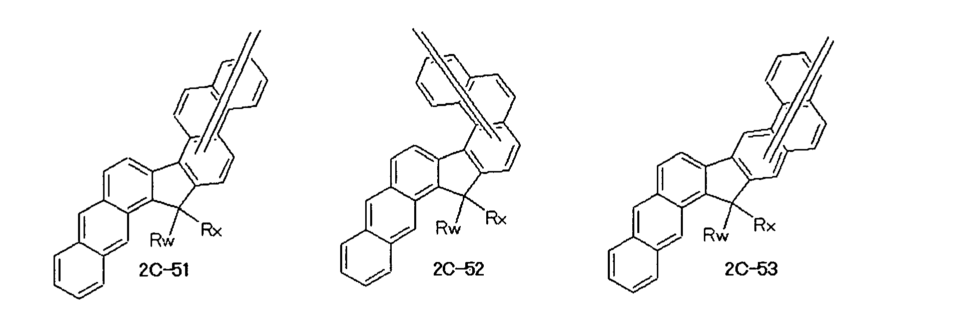

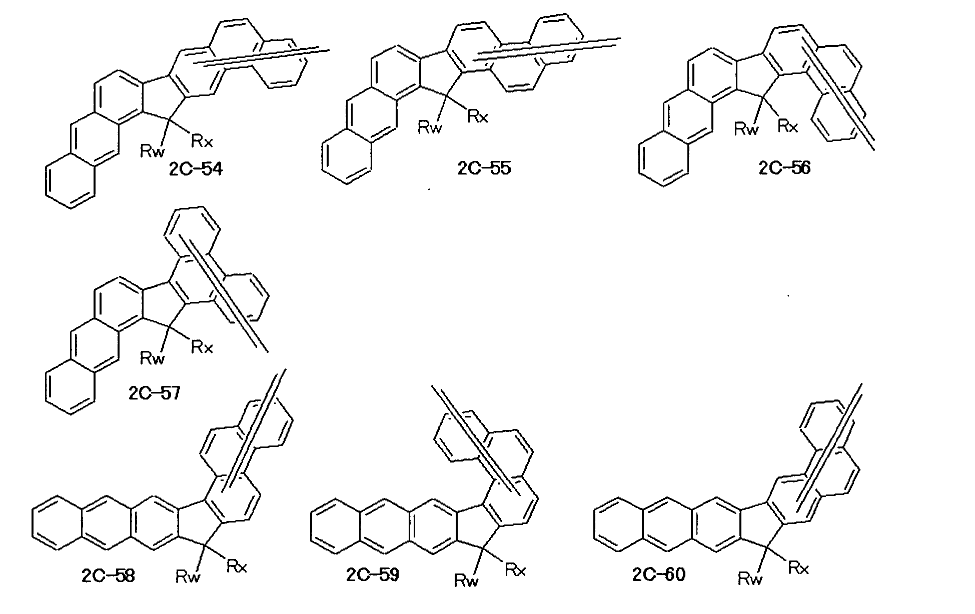

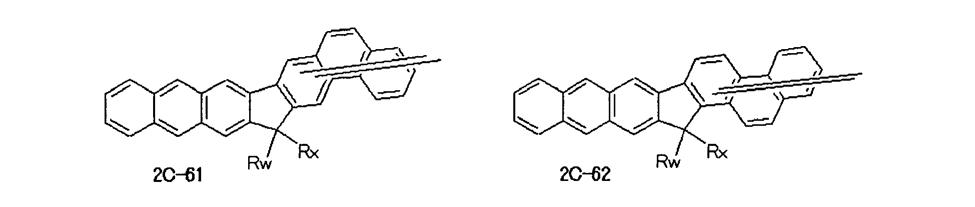

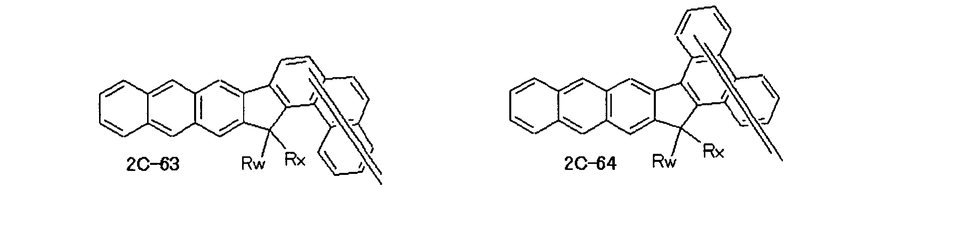

From the standpoint of light emitting efficiency in the case of use of the polymer compound of the present invention in a polymer light-emitting device, it is preferable that the repeating unit of the formula (2) is a repeating unit selected from the group consisting of a repeating unit of the formula (2-1), a repeating unit of the formula (2-2), a repeating unit of the formula (2-3) and a repeating unit of the formula (2-4), and more preferably a repeating unit of the formula (2-1). 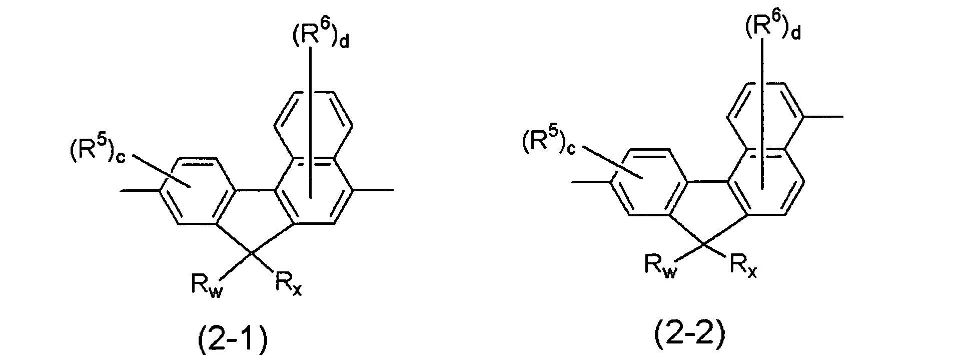 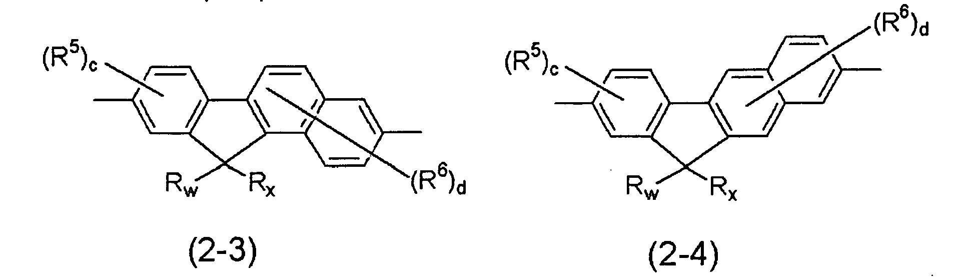 [in the formulae (2-1) to (2-4), R⁵ and R⁶ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group or cyano group. c represents an integer of 0 to 3, and d represents an integer of 0 to 5. When there exists a plurality of R⁵, they may be the same or different. When there exists a plurality of R⁶, they may be the same or different. R_{w} and Rₓ represent the same meaning as described above, and R_{w} and Rₓ may be mutually connected to form a ring.]

For R⁵ and R⁶, the definition and specific examples of the alkyl group, alkoxy group, alkylthio group, aryl group, aryloxy group, arylthio group, arylalkyl group, arylalkoxy group, arylalkylthio group, arylalkenyl group, arylalkynyl group, substituted amino group, substituted silyl group, halogen atom, acyl group, acyloxy group, imine residue, amide group, acid imide group, mono-valent heterocyclic group and substituted carboxyl group are the same as the definition and specific examples of these groups in the explanation for the above-described R¹.

From the standpoint of durability of a light emitting material in the case of use of the polymer compound of the present invention as a light emitting material of a polymer light-emitting device, it is preferable that the repeating unit of the formula (2-1) is a repeating unit of the formula (2-5).

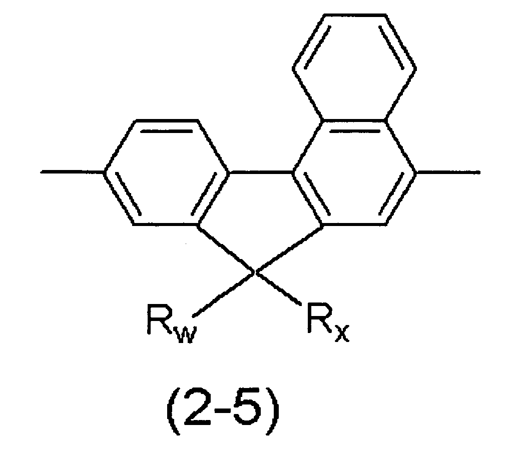

### [in the formula (2-5), R_{w} and Rₓ represent the same meaning as described above.]

From the standpoint of easiness of synthesis, R_{w} and Rₓ represent preferably an alkyl group, alkoxy group, alkylthio group, aryl group, aryloxy group, arylthio group, arylalkyl group, arylalkoxy group, arylalkylthio group, arylalkenyl group or arylalkynyl group, more preferably an alkyl group, alkoxy group, aryl group, aryloxy group, arylalkyl group or arylalkoxy group, further preferably an alkyl group.

The polymer compound of the present invention contains at least one repeating unit selected from the group consisting of a repeating unit of the formula (2) and a repeating unit of the formula (3). In the formula (3), ring C and ring D represent each independently an aromatic ring optionally having a substituent, and the aromatic ring includes an aromatic hydrocarbon ring and aromatic heterocyclic ring.
The aromatic hydrocarbon ring includes a benzene ring, naphthalene ring, anthracene ring, tetracene ring, pentacene ring, pyrene ring and phenanthrene ring, and the aromatic heterocyclic ring includes a thiophene ring and pyridine ring. From the standpoint of easiness of synthesis of a monomer and device properties, a benzene ring, naphthalene ring, anthracene ring and phenanthrene ring are preferable, and a benzene ring and naphthalene ring are more preferable. X represents -O-, -S-, -S(=O)-, -S(=O)₂-, -Si(R⁴)₂-Si(R⁴)₂-, -Si(R⁴)₂-, -B(R⁴)-, -P(R⁴)-, - P(=O)(R⁴)-, -O-C(R⁴)₂- or -N=C(R⁴)-, and R⁴ represents a hydrogen atom, alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group or cyano group. A hydrogen atom contained in these groups may be substituted by a fluorine atom, when there exists a plurality of R⁴, they may be the same or different.

For R⁴ in the formula (3), the definition and specific examples of the alkyl group, alkoxy group, alkylthio group, aryl group, aryloxy group, arylthio group, arylalkyl group, arylalkoxy group, arylalkylthio group, arylalkenyl group, arylalkynyl group, substituted amino group, substituted silyl group, halogen atom, acyl group, acyloxy group, imine residue, amide group, acid imide group, mono-valent heterocyclic group and substituted carboxyl group are the same as the definition and specific examples of these groups in the explanation for the above-described R¹.

When ring C and/or ring D in the formula (3) have a substituent, this substituent is preferably selected from the group consisting of an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group and cyano group, from the standpoint of the solubility in an organic solvent of the polymer compound of the present invention, polymer light-emitting device properties when the the polymer compound of the present invention is used, easiness of synthesis of a monomer, and the like. A hydrogen atom contained in these substituents may be substituted by a fluorine atom. When the repeating unit of the formula (3) has two or more substituents in total on ring C and/or ring D, these substituents may be the same or different.

Here, the definition and specific examples of the alkyl group, alkoxy group, alkylthio group, aryl group, aryloxy group, arylthio group, arylalkyl group, arylalkoxy group, arylalkylthio group, arylalkenyl group, arylalkynyl group, substituted amino group, substituted silyl group, halogen atom, acyl group, acyloxy group, imine residue, amide group, acid imide group, mono-valent heterocyclic group and substituted carboxyl group are the same as the definition and specific examples of these groups in the explanation for the above-described R¹.

Of them, an alkyl group, alkoxy group, alkylthio group, aryl group, aryloxy group, arylthio group, arylalkyl group, arylalkoxy group and mono-valent heterocyclic group are preferable, and an alkyl group, alkoxy group and aryl group are more preferable, from the standpoint of improvement of the solubility in an organic solvent of the polymer compound of the present invention.

The repeating unit of the formula (3) includes repeating units of the formulae (3-1) to (3-56). The repeating units of the formulae (3-1) to (3-56) may have a substituent, and from the standpoint of improvement of the solubility in an organic solvent of the polymer compound of the present invention, the repeating units preferably have at least one substituent, and more preferably two or more substituents. R⁴ in the formula (3-29) to (3-56) represents the same meaning as described above.

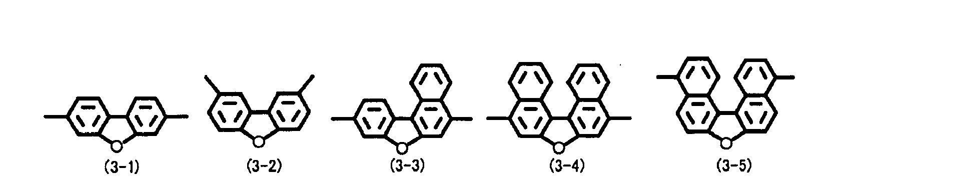

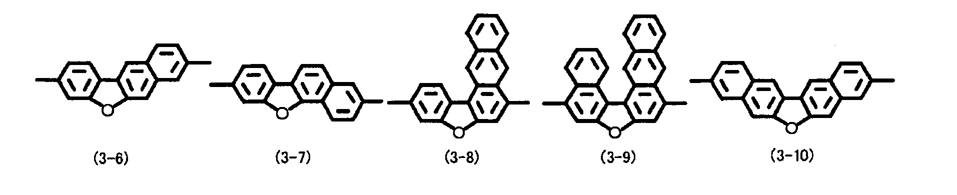

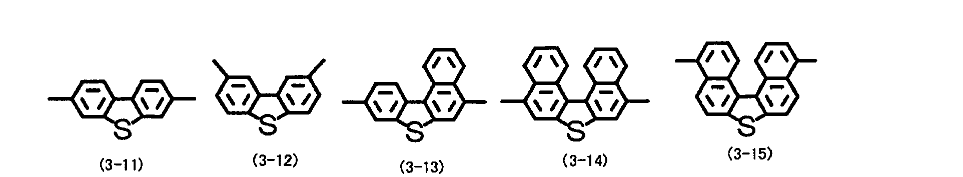

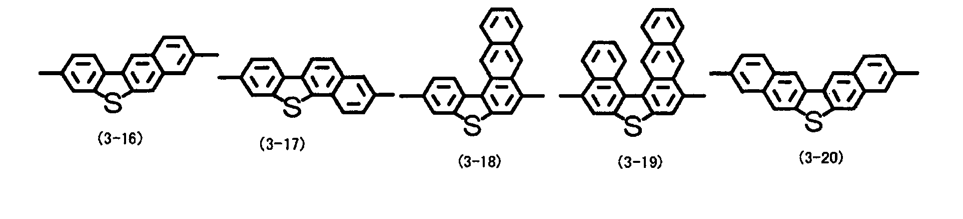

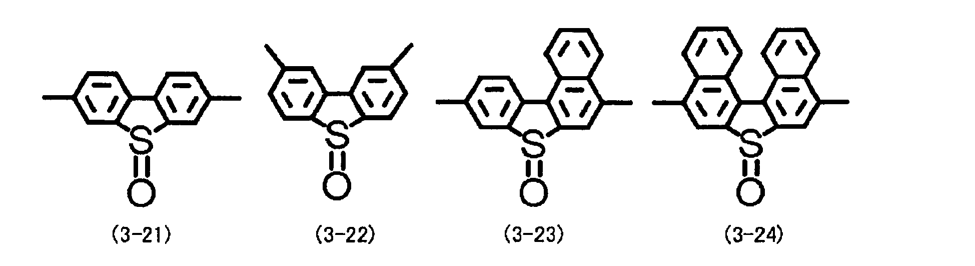

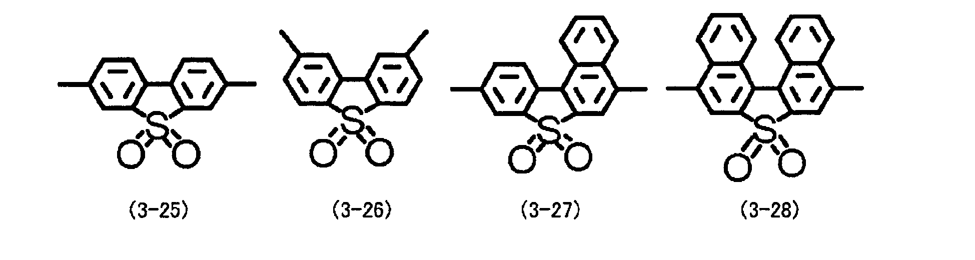

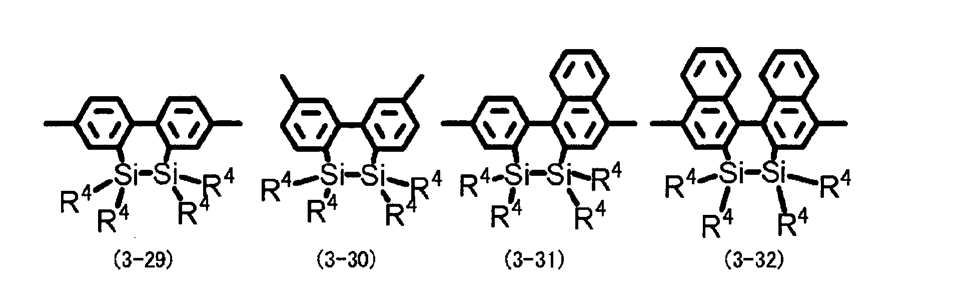

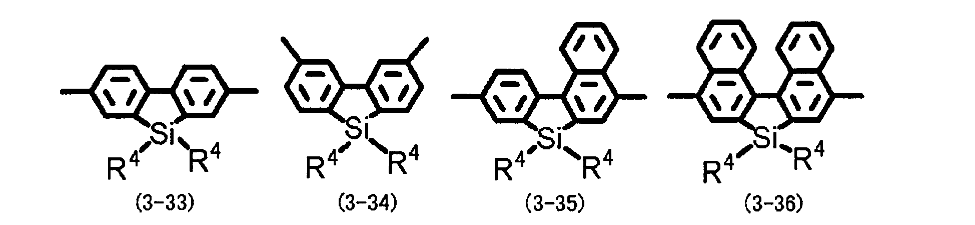

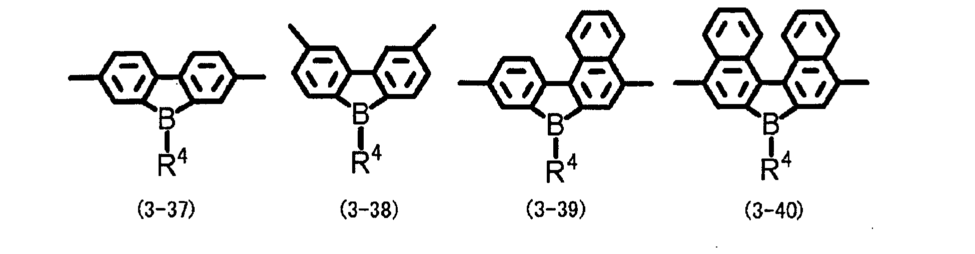

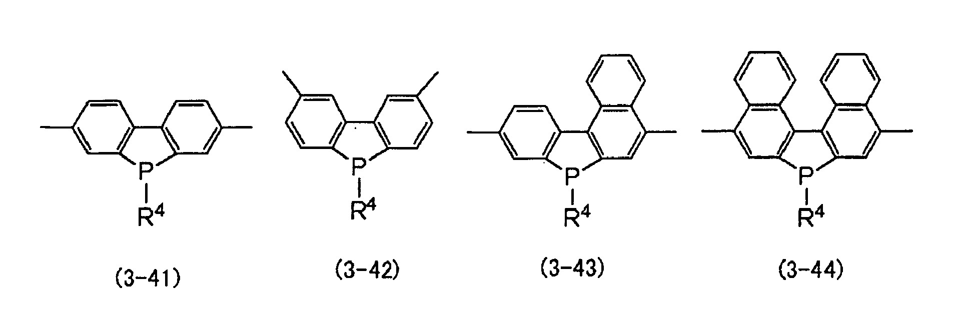

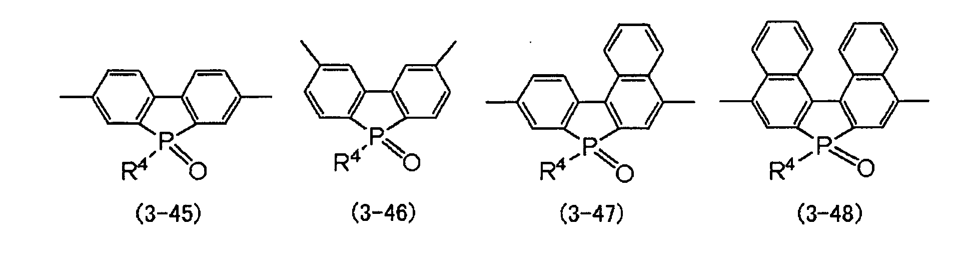

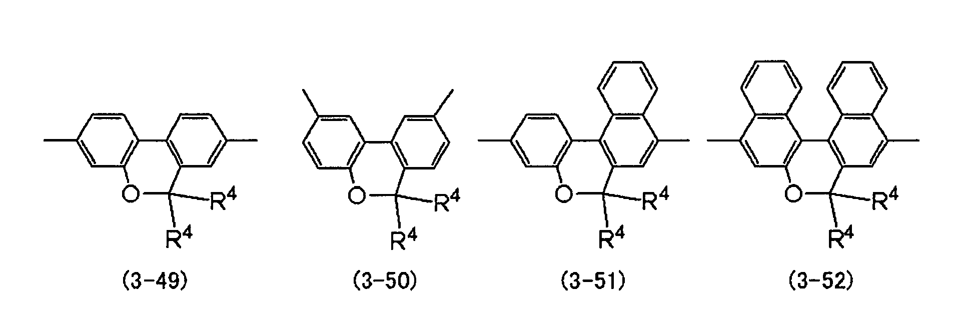

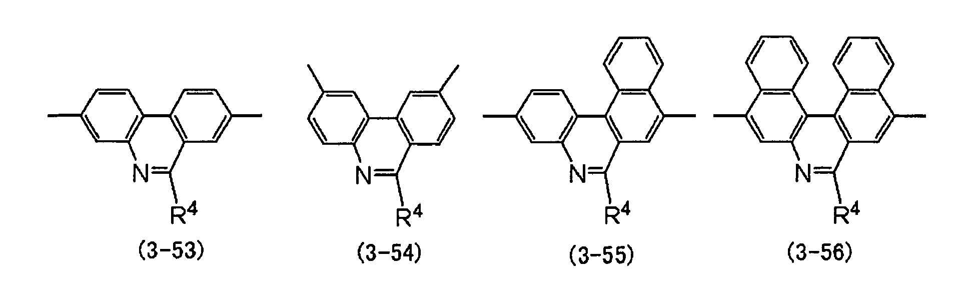

Among the repeating units of the formula (3), preferable is a repeating unit selected from the group consisting of a repeating unit of the formula (3-A), a repeating unit of the formula (3-B) and a repeating unit of the formula (3-C), more preferable is a repeating unit of the formula (3-A) or a repeating unit of the formula (3-B), and further preferable is a repeating unit of the formula (3-A), from the standpoint of polymer light-emitting device properties when the polymer compound of the present invention is used, fluorescence intensity and the like. 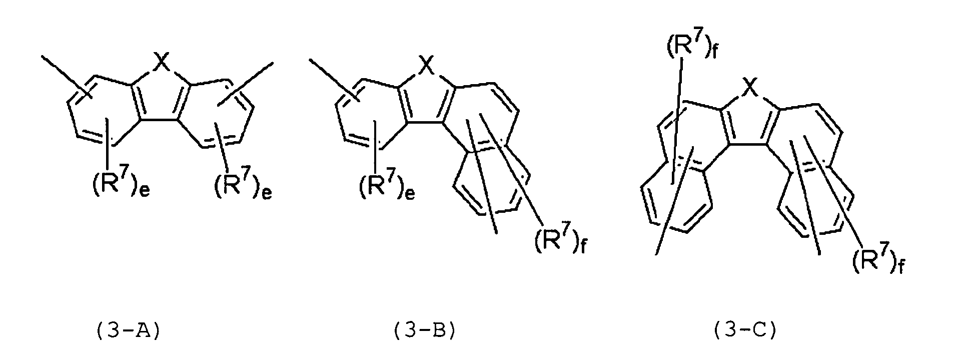 [in the formulae (3-A) to (3-C), X represents the same meaning as described above, and R⁷ represents each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group or cyano group. e represents an integer of 0 to 3, and f represents an integer of 0 to 5. When there exists a plurality of e, they may be the same or different, and when there exists a plurality of f, they may be the same or different. When there exists a plurality of R⁷, they may be the same or different.]

For R⁷, the definition and specific examples of the alkyl group, alkoxy group, alkylthio group, aryl group, aryloxy group, arylthio group, arylalkyl group, arylalkoxy group, arylalkylthio group, arylalkenyl group, arylalkynyl group, substituted amino group, substituted silyl group, halogen atom, acyl group, acyloxy group, imine residue, amide group, acid imide group, mono-valent heterocyclic group and substituted carboxyl group are the same as the definition and specific examples of these groups in the explanation for the above-described R¹.

R⁷ in the formulae (3-A) to (3-C) represents preferably an alkyl group, alkoxy group, aryl group, aryloxy group, arylalkyl group or arylalkoxy group, from the standpoint of the solubility in an organic solvent of the polymer compound of the present invention, polymer light-emitting device properties when the polymer compound of the present invention is used, easiness of synthesis of a monomer, and the like.

In the formulae (3-A) to (3-C), the sum of e and f is preferably 1 or more, more preferably 2 or more, from the standpoint of improvement of the solubility in an organic solvent of the polymer compound of the present invention.
It is preferable that the repeating unit of the formula (3-A) is a repeating unit of the formula (3-D). 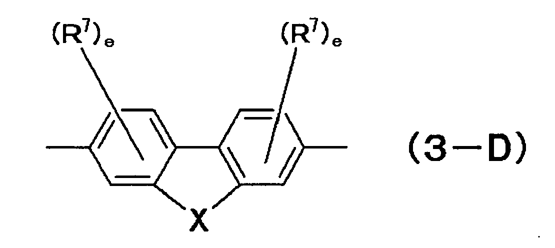 (in the formula (3-D), X, R⁷ and e represent the same meaning as described above.)

In the formulae (3), (3-A), (3-B), (3-C) and (3-D), X represents preferably -O-, -S-, -S(=O)-, -S(=O)₂-, - Si(R⁴)₂-, -B(R⁴)- or -O-C(R⁴)₂-, more preferably -O-, -S-, -Si(R⁴)₂- or -O-C(R⁴)₂-, and further preferably -O- or -S-, from the standpoint of fluorescence intensity and from the standpoint of properties of a polymer light-emitting device when the polymer compound of the present invention is used.

The polymer compound of the present invention may contain two or more repeating units of the formula (1), may contain two or more repeating units of the formula (2) and may contain two or more repeating units of the formula (3). Further, the polymer compound of the present invention may contain a repeating unit of the formula (2) and a repeating unit of the formula (3).

When the total number of repeating units in the polymer compound of the present invention is hypothesized as 100, the total number of repeating units of the formula (1) is preferably 1 to 95, more preferably 1 to 50, and further preferably 5 to 50. The sum of the total number of repeating units of the formula (2) and the total number of repeating units of the formula (3) is preferably 5 to 99, more preferably 20 to 90, and further preferably 40 to 90.

The polymer compound of the present invention may further contain a repeating unit of the formula (7) from the standpoint of its fluorescence intensity and device properties.

-Ar- (7)

[in the formula (7), Ar represents an arylene group, a di-valent heterocyclic group, a di-valent group having a metal complex structure, or a di-valent aromatic amine group.]

The arylene group represented by Ar means an atomic group derived from an aromatic hydrocarbon by removal of two hydrogen atoms, and includes also those having a benzene ring, those having a condensed ring, and those having two or more independent benzene rings or condensed rings bonded directly or via a group such as a vinylene group and the like. The arylene group may have a substituent. Though the kind of the substituent is not particularly restricted, preferable from the standpoint of solubility, fluorescence properties, easiness of synthesis, properties when made into a device, and the like are an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group and nitro group.
The carbon number of the arylene group excluding the substituent is usually about 6 to 60, preferably 6 to 20. The total carbon number of the arylene group including the substituent is usually about 6 to 100.

The arylene group includes a phenylene group (for example, the following formulae 1 to 3), naphthalenediyl group (the following formulae 4 to 13), anthracene-diyl group (the following formulae 14 to 19), biphenyl-diyl group (the following formulae 20 to 25), terphenyl-diyl group (the following formulae 26 to 28), condensed ring compound group (the following formulae 29 to 42) and the like.

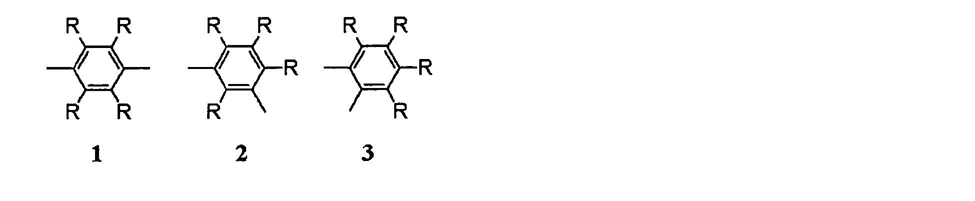

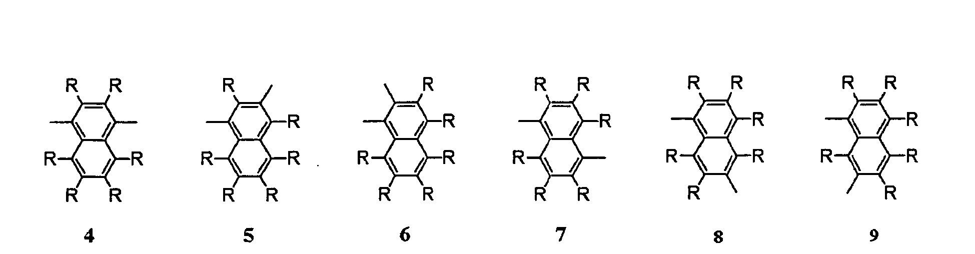

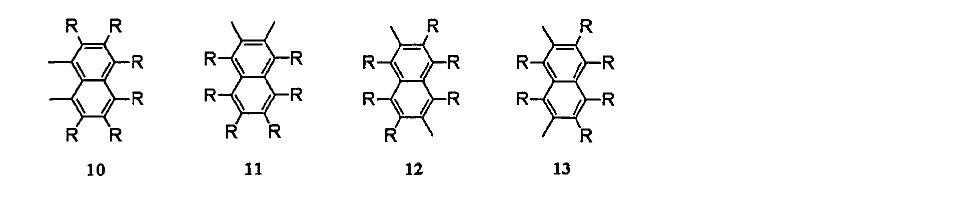

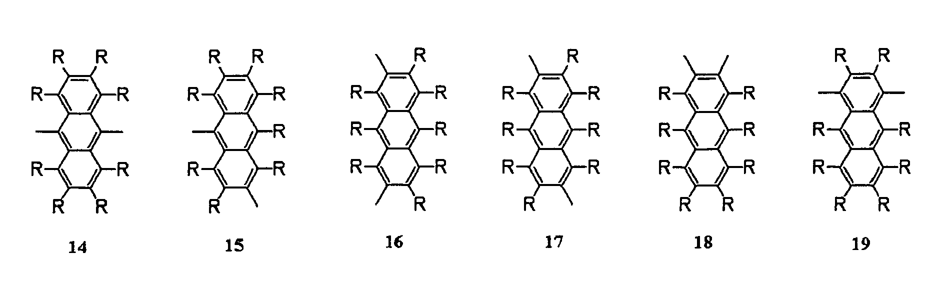

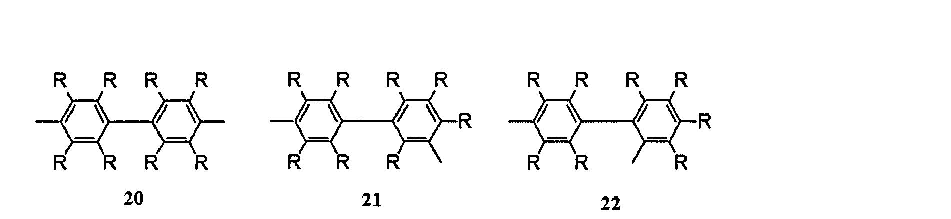

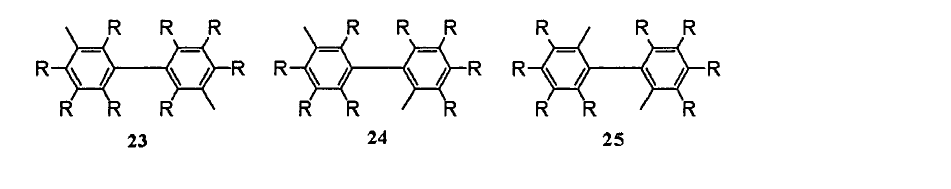

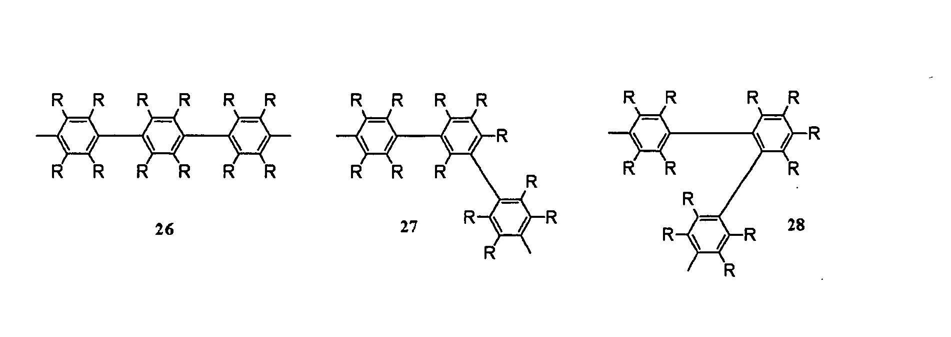

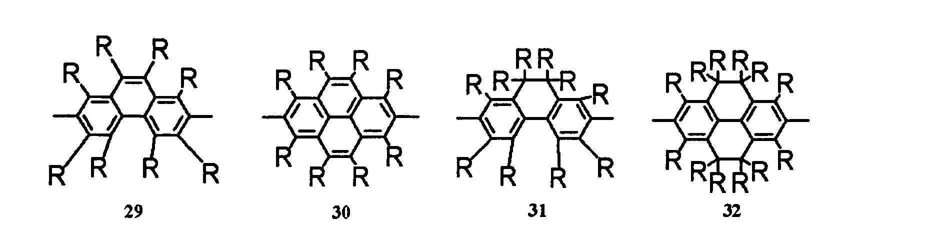

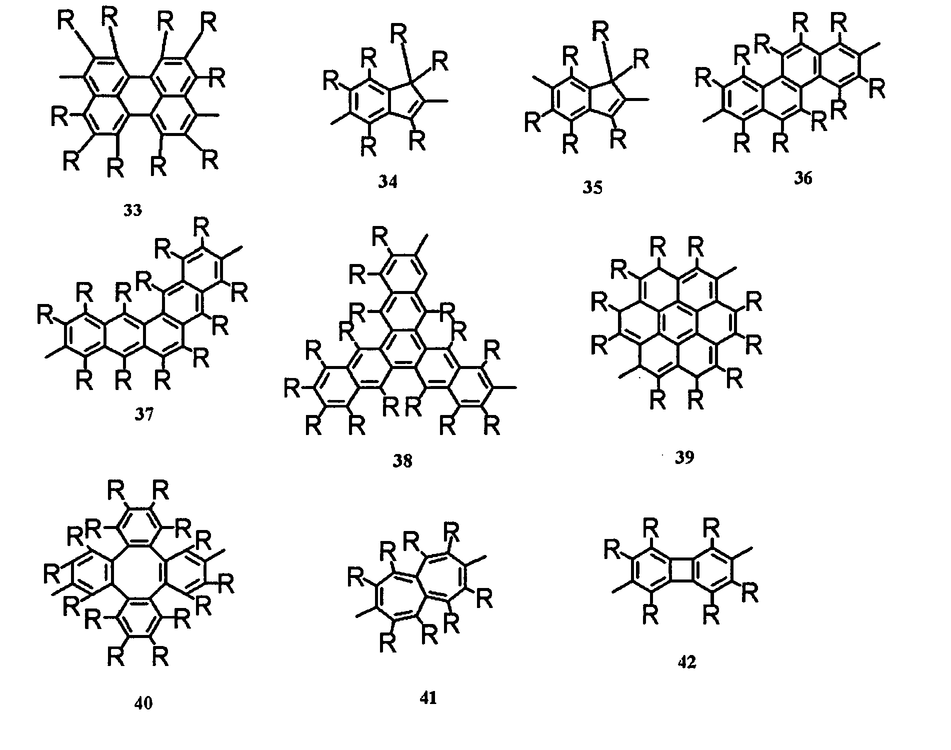

The di-valent heterocyclic group means an atomic group remaining after removal of two hydrogen atoms from a heterocyclic compound, and this group may have a substituent. Here, the heterocyclic compound means an organic compound having a cyclic structure in which elements constituting the ring include not only a carbon atom, but also a hetero atom such as oxygen, sulfur, nitrogen, phosphorus, boron, arsenic and the like contained in the ring. Among di-valent heterocyclic groups, di-valent aromatic heterocyclic groups are preferable. Though the kind of the substituent is not particularly restricted, preferable from the standpoint of solubility, fluorescence properties, easiness of synthesis, properties when made into a device, and the like are an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group and nitro group.

The carbon number of the di-valent heterocyclic group excluding the substituent is usually about 3 to 60. The total carbon number of the di-valent heterocyclic group including the substituent is usually about 3 to 100.
The di-valent heterocyclic group includes the following groups.
Di-valent heterocyclic groups containing nitrogen as a hetero atom: pyridinediyl group (the following formulae 101 to 106), diazaphenylene group (the following formulae 107 to 110), quinolinediyl group (the following formulae 111 to 125), quinoxalinediyl group (the following formulae 126 to 130), acridinediyl group (the following formulae 131 to 134), bipyridyldiyl group (the following formulae 135 to 137), phenanthrolinediyl group (the following formulae 138 to 140).
5-membered ring heterocyclic groups containing oxygen, silicon, nitrogen, sulfur, selenium, boron, phosphorus and the like as a hetero atom (the following formulae 141 to 145).
5-membered ring condensed hetero groups containing oxygen, silicon, nitrogen, selenium and the like as a hetero atom (the following formulae 146 to 157).
5-membered ring heterocyclic groups containing oxygen, silicon, nitrogen, sulfur, selenium and the like as a hetero atom, which are bonded at an α-position of its hetero atom to form a dimer or oligomer (the following formulae 158 to 159).
5-membered ring heterocyclic groups containing oxygen, silicon, nitrogen, sulfur, selenium and the like as a hetero atom, which are bonded at an α-position of its hetero atom to a phenyl group (the following formulae 160 to 166).

5-membered ring condensed heterocyclic groups containing oxygen, nitrogen, sulfur, selenium and the like as a hetero atom, and carrying thereon a substituent such as a phenyl group, furyl group or thienyl group (the following formulae 167 to 172).

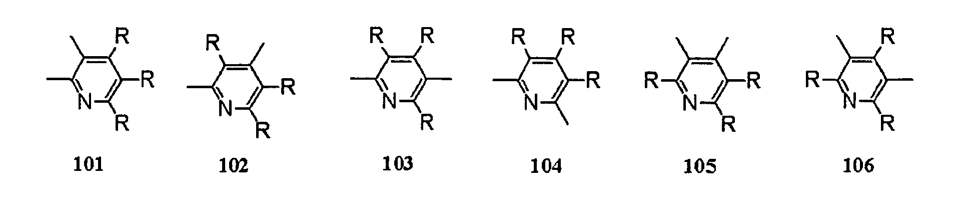

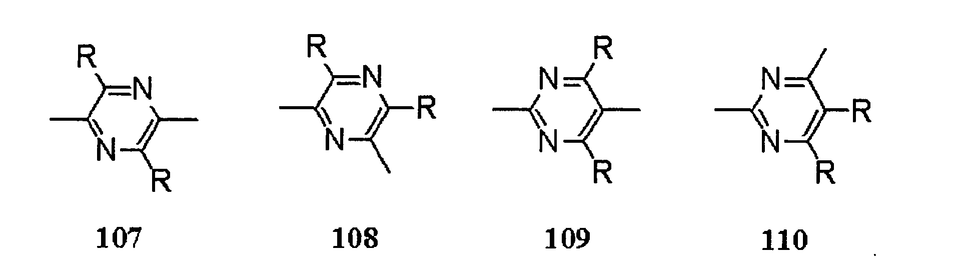

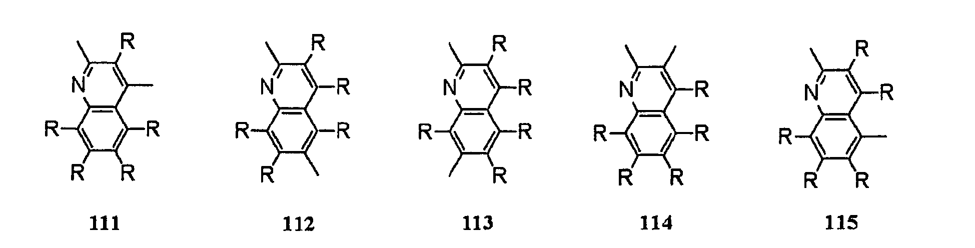

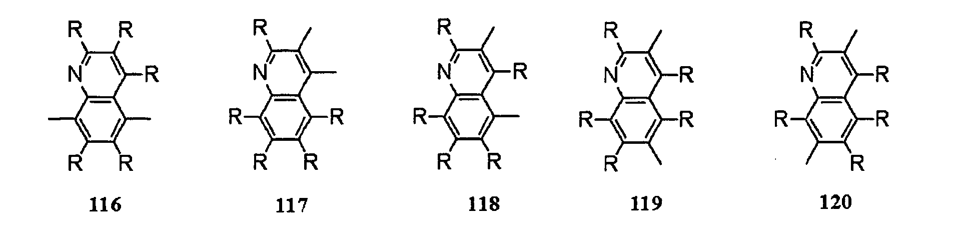

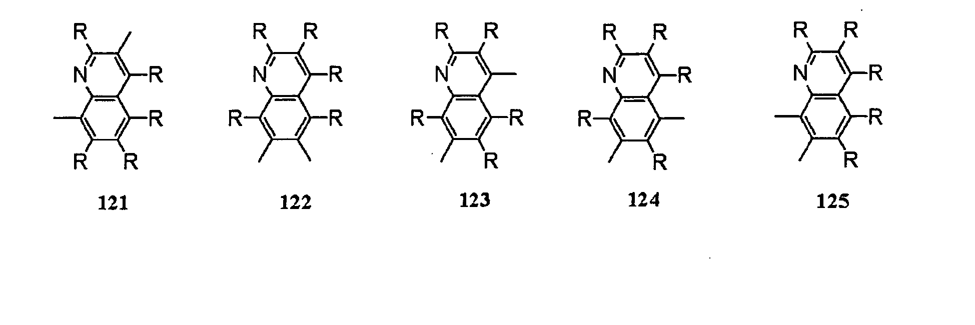

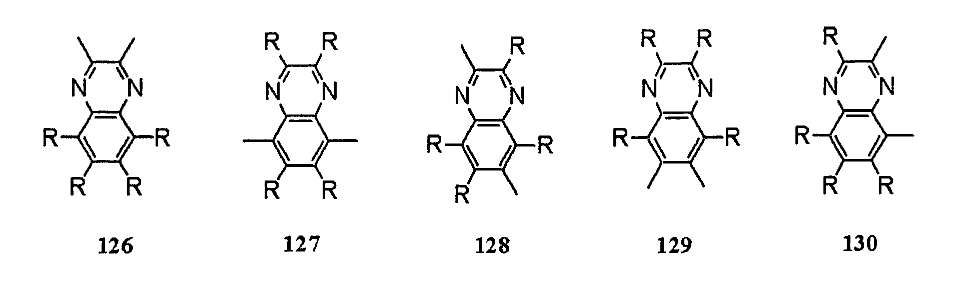

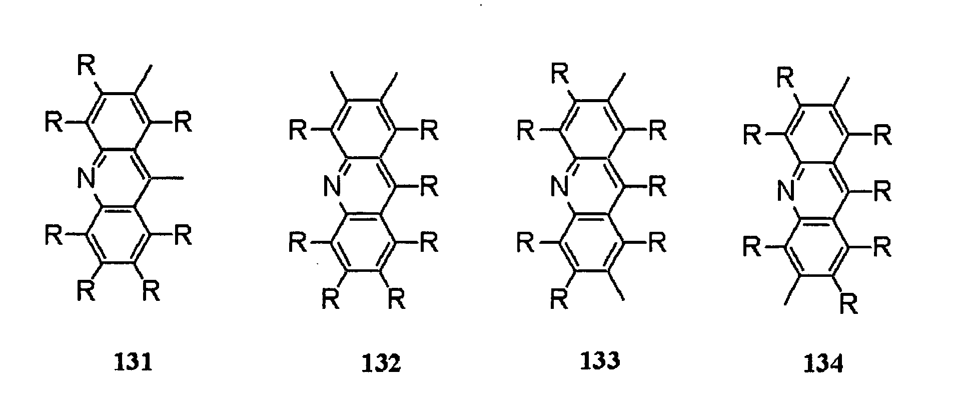

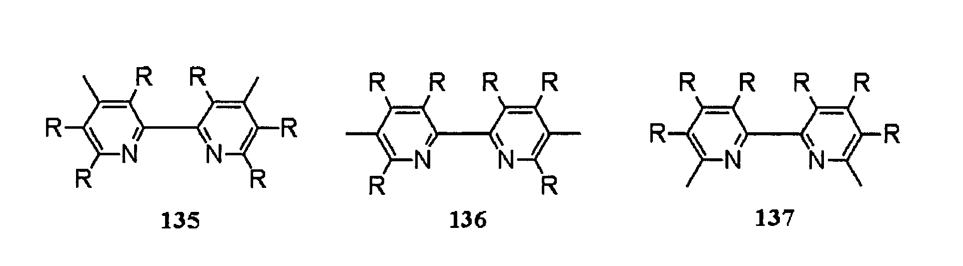

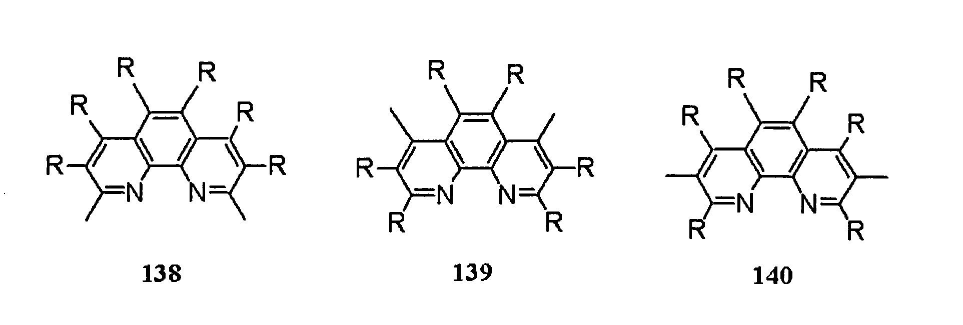

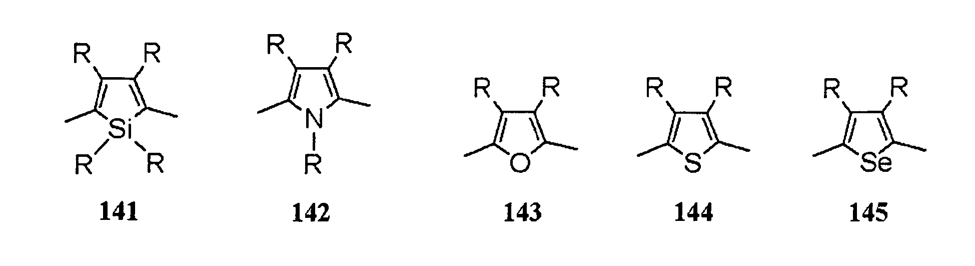

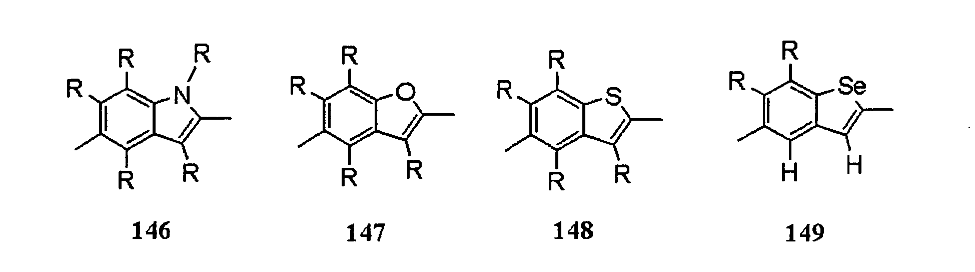

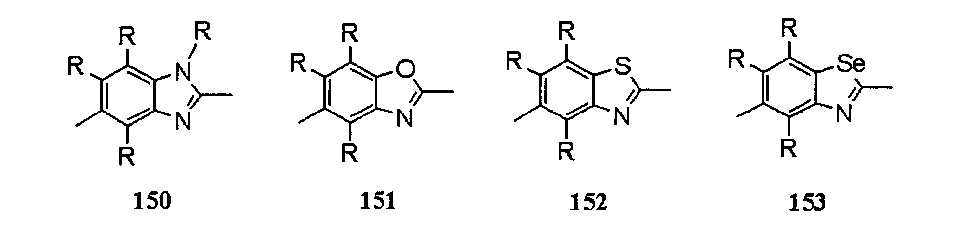

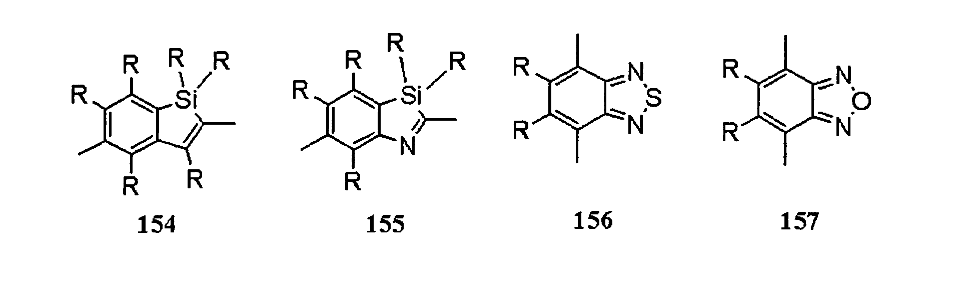

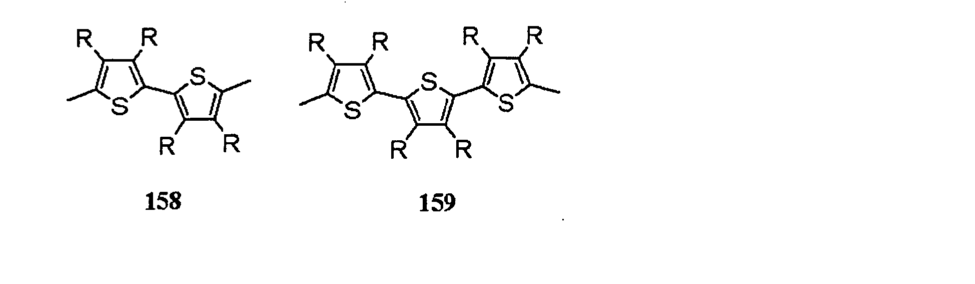

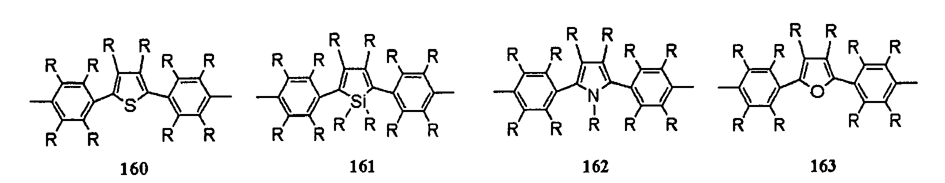

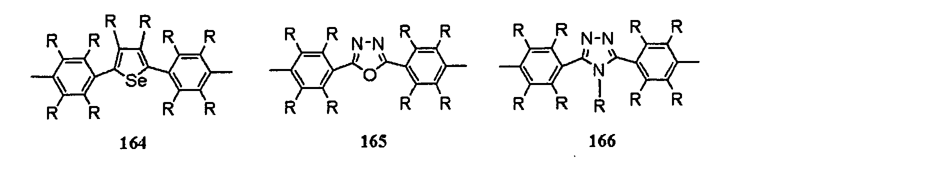

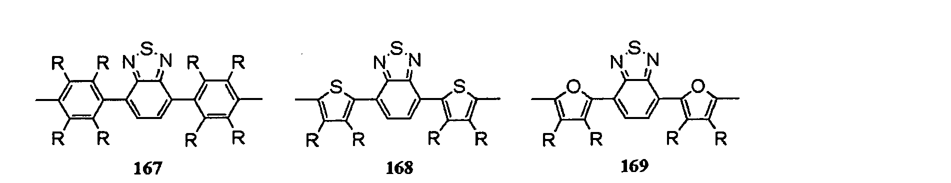

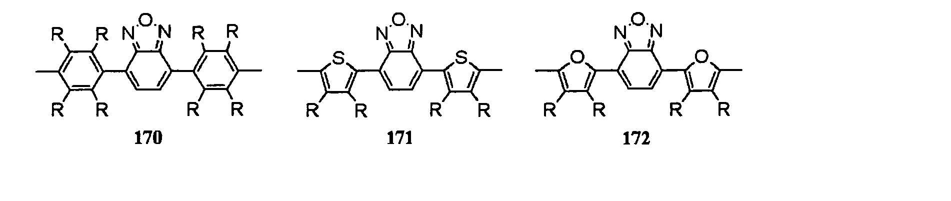

In the formulae (1 to 42, 101 to 172), R represents a hydrogen atom, alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group or nitro group.

Here, the definition and specific examples of the alkyl group, alkoxy group, alkylthio group, aryl group, aryloxy group, arylthio group, arylalkyl group, arylalkoxy group, arylalkylthio group, arylalkenyl group, arylalkynyl group, substituted amino group, substituted silyl group, halogen atom, acyl group, acyloxy group, imine residue, amide group, acid imide group, mono-valent heterocyclic group and substituted carboxyl group are the same as the definition and specific examples of them for the above-described R¹ and R².

The di-valent group having a metal complex structure includes groups of the following formulae M1 to M7.

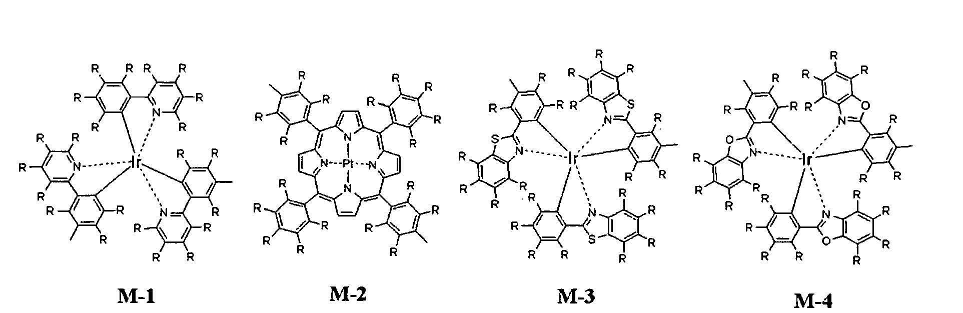

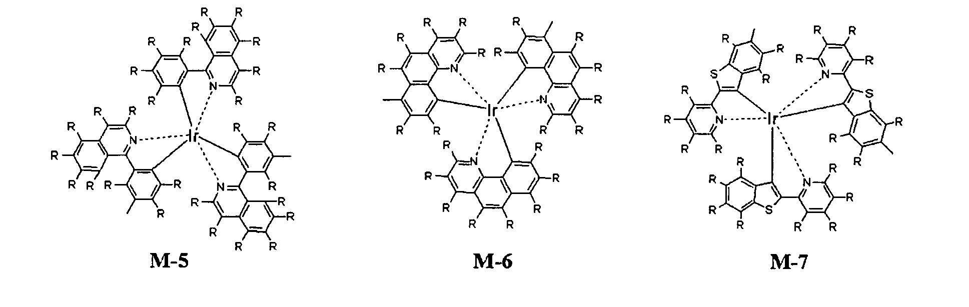

In the formulae (M-1) to (M-7), the definition and specific examples of R are the same as the definition and specific examples of R in the above-described formulae (1 to 42, 101 to 172).

The di-valent aromatic amine group includes a group of the formula (6). 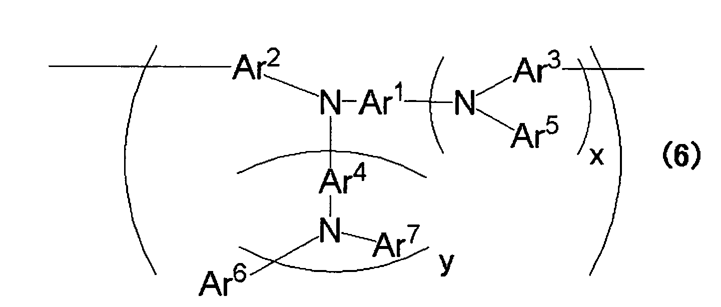 [in the formula (6), Ar¹, Ar², Ar³ and Ar⁴ represent each independently an arylene group or di-valent heterocyclic group, Ar⁵, Ar⁶ and Ar⁷ represent each independently an aryl group or mono-valent heterocyclic group, and x and y represent each independently an integer of 0 to 5.]

In the formula (6), x represents preferably 0 to 3, more preferably 0 or 1. y represents preferably 0 to 3, more preferably 0 or 1.

The definition and specific examples of the arylene group, di-valent heterocyclic group, aryl group and mono-valent heterocyclic group are the same as the definition and specific examples of them in the explanation of the above-described Ar.

The repeating unit of the formula (6) includes repeating units of the formulae (6-1) to (6-14).

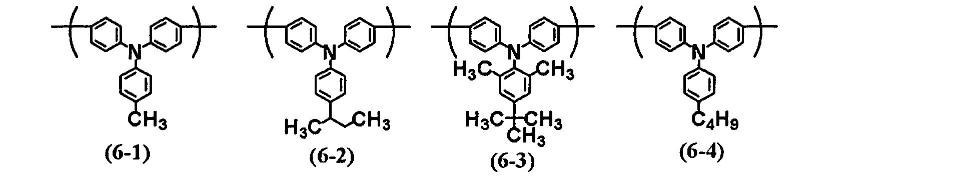

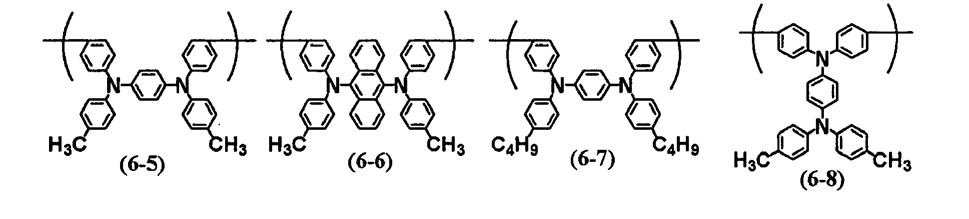

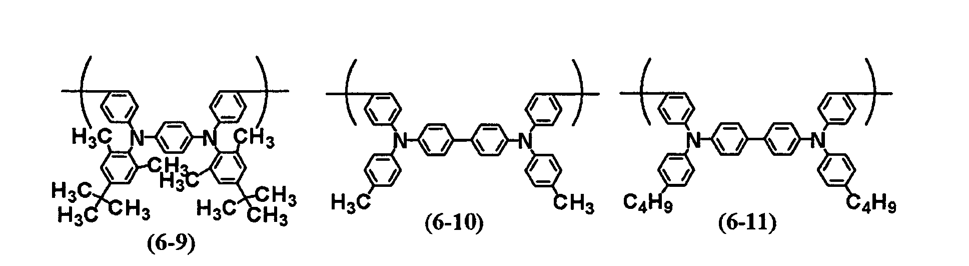

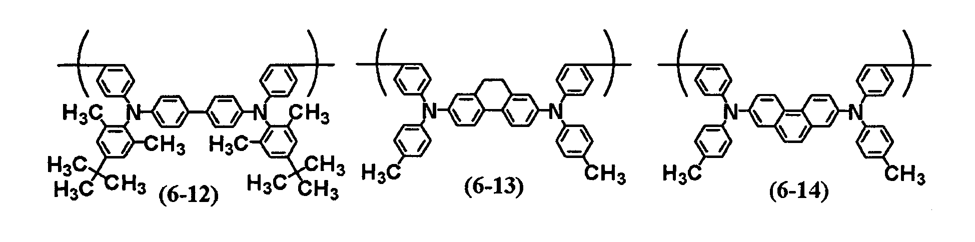

The polymer compound of the present invention includes a polymer compound composed of a repeating unit of the formula (1) and a repeating unit of the formula (2), a polymer compound composed of a repeating unit of the formula (1) and a repeating unit of the formula (3), a polymer compound composed of a repeating unit of the formula (1), a repeating unit of the formula (2) and a repeating unit of the formula (3), a polymer compound composed of a repeating unit of the formula (1), a repeating unit of the formula (2) and a repeating unit of the formula (7), a polymer compound composed of a repeating unit of the formula (1), a repeating unit of the formula (3) and a repeating unit of the formula (7), and a polymer compound composed of a repeating unit of the formula (1), a repeating unit of the formula (2), a repeating unit of the formula (3) and a repeating unit of the formula (7).

From the standpoint of the life property of a device, the polymer compound of the present invention has a polystyrene-equivalent number average molecular weight of preferably 10³ to 10⁸, more preferably 10³ to 10⁷, and further preferably 10⁴ to 10⁷.

The polymer compound of the present invention may also be a random, alternative, block or graft copolymer, or a polymer having an intermediate structure thereof, for example, a random copolymer having a block property. From the standpoint of obtaining a polymer light emitting body having high fluorescent or phosphorescent quantum yield, random copolymers having a block property and block or graft copolymers are more preferable than complete random copolymers. Further, a polymer compound having a branched main chain and having three or more terminal parts, and a dendrimer are also included in the polymer compound of the present invention.

As for the end group of the polymer compound of the present invention, if a polymerization active group derived from a raw material monomer of the polymer compound remains intact thereon, there is a possibility of reduction in the light emitting property and life-time of a device produced using this polymer compound, thus, the end group may be protected with a stable group. As the group, those having a conjugated bond continuing to a conjugated structure of the main chain are preferable, and there are exemplified structures in which the polymer compound is connected to an aryl group or heterocyclic group as a stable group via a carbon-carbon bond. Specifically, substituents described as Chemical Formula 10 in JP-A No. 9-45478 are exemplified, as the group to be used for protection.

As the good solvent for the polymer compound of the present invention, exemplified are chloroform, methylene chloride, dichloroethane, tetrahydrofuran, toluene, xylene, mesitylene, tetralin, decalin, n-butylbenzene and the like. Depending on the structure and molecular weight of the polymer compound, the polymer compound can be dissolved usually in an amount of 0.1 wt% or more in these solvents.

Next, the method of producing the polymer compound of the present invention will be explained.
The polymer compound of the present invention can be produced by, for example, using a compound of the formula:

Y₁-A-Y₂

[in the formula, -A- represents a repeating unit of the formula (1), (2) or (3). Y₁ and Y₂ represent each independently a substituent participating in condensation polymerization.]
and condensation-polymerizing this.

In the production method of the present invention, the substituents participating in condensation polymerization (Y₁ and Y₂) include a halogen atom, alkyl sulfonate group, aryl sulfonate group, arylalkyl sulfonate group, group derived from a borate, sulfoniummethyl group, phosphoniummethyl group, phosphonate methyl group, methyl monohalide group, -B(OH)₂, formyl group, cyano group and vinyl group.

Here, the halogen atom includes a fluorine atom, chlorine atom, bromine atom and iodine atom.

The alkyl sulfonate group includes a methane sulfonate group, ethane sulfonate group, trifluoromethane sulfonate group and the like, the aryl sulfonate group includes a benzene sulfonate group, p-toluene sulfonate group and the like, and the aryl sulfonate group includes a benzyl sulfonate group.

As the group derived from a borate, groups of the following formulae are mentioned. 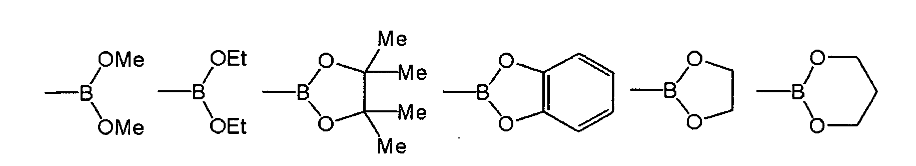 (in the formula, Me represents a methyl group, Et represents an ethyl group.)

As the sulfoniummethyl group, groups of the following formula are mentioned.

-CH₂S⁺Me₂X₁⁻, -CH₂S⁺Ph₂X₁⁻

(X₁ represents a halogen atom, Ph represents a phenyl group.)

As the phosphoniummethyl group, groups of the following formula are mentioned.

-CH₂P⁺Ph₃X₁⁻

(X₁ represents a halogen atom.)

As the phosphonate methyl group, groups of the following formula are mentioned.

-CH₂PO(OR')₂

(R' represents an alkyl group, aryl group or arylalkyl group.)

As the methyl monohalide group, a methyl fluoride group, methyl chloride group, methyl bromide group and methyl iodide group are mentioned.

Preferable substituents as the substituent participating in condensation polymerization include a halogen atom, alkyl sulfonate group, aryl sulfonate group or arylalkyl sulfonate group when the condensation polymerization reaction is, for example, a reaction using a 0-valent nickel complex such as the Yamamoto coupling reaction and the like, and an alkyl sulfonate group, halogen atom, group derived from a borate, -B(OH)₂ and the like in the case of a reaction using a nickel catalyst or palladium catalyst such as the Suzuki coupling reaction and the like, though varying depending on the kind of the condensation polymerization reaction.

The polymer compound of the present invention can be produced by dissolving a compound having a substituent participating in condensation polymerization (raw material compound) as a monomer in an organic solvent if necessary, and condensation-polymerizing this at a temperature of not lower than the melting point and not higher than the boiling point of the organic solvent using, for example, an alkali and a suitable catalyst. For production of the polymer compound of the present invention, there can be used known methods described in, for example, Organic Reactions, Volume 14, page 270-490, John Wiley & Sons,Inc., 1965; Organic Syntheses, Collective Volume VI, page 407-411, John Wiley & Sons, Inc., 1988; Chemical Review (Chem. Rev.), Volume 95, page 2457 (1995); Journal of Organometallic Chemistry (J. Organomet. Chem.), Volume 576, page 147 (1999); Macromolecular Chemistry Macromolecular Symposium (Makromol. Chem., Macromol.Symp.), Volume 12, page 229 (1987), and the like.

In the method of producing the polymer compound of the present invention, known condensation polymerization reactions can be used, depending on the substituent participating in condensation polymerization.

For example, the correspondent monomers are subjected to: a method of polymerization by the Suzuki coupling reaction, a method of polymerization by the Grignard reaction, a method of polymerization with a Ni(0) complex, a method of polymerization with an oxidizer such as FeCl₃ and the like, a method of electrochemical oxidation polymerization, a method by decomposition of an intermediate polymer having a suitable leaving group, and the like.

Of them, a method of polymerization by the Suzuki coupling reaction, a method of polymerization by the Grignard reaction and a method of polymerization with a nickel 0-valent complex are preferable from the standpoint of easiness of control of the structure of the polymer compound.

Among the production methods of the polymer compound of the present invention, preferable are production methods in which the substituents participating in condensation polymerization (Y₁ and Y₂) are each indepently selected from halogen atoms, alkyl sulfonate groups, aryl sulfonate groups and arylalkyl sulfonate groups, and condensation polymerization is carried out in the presence of a nickel 0-valent complex.
The raw material compound includes dihalogenated compounds, bis(alkyl sulfonate) compounds, bis(aryl sulfonate) compounds, bis(arylalkyl sulfonate) compounds, halogen-alkyl sulfonate compounds, halogen-aryl sulfonate compounds, halogen-arylalkyl sulfonate compounds, alkyl sulfonate-aryl sulfonate compounds, alkyl sulfonate-arylalkyl sulfonate compounds, and aryl sulfonate-arylalkyl sulfonate compounds.

In this case, there is mentioned a method in which a polymer compound having a controlled sequence is produced by using, for example, a halogen-alkyl sulfonate compound, halogen-aryl sulfonate compound, halogen-arylalkyl sulfonate compound, alkyl sulfonate-aryl sulfonate compound, alkyl sulfonate-arylalkyl sulfonate compound, or aryl sulfonate-arylalkyl sulfonate compound as the raw material compound.

Among the production methods of the polymer compound of the present invention, preferable is a production method in which the substituents participating in condensation polymerization (Y₁ and Y₂) are selected each independently from halogen atoms, alkyl sulfonate groups, aryl sulfonate groups, arylalkyl sulfonate groups, boric group or groups derived from borate groups, and the ratio of the sum (J) of mole numbers of halogen atoms, alkyl sulfonate groups, aryl sulfonate groups and arylalkyl sulfonate groups to the sum (K) of mole numbers of a boric group (-B(OH)₂) and groups derived from and borate groups, in all raw material compounds, is substantially 1 (usually, K/J is in the range of 0.7 to 1.2), and condensation polymerization is carried out using a nickel catalyst or palladium catalyst.
As combinations of raw material compounds, there are mentioned combinations of a dihalogenated compound, bis(alkyl sulfonate) compound, bis(aryl sulfonate) compound or bis(arylalkyl sufonate) compound with a diboric acid compound or diborate compound.
Further mentioned are a halogen-boric acid compound, halogen-borate compound, alkyl sulfonate-boric acid compound, alkyl sulfonate-borate compound, aryl sulfonate-boric acid compound, aryl sulfonate-borate compound, arylalkyl sulfonate-boric acid compound, arylalkyl sulfonate-boric acid compound and aryl alkyl sulfonate-borate compound.

In this case, there is mentioned a method in which a polymer compound having a controlled sequence is produced by using, for example, a halogen-boric acid compound, halogen-borate compound, alkyl sulfonate-boric acid compound, alkyl sulfonate-borate compound, aryl sulfonate-boric acid compound, aryl sulfonate-borate compound, arylalkyl sulfonate-boric acid compound, arylalkyl sulfonate-boric acid compound or arylalkyl sulfonate-borate compound as the raw material compound.

The solvent differs depending on the reaction and compound to be used, and for suppressing a side reaction, in general, it is preferable that the solvent to be used is subjected to a sufficient deoxygenation treatment and the reaction is progressed under an inert atmosphere. Further, it is preferable to perform a dehydration treatment likewise. However, this is not the case when a reaction in a two-phase system with water such as in the Suzuki coupling reaction is carried out.

The solvent includes saturated hydrocarbons such as pentane, hexane, heptane, octane, cyclohexane and the like, unsaturated hydrocarbons such as benzene, toluene, ethylbenzene, xylene and the like, halogenated saturated hydrocarbons such as carbon tetrachloride, chloroform, dichloromethane, chlorobutane, bromobutane, chloropentane, bromopentane, chlorohexane, bromohexane, chlorocyclohexane, bromocyclohexane and the like, halogenated unsaturated hydrocarbons such as chlorobenzene, dichlorobenzene, trichlorobenzene and the like, alcohols such as methanol, ethanol, propanol, isopropanol, butanol, t-butyl alcohol and the like, carboxylic acids such as formic acid, acetic acid, propionic acid and the like, ethers such as dimethyl ether, diethyl ether, methyl-t-butyl ether, tetrahydrofuran, tetrahydropyran, dioxane and the like, amines such as trimethylamine, triethylamine, N,N,N',N'-tetramethylethylenediamine, pyridine and the like, amides such as N,N-dimethylformamide, N,N-dimethylacetamide, N,N-diethylacetamide, N-methylmorpholine oxide, and the like. These solvents may be used singly or in admixture. Of them, preferable are toluene and tetrahydrofuran.

For progressing the condensation polymerization reaction, an alkali or suitable catalyst is appropriately added. These may be advantageously selected depending on the reaction to be used. As the alkali or catalyst, those which are sufficiently dissolved in the solvent used in the reaction are preferable. As the method of mixing an alkali or catalyst, there is mentioned a method in which a solution of an alkali or catalyst is added slowly to a reaction solution containing a raw material compound and a solvent under an inert atmosphere such as argon, nitrogen and the like while stirring the solution, or reversely, the reaction solution is slowly added to a solution of an alkali or catalyst.

When the polymer compound of the present invention is used in a polymer LED and the like, the purity of the polymer compound exerts an influence on the device performances such as a light emitting property and the like, thus, it is preferable to purify the monomer before polymerization by a method such as distillation, sublimation purification, re-crystallization and the like, then, to polymerize the monomer. Further, it is preferable, after polymerization, to carry out a purification treatment such as re-precipitation purification, chromatographic fractionation and the like.

The composition of the present invention is a composition containing the polymer compound of the present invention, and includes a composition characterized by containing at least one material selected from the group consisting of a hole transporting material, electron transporting material and light emitting material, and at least one polymer compound of the present invention, a composition characterized by containing at least two polymer compounds of the present invention, and the like.

The liquid composition of the present invention is useful for fabrication of light-emitting devices such as polymer light-emitting devices, and organic transistors. The liquid composition contains the above-described polymer compound and a solvent. In this specification, "liquid composition" means a composition which is liquid in device fabrication, and usually, liquid at normal pressure (namely, 1 atm) and 25°C. The liquid composition is, in general, referred to as ink, ink composition, solution or the like in some cases.

The liquid composition of the present invention may also contain a low molecular weight light emitting material, hole transporting material, electron transporting material, stabilizer, additive for adjusting viscosity and/or surface tension, antioxidant and the like, in addition to the above-described polymer compound. These optional components may be each used singly or in combination of two or more.

Examples of the low molecular weight fluorescent material which may be contained in the liquid composition of the present invention include naphthalene derivatives, anthracene, anthracene derivatives, perylene, perylene derivatives, polymethine dyes, xanthene dyes, coumarine dyes, cyanine dyes; metal complexes having a metal complex of 8-hydroxyquinoline as a ligand; metal complexes having a 8-hydroxyquinoline derivative as a ligand; other fluorescent metal complexes, aromatic amines, tetraphenylcyclopentadiene, tetraphenylcyclopentadiene derivatives, tetraphenylcyclobutadiene, tetraphenylcyclobutadiene derivatives, and fluorescent materials of low molecular weight compounds such as stilbene, silicon-containing aromatic, oxazole, furoxane, thiazole, tetraarylmethane, thiadiazole, pyrazole, metacyclophane, acetylene and the like. As the low molecular weight fluorescent material, specifically, those described in, for example, JP-A No. 57-51781, JP-A NO. 59-194393 and the like, and known materials are mentioned.

Examples of the hole transporting material which may be contained in the liquid composition of the present invention include polyvinylcarbazole and derivatives thereof, polysilane and derivatives thereof, polysiloxane derivatives having an aromatic amine in the side chain or the main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylenevinylene) and derivatives thereof, poly(2,5-thienylenevinylene) and derivatives thereof, and the like.

Examples of the electron transporting material which may be contained in the liquid composition of the present invention include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives; metal complexes of 8-hydroxyquinoline and derivatives thereof; polyquinoline and derivatives thereof, polyquinoxaline and derivatives thereof, polyfluorene and derivatives thereof, and the like.

Examples of the stabilizer which may be contained in the liquid composition of the present invention include phenol antioxidants, phosphorus antioxidants and the like.

As the additive for adjusting viscosity and/or surface tension which may be contained in the liquid composition of the present invention, for example, a high molecular weight compound for increasing viscosity (thickening agent), a poor solvent, a low molecular weight compound for decreasing viscosity, a surfactant for lowering surface tension, and the like, may be appropriately combined and used. Here, the poor solvent means a solvent with which the weight of the polymer compound of the present invention dissolved in 1 g of the solvent is 0.1 mg or less.

As the above-described high molecular weight compound, those not disturbing light emission and charge transportation may be permissible, and usually, those which are soluble in the solvent of the liquid composition are mentioned. As the high molecular weight compound, for example, polystyrene of high molecular weight, polymethyl methacrylate of high molecular weight, and the like can be used. The above-described high molecular weight compound has a polystyrene-equivalent number average molecular weight of preferably 500000 or more, more preferably 1000000 or more. Also a poor solvent can be used as a thickening agent.

As the antioxidant which may be contained in the liquid composition of the present invention, those not disturbing light emission and charge transportation may be permissible, and when the composition contains a solvent, usually those which are soluble in the solvent are mentioned. As the antioxidant, phenol antioxidants, phosphorus antioxidants and the like are exemplified. By use of the antioxidant, preservation stability of the above-described polymer compound and solvent can be improved.

When the liquid composition of the present invention contains a hole transporting material, the amount of the hole transporting material in the liquid composition is usually 1 to 80, preferably 5 to 60 when the weight of the liquid composition excluding the solvent is 100. When the liquid composition of the present invention contains an electron transporting material, the amount of the electron transporting material in the liquid composition is usually 1 to 80, preferably 5 to 60 when the weight of the liquid composition excluding the solvent is 100.

In the case of film formation using this liquid composition in fabricating a polymer light-emitting device, it may be advantageous to only remove a solvent by drying after application of the liquid composition, and also in the case of mixing of a charge transporting material and a light emitting material, the same means can be applied, that is, this method is extremely advantageous for production. In drying, drying may be effected under heating at about 50 to 150°C, alternatively, drying may be carried out under reduced pressure of about 10⁻³ Pa.

As the film formation method using the liquid composition, application methods such as a spin coat method, casting method, micro gravure coat method, gravure coat method, bar coat method, roll coat method, wire bar coat method, dip coat method, spray coat method, screen printing method, flexo printing method, offset printing method, inkjet print method and the like can be used.

The proportion of a solvent in the liquid composition is usually 1 wt% to 99.9 wt%, preferably 60 wt% to 99.9 wt%, further preferably 90 wt% to 99.8 wt% with respect to the total weight of the liquid composition. Though the viscosity of the liquid composition varies depending on a printing method, the viscosity at 25°C is preferably in the range of 0.5 to 500 mPa·s, and when a liquid composition passes through a discharge apparatus such as in an inkjet print method and the like, the viscosity at 25°C is preferably in the range of 0.5 to 20 mPa·s, for preventing clogging and flying curving in discharging.

As the solvent contained in the liquid composition, those capable of dissolving or dispersing components other than the solvent in the liquid composition are preferable. Exemplified as the solvent are chlorine-based solvents such as chloroform, methylene chloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene, trimethylbenzene, mesitylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, methyl benzoate, ethylcellosolve acetate and the like, polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexane diol and the like and derivatives thereof, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide, and the like. These solvents may be used singly or in combination of two or more. Among the above-described solvents, one or more organic solvents having a structure containing at least one benzene ring and having a melting point of 0°C or lower and a boiling point of 100°C or higher are preferably contained from the standpoint of viscosity, film formability and the like.

Regarding the kind of the solvent, aromatic hydrocarbon solvents, aliphatic hydrocarbon solvents, ester solvents and ketone solvents are preferable from the standpoint of solubility of components other than the solvent in the liquid composition into the solvent, uniformity in film formation, viscosity property and the like, and preferable are toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone and dicyclohexyl ketone, and it is more preferable to contain at least one of xylene, anisole, mesitylene, cyclohexylbenzene and bicyclohexylmethyl benzoate.

The number of the solvent to be contained in the liquid composition is preferably two or more, more preferably two to three, and further preferably two from the standpoint of film formability and from the standpoint of device properties and the like.

When two solvents are contained in the liquid composition, one of them may be solid at 25°C. From the standpoint of film formability, it is preferable that one solvent has a boiling point of 180°C or higher and another solvent has a boiling point of lower than 180°C, and it is more preferable that one solvent has a boiling point of 200°C or higher and another solvent has a boiling point of lower than 180°C. From the standpoint of viscosity, it is preferable that 0.2 wt% or more of components excepting solvents from the liquid composition are dissolved at 60°C in solvents, and it is preferable that 0.2 wt% or more of components excepting solvents from the liquid composition are dissolved at 25°C in one of two solvents.

When three solvents are contained in the liquid composition, one or two of them may be solid at 25°C. From the standpoint of film formability, it is preferable that at least one of three solvents has a boiling point of 180°C or higher and at least one solvent has a boiling point of 180°C or lower, and it is more preferable that at least one of three solvents has a boiling point of 200°C or higher and 300°C or lower and at least one solvent has a boiling point of 180°C or lower. From the standpoint of viscosity, it is preferable that 0.2 wt% or more of components excepting solvents from the liquid composition are dissolved at 60°C in two of three solvents, and it is preferable that 0.2 wt% or more of components excepting solvents from the liquid composition are dissolved at 25°C in one of three solvents.

When two or more solvents are contained in the liquid composition, the content of a solvent having the highest boiling point is preferably 40 to 90 wt%, more preferably 50 to 90 wt%, and further preferably 65 to 85 wt% with respect to the weight of all solvents contained in the liquid composition, from the standpoint of viscosity and film formability.

### <Application>

The polymer compound of the present invention can be used not only as a light-emitting material, but also as a thin film, organic semiconductor material, organic transistor, optical material, solar battery, or a conductive material by doping.

The thin film of the present invention will be illustrated. This thin film contains the above-described polymer compound. As the kind of the thin film, a light emitting thin film, conductive thin film, organic semiconductor thin film and the like are exemplified.

The light emitting thin film has a light emission quantum yield of preferably 50% or more, more preferably 60% or more and further preferably 70% or more from the standpoint of the brilliance and light emission voltage of a device and the like.

The conductive thin film preferably has a surface resistance of 1 KΩ/□ or less. By doping the thin film with a Lewis acid, ionic compound or the like, electric conductivity can be enhanced. The surface resistance is more preferably 100 Ω/□ or less, further preferably 10 Ω/□ or less.

In the organic semiconductor thin film, one larger parameter of electron mobility or hole mobility is preferably 10⁻⁵ cm²/V/s or more, more preferably 10⁻³ cm²/V/s or more, and further preferably 10⁻¹ cm²/V/s or more. Using the organic semiconductor thin film of the present invention, an organic transistor can be fabricated. For example, by forming the organic semiconductor thin film on a Si substrate carrying a gate electrode and an insulation film made of SiO₂ and the like formed thereon, and forming a source electrode and a drain electrode with Au and the like, an organic transistor can be obtained.

Next, a polymer electric field effect transistor as one embodiment of organic transistors will be described.

The polymer compound of the present invention can be suitably used as a material of a polymer electric field effect transistor, particularly, as a material of an active layer. Regarding the structure of a polymer electric field effect transistor, it may be usually advantageous that a source electrode and a drain electrode are placed in contact with an active layer made of a polymer, further, a gate electrode is placed sandwiching an insulation layer in contact with the active layer.

The polymer electric field effect transistor is usually formed on a supporting substrate. The material of the supporting substrate is not particularly restricted providing it does not disturb a property as an electric field effect transistor, and glass substrates and flexible film substrates and plastic substrates can also be used.

The polymer electric field effect transistor can be produced by known methods, for example, a method described in JP-A No. 5-110069.

It is very advantageous and preferable for production to use a polymer compound soluble in an organic solvent, in forming an active layer. As the method of film formation from a solution prepared by dissolving an organic solvent-soluble polymer compound in a solvent, application methods such as a spin coat method, casting method, micro gravure coat method, gravure coat method, bar coat method, roll coat method, wire bar coat method, dip coat method, spray coat method, screen printing method, flexo printing method, offset printing method, inkjet printing method and the like can be used.

Preferable is an encapsulated polymer electric field effect transistor obtained by fabricating a polymer electric field effect transistor, then, encapsulating this. By this, the polymer electric field effect transistor is blocked from atmospheric air, thereby, lowering of properties of the polymer electric field effect transistor can be suppressed.

As the encapsulation method, a method of covering with an ultraviolet (UV) hardening resin, thermosetting resin, inorganic SiONx film and the like, a method of pasting a glass plate or film with an UV hardening resin, thermosetting resin or the like, and other methods are mentioned. For effectively performing blocking from atmospheric air, it is preferable that processes after fabrication of a polymer electric field effect transistor until encapsulation are carried out without exposing to atmospheric air (for example, in dried nitrogen atmosphere, vacuum and the like).

Next, the organic solar battery will be described. A solid photoelectric conversion device utilizing a photoelectromotive force effect as an organic photoelectric conversion device as one embodiment of organic solar batteries will be described.

The polymer compound of the present invention can be suitably used as a material of an organic photoelectric conversion device, particularly, as an organic semiconductor layer of a schottky barrier type device utilizing an interface between an organic semiconductor and a metal, or as an organic semiconductor layer of a pn hetero junction type device utilizing an interface between an organic semiconductor and an inorganic semiconductor or between organic semiconductors.

Further, the polymer compound of the present invention can be suitably used as an electron donating polymer or an electron accepting polymer in a bulk hetero junction type device in which the donor-acceptor contact area is increased, or an electron donating conjugated polymer (dispersion supporting body) of an organic photoelectric conversion device using a high molecular weight-low molecular weight complex system, for example, a bulk hetero junction type organic photoelectric conversion device containing a dispersed fullerene derivative as an electron acceptor.

With respect to the structure of the organic photoelectric conversion device, in the case of for example a pn hetero junction type device, it is advantageous that a p type semiconductor layer is formed on an ohmic electrode, for example, on ITO, further, an n type semiconductor layer is laminated, and an ohmic electrode is provided thereon.

The organic photoelectric conversion device is usually formed on a supporting substrate. The material of the supporting substrate is not particularly restricted providing it does not disturb a property as an organic photoelectric conversion device, and glass substrates and flexible film substrates and plastic substrates can also be used.

The organic photoelectric conversion device can be produced by known methods, for example, a method described in Synth. Met., 102, 982 (1999), and a method described in Science, 270, 1789 (1995).

Next, the polymer light-emitting device of the present invention will be described.

The polymer light-emitting device of the present invention contains electrodes consisting of an anode and a cathode, and a layer arranged between the electrodes and containing the polymer compound of the present invention.

The polymer light-emitting device of the present invention includes (1) a polymer light-emitting device having an electron transporting layer arranged between a cathode and a light emitting layer, (2) a polymer light-emitting device having a hole transporting layer arranged between an anode and a light emitting layer, (3) a polymer light-emitting device having an electron transporting layer arranged between a cathode and a light emitting layer and having a hole transporting layer arranged between an anode and a light emitting layer; and the like.

Specifically, the following structures a) to d) are mentioned as the polymer light-emitting device of the present invention.
a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode
   (wherein, "/" means adjacent lamination of layers; hereinafter, the same shall apply in this specification.)

Here, the light emitting layer is a layer having a function of emitting light. The hole transporting layer is a layer having a function of transporting holes, and the electron transporting layer is a layer having a function of transporting electrons. The electron transporting layer and hole transporting layer are collectively called a charge transporting layer. Each of these light emitting layers, hole transporting layers and electron transporting layers may be independently used in combination of two or more.
A hole transporting layer adjacent to a light emitting layer is called an interlayer layer in some cases.

Though the method of film formation of a light emitting layer is not restricted, methods of film formation from a solution are exemplified.

For film formation from a solution, application methods such as a spin coat method, casting method, micro gravure coat method, gravure coat method, bar coat method, roll coat method, wire bar coat method, dip coat method, spray coat method, screen printing method, flexo printing method, offset printing method, inkjet printing method and the like can be used.

In the case of film formation from a solution using the polymer compound of the present invention in fabricating a polymer light-emitting device, it may be advantageous to only remove a solvent by drying after application of this solution, and also in the case of mixing of a charge transporting material and a light emitting material, the same means can be applied, that is, this method is extremely advantageous for production.

The thickness of a light emitting layer shows an optimum value varying depending on a material to be used, and may be advantageously regulated so as to give appropriate values of driving voltage and light emission efficiency, and is, for example, 1 nm to 1 µm, preferably 2 nm to 500 nm, and further preferably 5 nm to 200 nm.

As one embodiment of the polymer light-emitting device of the present invention, those containing the above-described polymer compound in a light emitting layer are mentioned. In this case, the light emitting layer may contain a light emitting material other than the polymer compound. The light emitting layer containing a light emitting material other than the polymer compound may be laminated with a light emitting layer containing the above-described polymer compound.

As the light emitting material other than the above-described polymer compound, known materials can be used. As the compounds of low molecular weight, for example, naphthalene derivatives, anthracene and derivatives thereof, perylene and derivatives thereof, coloring matters such as polymethines, xanthenes, coumarins and cyanines, metal complexes of 8-hydroxyquinoline and derivatives thereof, aromatic amines, tetraphenylcyclopentadiene and derivatives thereof, tetraphenylbutadiene and derivatives thereof, and the like can be used. Specifically, known materials such as those described in, for example, JP-A Nos. 57-51781, 59-194393, and the like can be used.

When the polymer light-emitting device of the present invention contains a hole transporting layer, exemplified as the hole transporting material to be used are polyvinylcarbazole and its derivatives, polysilane and its derivatives, polysiloxane derivatives having an aromatic amine on the side chain or main chain, pyrazoline derivatives, arylamine derivatives, stilbene derivatives, triphenyldiamine derivatives, polyaniline and its derivatives, polythiophene and its derivatives, polypyrrole and its derivatives, poly(p-phenylenevinylene) and its derivatives, poly(2,5-thienylenevinylene) and its derivatives, and the like. Specifically, exemplified as the hole transporting material are those described in JP-A Nos. 63-70257, 63-175860, 2-135359, 2-135361, 2-209988, 3-37992 and 3-152184, and the like.

Among them, preferable as the hole transporting material used in a hole transporting layer are high molecular weight hole transporting materials such as polyvinylcarbazole and its derivatives, polysilane and its derivatives, polysiloxane derivatives having an aromatic amine compound group on the side chain or main chain, polyaniline and its derivatives, polythiophene and its derivatives, poly(p-phenylenevinylene) and its derivatives, poly(2,5-thienylenevinylene) and its derivatives, and the like, and further preferable are polyvinylcarbazole and its derivatives, polsilane and its derivatives, and polysiloxane derivatives having an aromatic amine on the side chain or main chain. In the case of a low molecular weight hole transporting material, it is preferable that the hole transporting material is dispersed in a polymer binder in use.

Polyvinylcarbazole and its derivative are obtained, for example, from a vinyl monomer by cation polymerization or radical polymerization.

As the polysilane and its derivative, compounds described in Chemical Review (Chem. Rev.), vol. 89, p. 1359 (1989), GB Patent No. 2300196 publication, and the like are exemplified. Also as the synthesis method, methods described in them can be used, and particularly, the Kipping method is suitably used.

In the polysiloxane derivative, the siloxane skeleton structure shows little hole transporting property, thus, those having a structure of the above-mentioned low molecular weight hole transporting material on the side chain or main chain are suitably used. Particularly, those having an aromatic amine showing a hole transporting property on the side chain or main chain are exemplified.

The film formation method of a hole transporting layer is not particularly restricted, and in the case of use of a low molecular weight hole transporting material, a method of film formation from a mixed solution with a polymer binder is exemplified. In the case of a high molecular weight hole transporting material, a method of film formation from a solution is exemplified.

The solvent to be used for film formation from a solution is not particularly restricted providing it can dissolve a hole transporting material. Exemplified as the solvent are chlorine-based solvents such as chloroform, methylene chloride, dichloroethane and the like, ether solvents such as tetrahydrofuran and the like, aromatic hydrocarbon solvents such as toluene, xylene and the like, ketone solvents such as acetone, methyl ethyl ketone and the like, ester solvents such as ethyl acetate, butyl acetate, ethylcellosolve acetate and the like.

As the film formation method from a solution, there can be used application methods such as a spin coat method, casting method, micro gravure coat method, gravure coat method, bar coat method, roll coat method, wire bar coat method, dip coat method, spray coat method, screen printing method, flexo printing method, offset printing method, inkjet print method and the like from a solution.

As the polymer binder to be mixed, those not extremely disturbing charge transportation are preferable, and those showing no strong absorption against visible light are suitably used. Exemplified as the polymer binder are polycarbonate, polyacrylate, polymethyl acrylate, polymethyl methacrylate, polystyrene, polyvinyl chloride, polysiloxane and the like.

Regarding the thickness of a hole transporting layer, the optimum value varies depending on a material to be used, and it may be advantageously selected so that the driving voltage and light emission efficiency become optimum, and a thickness at least causing no formation of pin holes is necessary, and when the thickness is too large, the driving voltage of a device increases undesirably. Therefore, the thickness of the hole transporting layer is, for example, 1 nm to 1 µm, preferably 2 nm to 500 nm, and further preferably 5 nm to 200 nm.

When the polymer light-emitting device of the present invention has an electron transporting layer, known materials can be used as the electron transporting material to be used, and exemplified are oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, and the like. Specifically, those described in JP-A Nos. 63-70257, 63-175860, 2-135359, 2-135361, 2-209988, 3-37992 and 3-152184, and the like are exemplified as the electron transporting material.

Of them, oxadiazole derivatives, benzoquinone and its derivatives, anthraquinone and its derivatives, metal complexes of 8-hydroxyquinoline and its derivatives, polyquinoline and its derivatives, polyquinoxaline and its derivatives, polyfluorene and its derivatives are preferable, and 2-(4-biphenylyl)-5-(4-t-butylphenyl)-1,3,4-oxadiazole, benzoqinone, anthraquinone, tris(8-quinolinol)aluminum and polyquinoline are further preferable.
The film formation method of an electron transporting layer is not particularly restricted, and in the case of use of an electron transporting material of low molecular weight, exemplified are a vacuum vapor-deposition method from a powder and a film formation method from solution or melted state, and in the case of use of an electron transporting material of high molecular weight, a film formation method from solution or melted state is exemplified, respectively. In film formation from solution or melted state, a polymer binder may be used together.

The solvent used for film formation from a solution is not particularly restricted providing it can dissolve an electron transporting material and/or polymer binder. Exemplified as the solvent are chlorine-based solvents such as chloroform, methylene chloride, dichloroethane and the like, ether solvents such as tetrahydrofuran and the like, aromatic hydrocarbon solvents such as toluene, xylene and the like, ketone solvents such as acetone, methyl ethyl ketone and the like, ester solvents such as ethyl acetate, butyl acetate, ethylcellosolve acetate and the like.

As the film formation method from solution or melted state, application methods such as a spin coat method, casting method, micro gravure coat method, gravure coat method, bar coat method, roll coat method, wire bar coat method, dip coat method, spray coat method, screen printing method, flexo printing method, offset printing method, inkjet printing method and the like can be used.

As the polymer binder to be mixed, those not extremely disturbing charge transportation are preferable, and those showing no strong absorption against visible light are suitably used. Exemplified as the polymer binder are poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride, polysiloxane and the like.

Regarding the thickness of an electron transporting layer, the optimum value varies depending on a material to be used, and it may be advantageously selected so that the driving voltage and light emission efficiency become optimum, and a thickness at least causing no formation of pin holes is necessary, and when the thickness is too large, the driving voltage of a device increases undesirably. Therefore, the thickness of the electron transporting layer is, for example, 1 nm to 1 µm, preferably 2 nm to 500 nm, and further preferably 5 nm to 200 nm.

Among charge transporting layers arranged adjacent to an electrode, those having a function of improving charge injection efficiency from an electrode and having an effect of lowering the driving voltage of a device are, in particularly, called generally a charge injection layer (hole injection layer, electron injection layer).

Further, for improving close adherence with an electrode or improving charge injection from an electron, the above-mentioned charge injection layer or insulation layer may be arranged adjacent to the electrode, alternatively, for improving close adherence of an interface or preventing mixing, a thin buffer layer may be inserted into an interface of a charge transporting layer and a light emitting layer.

The order and number of layers to be laminated, and the thickness of each layer may be appropriately determined in view of light emission efficiency and device life.

In the present invention, as the polymer light-emitting device carrying a disposed charge injection layer (electron injection layer, hole injection layer), mentioned are polymer light-emitting devices having a charge injection layer arranged adjacent to a cathode and polymer light-emitting devices having a charge injection layer provided adjacent to an anode.

For example, the following structures e) to p) are mentioned as the polymer light-emitting device having a charge injection layer.
e) anode/charge injection layer/light emitting layer/cathode
f) anode/light emitting layer/charge injection layer/cathode
g) anode/charge injection layer/light emitting layer/charge injection layer/cathode
h) anode/charge injection layer/hole transporting layer/light emitting layer/cathode
i) anode/hole transporting layer/light emitting layer/charge injection layer/cathode
j) anode/charge injection layer/hole transporting layer/light emitting layer/charge injection layer/cathode
k) anode/charge injection layer/light emitting layer/charge transporting layer/cathode
l) anode/light emitting layer/electron transporting layer/charge injection layer/cathode
m) anode/charge injection layer/light emitting layer/electron transporting layer/charge injection layer/cathode
n) anode/charge injection layer/hole transporting layer/light emitting layer/charge transporting layer/cathode
o) anode/hole transporting layer/light emitting layer/electron transporting layer/charge injection layer/cathode
p) anode/charge injection layer/hole transporting layer/light emitting layer/electron transporting layer/charge injection layer/cathode

As specific examples of the charge injection layer, exemplified are a layer containing an electric conductive polymer, a layer provided arranged between an anode and a hole transporting layer and containing a material having ionization potential of a value between an anode material and a hole transporting material contained in a hole transporting layer, a layer arranged between a cathode and an electron transporting layer and containing a material having electron affinity of a value between a cathode material and an electron transporting material contained in an electron transporting layer, and the like.

When the above-mentioned charge injection layer contains an electric conductive polymer, the electric conductivity of the electric conductive polymer is preferably 10⁻⁵ S/cm or more and 10³ S/cm or less, and for decreasing leak current between light emission picture elements, more preferably 10⁻⁵ S/cm or more and 10² S/cm or less, and further preferably 10⁻⁵ S/cm or more and 10¹ S/cm or less. Usually, for controlling the electric conductivity of the electric conductive polymer to 10⁻⁵ S/cm or more and 10³ S/cm or less, the electric conductive polymer is doped with a suitable amount of ions.

As the kind of ions to be doped, an anion is used when the charge injection layer is a hole injection layer and a cation is used when the charge injection layer is an electron injection layer. The anion includes a polystyrenesulfonic ion, alkylbenzenesulfonic ion and camphorsulfonic ion, and the cation includes a lithium ion, sodium ion, potassium ion and tetrabutylammonium ion.

The thickness of the charge injection layer is, for example, 1 nm to 100 nm, preferably 2 nm to 50 nm.

The material used in the charge injection layer may be appropriately selected depending on a relation with materials of an electrode and an adjacent layer, and exemplified are electric conductive polymers such as polyaniline and its derivatives, polythiophene and its derivatives, polypyrrole and its derivatives, polyphenylenevinylene and its derivatives, polythienylenevinylene and its derivatives, polyquinoline and its derivatives, polyquinoxaline and its derivatives, polymers containing an aromatic amine structure on the main chain or side chain, and the like, and metal phthalocyanines (copper phthalocyanine and the like), carbon and the like.

The insulation layer has a function of making charge injection easy. The average thickness of this insulation layer is usually 0.1 to 20 nm, preferably 0.5 to 10 nm, more preferably 1 to 5 nm.
As the material of the insulation layer, metal fluorides, metal oxides, organic insulating materials and the like are mentioned. As the polymer light-emitting device carrying an insulation layer provided thereon, there are mentioned polymer light-emitting devices in which an insulation layer is arranged adjacent to a cathode, and polymer light-emitting devices in which an insulation layer is arranged adjacent to an anode.
For example, the following structures q) to ab) are mentioned as the polymer light-emitting device having an insulation layer.
q) anode/insulation layer/light emitting layer/cathode
r) anode/light emitting layer/insulation layer/cathode
s) anode/insulation layer/light emitting layer/insulation layer/cathode
t) anode/insulation layer/hole transporting layer/light emitting layer/cathode
u) anode/hole transporting layer/light emitting layer/insulation layer/cathode
v) anode/insulation layer/hole transporting layer/light emitting layer/insulation layer/cathode
w) anode/insulation layer/light emitting layer/electron transporting layer/cathode
x) anode/light emitting layer/electron transporting layer/insulation layer/cathode
y) anode/insulation layer/light emitting layer/electron transporting layer/insulation layer/cathode
z) anode/insulation layer/hole transporting layer/light emitting layer/electron transporting layer/cathode
aa) anode/hole transporting layer/light emitting layer/electron transporting layer/insulation layer/cathode
ab) anode/insulation layer/hole transporting layer/light emitting layer/electron transporting layer/insulation layer/cathode

The substrate which forms a polymer light-emitting device of the present invention may advantageously be one which forms an electrode and which does not change in forming a layer of an organic substance, and for example, substrates of glass, plastic, polymer film, silicon and the like are exemplified. In the case of an opaque substrate, it is preferable that the opposite electrode is transparent or semi-transparent.

In the present invention, it is usually preferable that at least one of electrodes consisting of an anode and cathode is transparent or semi-transparent.

As the material of the anode, an electric conductive metal oxide film, semi-transparent metal thin film and the like are used. Specifically, films (NESA and the like) formed using electric conductive glass composed of indium oxide, zinc oxide, tin oxide, and composite thereof: indium-tin-oxide (ITO), indium-zinc-oxide and the like, gold, platinum, silver, copper and the like are used, and ITO, indium-zinc-oxide, tin oxide are preferable. As the fabrication method, a vacuum vapor-deposition method, sputtering method, ion plating method, plating method and the like are mentioned. As the anode, organic transparent electric conductive films made of polyaniline and its derivatives, polythiophene and its derivatives, and the like may be used.

The thickness of an anode can be appropriately selected in view of light transmission and electric conductivity, and it is, for example, 10 nm to 10 µm, preferably 20 nm to 1 µm, and further preferably 50 nm to 500 nm.

For making electric charge injection easy, a layer made of a phthalocyanine derivative, electric conductive polymer, carbon and the like, or a layer made of a metal oxide, metal fluoride, organic insulation material and the like, may be provided on an anode.

As the material of a cathode, materials of small work function are preferable. For example, metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and the like, alloys of two or more of them, or alloys made of at least one of them and at least one of gold, silver, platinum, copper, manganese, titanium, cobalt, nickel, tungsten and tin, graphite or graphite intercalation compounds and the like are used. Examples of the alloy include magnesium-silver alloy, magnesium-indium alloy, magnesium-aluminum alloy, indium-silver alloy, lithium-aluminum alloy, lithium-magnesium alloy, lithium-indium alloy, calcium-aluminum alloy and the like. The cathode may take a structure of one layer or a laminated structure including two or more layers.

The thickness of a cathode can be appropriately selected in view of electric conductivity and durability, and it is, for example, 10 nm to 10 µm, preferably 20 nm to 1 µm, and further preferably 50 nm to 500 nm.

As the cathode fabrication method, a vacuum vapor-deposition method, sputtering method, lamination method of thermally press-binding a metal thin film, and the like are used. A layer made of an electric conductive polymer, or a layer made of a metal oxide, metal fluoride, organic insulation material and the like, may be provided between a cathode and an organic substance layer, and after fabrication of a cathode, a protective layer for protecting the polymer light-emitting device may be installed. For use of the polymer light-emitting device stably for a long period of time, it is preferable to install a protective layer and/or protective cover, for protecting a device from outside.

As the protective layer, resins, metal oxides, metal fluorides, metal borides and the like can be used. As the protective cover, a glass plate, and a plastic plate having a surface which has been subjected to low water permeation treatment, and the like can be used, and a method in which the cover is pasted to a device substrate with a thermosetting resin or photo-curing resin to attain sealing is suitably used. When a space is kept using a spacer, blemishing of a device can be prevented easily. If an inert gas such as nitrogen, argon and the like is filled in this space, oxidation of a cathode can be prevented, further, by placing a drying agent such as barium oxide and the like in this space, it becomes easy to suppress moisture adsorbed in a production process from imparting damage to the device. It is preferable to adopt one strategy among these methods.

The polymer light-emitting device of the present invention can be used for a surface light source, and displays such as a segment display, dot matrix display, liquid crystal display (for example, back light and the like).

For obtaining a surface light emission using the polymer light-emitting device of the present invention, it may be advantageous to place a surface anode and a surface cathode so as to overlap. For obtaining light emission in the form of pattern, there are a method in which a mask having a window in the form of pattern is placed on the surface of the above-mentioned surface light-emitting device, a method in which an organic substance layer in non-light emitting parts is formed with extremely large thickness to give substantially no light emission, a method in which either anode or cathode, or both electrodes are formed in the form pattern. By forming a pattern by any of these methods, and placing several electrodes so that on/off is independently possible, a display of segment type is obtained which can display digits, letters, simple marks and the like. Further, for providing a dot matrix device, it may be permissible that both an anode and a cathode are formed in the form of stripe, and placed so as to cross. By using a method in which several polymer compounds showing different emission colors are painted separately or a method in which a color filter or a fluorescence conversion filter is used, partial color display and multicolor display are made possible. In the case of a dot matrix device, passive driving is possible, and active driving may be carried out in combination with TFT and the like. These displays can be used as a display of a computer, television, portable terminal, cellular telephone, car navigation, view finder of video camera, and the like.

Further, the above-mentioned surface light-emitting device is of self emitting and thin type, and can be suitably used as a planar light source for back light of a liquid crystal display, or as a planar light source for illumination. If a flexible substrate is used, it can also be used as a curved light source or display.

### EXAMPLES

Examples will be shown below for illustrating the present invention further in detail, but the present invention is not limited to them.

Here, the polystyrene-equivalent number average molecular weight and weight average molecular weight were measured by size exclusion chromatography (SEC)(manufactured by Shimadzu Corporation: LC-10 Avp). A polymer to be measured was dissolved in tetrahydrofuran so as to give a concentration of about 0.5 wt%, and the solution was injected in an amount of 30 µL into SEC (GPC). Tetrahydrofuran was used as the mobile phase of SEC (GPC), and allowed to flow at a flow rate of 0.6 mL/min. As the column, two TSKgel Super HM-H (manufactured by Tosoh Corp.) and one TSKgel Super H2000 (manufactured by Tosoh Corp.) were connected serially. A differential refractive index detector (RID-10A: manufactured by Shimadzu Corp.) was used as a detector.

### (Synthesis Example 1)

### Synthesis of N-octylphenoxazine

Under an inert atmosphere, phenoxazine (10.0 g), sodium hydroxide (21.9 g), tetraethylammonium bromide (0.37 g) and dimethyl sulfoxide (34 mL) were mixed, and the mixture was heated up to 80°C, then, 18 mL of water was added and 1-bromooctane (12.9 g) was dropped over a period of 50 minutes. Then, the mixture was heated up to 90°C and stirred for 1 hour, then, cooled down to room temperature. Then, the deposited solid was dissolved in 160 mL of toluene, and washed with water (100 mL) twice, washed with 1 N hydrochloric acid (100 mL) once, and washed with water (100 mL) three times, and allowed to pass through a silica gel column, and subjected to concentration under reduced pressure and drying in vacuo, to obtain 16.0 g of N-octylphenoxazine (purity: 99.4%).
¹H-NMR (300 MHz, CDCl₃); δ 0.89 (t, 3H), 1.15-1.47 (m, 10H), 1.65 (br, 2H), 3.45 (br, 2H), 6.31-6.88 (br, 8H). LC-MS (APPI-MS (posi)): 296 [M+H]⁺

### (Synthesis Example 2)

### Synthesis of 3,7-dibromo-N-octylphenoxazine

Under an inert atmosphere, a solution composed of 1,3-dibromo-5,5-dimethylhydantoin (15.1 g) and N,N-dimethylformamide (15.8 mL) was dropped at room temperature over a period of 30 minutes into a solution prepared by adding dichloromethane (55 mL) to N-octylphenoxazine (15.0 g), and the mixture was stirred for 1 hour, then, stirred at room temperature for 6 hours. The resultant precipitate was filtrated and washed with methanol, then, dried under reduced pressure, to obtain 16.6 g of 3,7-dibromo-N-octylphenoxazine (purity: 99.7%).
¹H-NMR (299.4 MHz, CDCl₃); δ 0.89 (t, 3H), 1.18-1.46 (m, 10H), 1.59 (br, 2H), 3.38 (br, 2H), 6.29 (d, 2H), 6.73 (s, 2H), 6.88 (d, 2H).
LC-MS (APPI-MS (posi)): 452 [M+H]⁺

### (Synthesis Example 3)

### Synthesis of compound (Monomer-1)

A compound (Monomer-1) was synthesized by the following reaction. Hereinafter, the reaction will be described in turn.

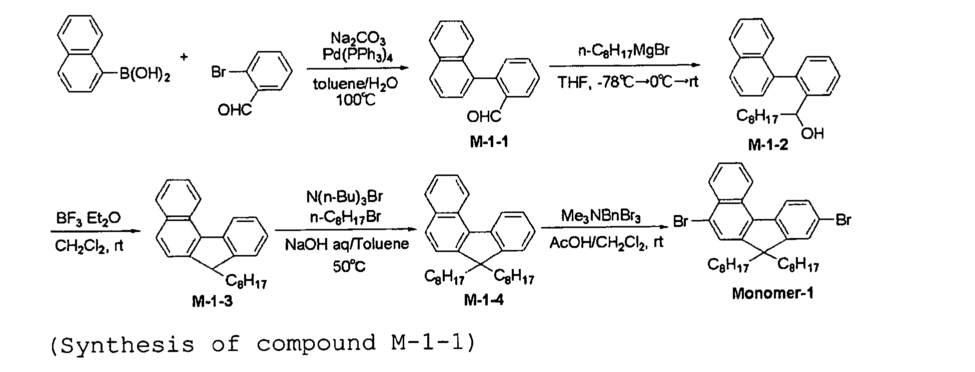

Under an inert atmosphere, into a 300 ml three-necked flask was charged 5.00 g (29 mmol) of 1-naphthaleneboronic acid, 6.46 g (35 mmol) of 2-bromobenzaldehyde, 10.0 g (73 mmol) of potassium carbonate, 36 ml of toluene and 36 ml of ion exchanged water to obtain a mixed solution, and argon was bubbled through this mixed solution for 20 minutes while stirring at room temperature. Subsequently, to this mixed solution was added 16.8 mg (0.15 mmol) of tetrakis(triphenylphosphine)palladium, further, argon was bubbled through the solution for 10 minutes while stirring at room temperature. The mixed solution was heated up to 100°C and reacted for 25 hours. After cooling to room temperature, the organic phase was extracted with toluene, and this was dried over sodium sulfate. The solvent was distilled off from this solution to obtain a residue, and the residue was purified by silica gel column using a toluene:cyclohexane (= 1:2) mixed solvent as a developing solvent, thereby obtaining 5.18 g (yield 86%) of a compound M-1-1 as a white crystal.
The above-described operation was repeated several times
¹H-NMR(300MHz/CDCl₃):
δ7.39 to 7.62(m, 5H), 7.70(m, 2H), 7.94(d, 2H), 8.12(dd, 2H), 9.63(s, 1H)
MS (APCI (+)): (M+H)⁺ 233

### (Synthesis of compound M-1-2)

Under an inert atmosphere, into a 300 ml three-necked flask was charged 8.00 g (34.4 mmol) of the compound M-1-1 and 46 ml of dehydrated THF, and the mixture was cooled down to -78°C. Subsequently, 52 ml of n-octylmagnesium bromide (1.0 mol/l THF solution) was dropped over a period of 30 minutes. After completion of dropping, the mixture was heated up to 0°C, stirred for 1 hour, then, heated up to room temperature and stirred for 45 minutes. The mixed solution was cooled in an ice bath, and to this was added 20 ml of 1N hydrochloric acid to terminate the reaction, and the organic phase was extracted with ethyl acetate, and dried over sodium sulfate. The solvent was distilled off from the organic phase to obtain a residue, and the residue was purified by silica gel column using a toluene:hexane (= 10:1) mixed solvent as a developing solvent, thereby obtaining 7.64 g (yield 64%) of a compound M-1-2 as a pale yellow oil. The oil was subjected to measurement by HPLC (high performance liquid chromatography), to observe two peaks. Since the peaks showed the same mass number by LC-MS measurement, this oil was judged to be a mixture of isomers.

### (Synthesis of compound M-1-3)

Under an inert atmosphere, into a 500ml three-necked flask was charged 5.00 g (14.4 mmol) of the compound M-1-2 (a mixture of isomers) and 74 ml of dehydrated dichloromethane, and the mixture was stirred at room temperature to cause dissolution thereof. Subsequently, into this was dropped an etherate complex of boron trifluoride at room temperature over a period of 1 hour, and after completion of dropping, the mixture was stirred at room temperature for 4 hours. Then, to the reaction mixture was slowly added 125 ml of ethanol while stirring, and after completion of heat generation, the organic phase was extracted with chloroform, washed with water twice, and dried over magnesium sulfate. The solvent was distilled off, then, the residue was purified by silica gel column using hexane as a developing solvent, thereby obtaining 3.22 g (yield 68%) of a compound M-1-3 as a colorless oil.
The above-described operation was repeated several times.
¹H-NMR(300MHz/CDCl₃):
δ0.90(t, 3H), 1.03 to 1.26(m, 14H), 2.13(m, 2H), 4.05(t, 1H), 7.35(dd, 1H), 7.46 to 7.50(m, 2H), 7.59 to 7.65(m, 3H), 7.82(d, 1H), 7.94(d, 1H), 8.35(d, 1H), 8.75(d, 1H) MS(APCI(+)):(M+H)⁺ 329

### (Synthesis of compound M-1-4)

Under an inert atmosphere, into a 200ml three-necked flask was charged 20 ml of ion exchanged water, and 18.9 g (0.47 mol) of sodium hydroxide was added portion-wise while stirring to cause dissolution thereof. The aqueous solution was cooled down to room temperature, then, to this was added 20 ml of toluene, 5.17 g (15.7 mmol) of the compound M-1-3 and 1.52 g (4.72 mmol) of tributylammonium bromide, and the mixture was heated up to 50°C. Further, into this was dropped n-octyl bromide, and after completion of dropping, the mixture was reacted at 50°C for 9 hours. After completion of the reaction, the organic layer was extracted with toluene, washed with water twice, and dried over sodium sulfate. The dried material was purified by silica gel column using hexane as a developing solvent, thereby obtaining 5.13 g (yield 74%) of a compound M-1-4 as a yellow oil.
¹H-NMR(300MHz/CDCl₃):
δ0.52(m, 2H), 0.79(t, 6H), 1.00 to 1.20(m, 22H), 2.05(t, 4H), 7.34(d, 1H), 7.40 to 7.53(m, 2H), 7.63(m, 3H), 7.83(d, 1H), 7.94(d, 1H), 8.31(d, 1H), 8.75(d, 1H)
MS(APCI(+)):(M+H)⁺ 441

### (Synthesis of compound (Monomer-1))

Under an air atmosphere, into a 50 ml three-necked flask was charged 4.00 g (9.08 mmol) of the compound M-1-4 and 57 ml of an acetic acid:dichloromethane (= 1:1) mixed solvent, and the mixture was stirred at room temperature to cause dissolution thereof. Subsequently, 7.79 g (20.0 mmol) of benzyltrimethylammonium tribromide was added, and zinc chloride was added until completion dissolution of benzyltrimethylammonium tribromide while stirring. After stirring at room temperature for 20 hours, 10 ml of a 5% sodium hydrogen sulfite aqueous solution was added to terminate the reaction, and the organic layer was extracted with chloroform, washed with a potassium carbonate aqueous solution twice, and dried over sodium sulfate. The dried material was purified twice by flash column using hexane as a developing solvent, then, re-crystallized from an ethanol:hexane (= 1:1) mixed solvent, subsequently, from an ethanol:hexane (= 10:1) mixed solvent, thereby obtaining 4.13 g (yield 76%)of a compound (Monomer-1) as a white crystal.
¹H-NMR(300MHz/CDCl₃):
δ0.60(m, 2H), 0.91(t, 6H), 1.01 to 1.38(m, 22H), 2.09(t, 4H), 7.62 to 7.75(m, 3H), 7.89(s, 1H), 8.20(d, 1H), 8.47(d,
1H), 8.72(d, 1H)
MS(APPI(+)):(M+H)⁺ 598

### (Example 1) Synthesis of polymer compound <P-1>

The compound (Monomer-1, 0.84 g), 3,7-dibromo-N-octylphenoxazine (0.51 g) and 2,2'-bipyridyl (0.63 g) were charged in a reaction vessel, then, the atmosphere in the reaction system was purged with a nitrogen gas. To this was added 50 g of tetrahydrofuran (dehydrating solvent) which had been deaerated in advance with bubbling with an argon gas. Then, to this mixed solution was added 1.15 g of bis(1,5-cyclooctadiene)nickel(0), and the mixture was reacted at 60°C for 3 hours. The reaction was carried out under a nitrogen gas atmosphere. After the reaction, this solution was cooled down, then, a mixed solution consisting of 50 ml of methanol/50 ml of ion exchanged water was poured, and the mixture was stirred for about 1 hour. Next, the generated precipitate was recovered by filtration.
Next, this precipitate was dried under reduced pressure, then, dissolved in toluene. To the toluene solution was added radiolite, the solution was stirred, then, this toluene solution was filtrated to remove insoluble materials, then, this toluene solution was passed through a column filled with alumina, thereby attaining purification thereof. Next, this toluene solution was washed with ca. 5% hydrochloric acid aqueous solution, and allowed to stand still, subjected to liquid-separation, then, the toluene solution was recovered, then, washed with ca. 5% ammonia water, and allowed to stand still, subjected to liquid-separation, then, the toluene solution was recovered, then, this toluene solution was washed with water, and allowed to stand still, subjected to liquid-separation, then, the toluene solution was recovered. Next, this toluene solution was poured into methanol, to cause re-precipitation. Next, the generated precipitate was recovered, and this precipitate was dried under reduced pressure, to obtain 0.54 g of a polymer. This polymer is called a polymer compound <P-1>. The polymer compound <P-1> had a polystyrene-equivalent number average molecular weight of 6.9×10⁴, and a polystyrene-equivalent weight average molecular weight of 2.1×10⁵.

### (Synthesis Example 4) Synthesis of DBF

DBF was synthesized by the following reaction. This reaction will be described in turn below. 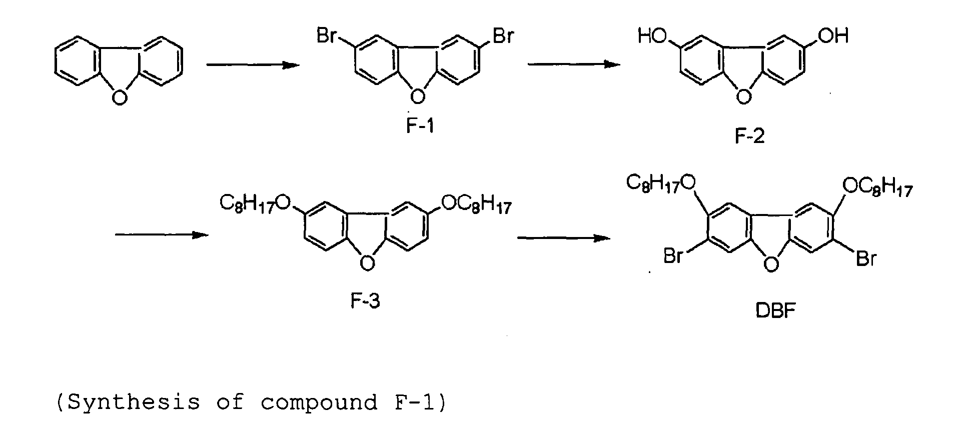 Under an inert atmosphere, into a 1L three-necked flask was charged dibenzofuran (23.2 g, 137.9 mmol) and acetic acid (232 g), and dissolved at room temperature by stirring, then, the solution was heated up to 75°C. After rising of temperature, bromine (92.6 g, 579.3 mmol) diluted with acetic acid (54 g) was dropped. After completion of dropping, the mixture was stirred for 3 hours while maintaining the temperature, and allowed to cool. After confirmation of disappearance of raw materials by TLC, sodium thiosulfate water was added to terminate the reaction, and the mixture was stirred at room temperature for 1 hour. After stirring, the filtration was performed to filtrate a cake, and further, washed with sodium thiosulfate water and water, then, dried.
The resultant crude product was re-crystallized from hexane, to obtain an intended material (yielded amount: 21.8 g, yield :49%)
¹H-NMR(300MHz/CDCl₃):
δ7.44(d, 2H), 7.57(d, 2H), 8.03(s, 2H)

### (Synthesis of compound F-2)

Under an inert atmosphere, into a 500 ml four-necked flask was charged the compound F-1 (16.6 g, 50.9 mmol) and tetrahydrofuran (2.93 g), and the mixture was cooled down to -78°C. n-butyllithium (80 ml <1.6 mol/L hexane solution>, 127.3 mmol) was dropped, then, the mixture was stirred for 1 hour while maintaining the temperature. This reaction solution was dropped into a solution prepared by adding trimethoxyboronic acid (31.7 g, 305.5 mmol) and tetrahydrofuran (250 ml) into a 1000 ml four-necked flask under an inert atmosphere and cooling down to -78°C. After completion of dropping, the temperature thereof was returned slowly to room temperature, the mixture was stirred at room temperature for 2 hours, then, disappearance of raw materials was confirmed by TLC. The mixture after reactionwas poured into concentrated sulfuric acid (30 g) and water (600 ml) in a 2000 ml beaker, to terminate the reaction. Toluene (300 ml) was added, the organic layer was extracted, and the organic layer was washed with water. The solvent was distilled off, then, 8 g of the residue and ethyl acetate (160 ml) were charged into a 300ml four-necked flask, subsequently, 30% hydrogen peroxide water (7.09 g)was added, and the mixture was stirred at 40°C for 2 hours. This reaction solution was poured into an aqueous solution composed of ammonium iron(II) sulfate (71 g) and water (500 ml) in a 1000 ml beaker. After stirring, the organic layer was extracted, and the organic layer was washed with water. The solvent was removed, to obtain 7.57 g of a crude compound F-2.
MS:(M-H)⁺ 199.0

### (Synthesis of compound F-3)

Under an inert atmosphere, into a 200ml four-necked flask was charged the compound F-2 (2.28 g, 11.4 mmol) and N, N-dimethylformamide (23 g), and stirred at room temperature to cause dissolution thereof, then, potassium carbonate (9.45 g, 68.3 mmol) was added and the mixture was heated up to 100°C. After rising of temperature, n-octyl bromide (6.60 g, 34.2 mmol) diluted with N, N-dimethylformamide (11 g) was dropped. After completion of dropping, the mixture was heated up to 60°C, and stirred for 2 hours while maintaining the temperature, and disappearance of raw materials was confirmed by TLC. Water (50 ml) was added to terminate the reaction, subsequently, toluene (50 ml) was added, the organic layer was extracted, and the organic layer was washed with water twice. After drying over anhydrous sodium sulfate, the solvent was distilled off. The resultant crude product was purified by a silica gel column, to obtain an intended material (yielded amount: 1.84 g, yield :38%).
The above-described operation was carried out several times.
MS:M⁺ 425.3

### (Synthesis of compound DBF)

Under an inert atmosphere, into a 500ml four-necked flask was charged the compound D-3 (7.50 g, 17.7 mmol) and N, N-dimethylformamide, and stirred at room temperature to cause dissolution thereof, then, the solution was cooled in an ice bath. After cooling, N-bromosuccinimide (6.38 g, 35.9 mmol) diluted with N, N-dimethylformamide (225 mmol) was dropped. After completion of dropping, the mixture was kept in an ice bath for 1 hour, at room temperature for 18.5 hours, and heated up to 40°C, and stirred for 6.5 hours while maintaining the temperature, and disappearance of raw materials was confirmed by liquid chromatography. The solvent was removed, and toluene (75 ml) was added to cause dissolution, then, the organic layer was washed with water three times. After drying over anhydrous sodium sulfate, the solvent was distilled off. About the half of the resultant crude product was purified by a silica gel column and liquid chromatography preparative isolation, to obtain an intended material (yielded amount: 0.326 g).
¹H-NMR (300MHz/CDCl₃):
δ0.90(t, 6H), 1.26 to 1.95(m, 24H), 4.11(t, 4H), 7.34(s,
   2H), 7.74(s, 2H)
   MS:M⁺ 582.1

### (Example 2)

### Synthesis of polymer compound <P-2>

The compound DBF (0.79 g), 3,7-dibromo-N-octylphenoxazine (0.51 g) and 2,2'-bipyridyl (0.63 g) were charged in a reaction vessel, then, the atmosphere in the reaction system was purged with a nitrogen gas. To this was added 50 g of tetrahydrofuran (dehydrating solvent) which had been deaerated in advance with bubbling with an argon gas. Then, to this mixed solution was added 1.15 g of bis(1,5-cyclooctadiene)nickel(0), and the mixture was reacted at 60°C for 3 hours. The reaction was carried out under a nitrogen gas atmosphere. After the reaction, this solution was cooled down, then, a mixed solution consisting of 50 ml of methanol/50 ml of ion exchanged water was poured, and the mixture was stirred for about 1 hour. Next, the generated precipitate was recovered by filtration.
Next, this precipitate was dried under reduced pressure, then, dissolved in toluene. To the toluene solution was added radiolite, the solution was stirred, then, this toluene solution was filtrated to remove insoluble materials, then, this toluene solution was passed through a column filled with alumina, thereby attaining purification thereof. Next, this toluene solution was washed with ca. 5% hydrochloric acid aqueous solution, and allowed to stand still, subjected to liquid-separation, then, the toluene solution was recovered, then, washed with ca. 5% ammonia water, and allowed to stand still, subjected to liquid-separation, then, the toluene solution was recovered, then, this toluene solution was washed with water, and allowed to stand still, subjected to liquid-separation, then, the toluene solution was recovered. Next, this toluene solution was poured into methanol, to cause re-precipitation. Next, the generated precipitate was recovered, and this precipitate was dried under reduced pressure, to obtain 0.11 g of a polymer. This polymer is called a polymer compound <P-2>. The polymer compound <P-2> had a polystyrene-equivalent number average molecular weight of 8.1×10⁴, and a polystyrene-equivalent weight average molecular weight of 1.5×10⁵.

### (Synthesis Example 5)

### Synthesis of compound (DBT-1)

A compound (DBT-1) was synthesized by the following reaction. Hereinafter, the reaction will be described in turn.

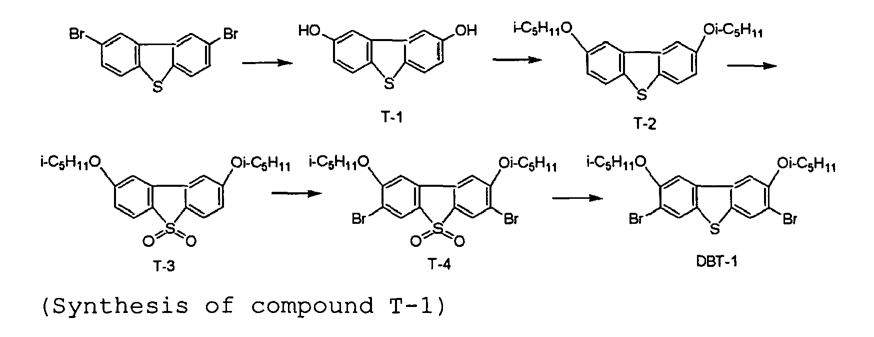

Under an inert atmosphere, into a 1L four-necked flask was charged 2,8-dibromodibenzothiophene (7 g) and THF (280 ml), and dissolved at room temperature by stirring, then, the solution was cooled down to -78°C. n-butyllithium (29 ml, 1.6 mol hexane solution) was dropped. After completion of dropping, the mixture was stirred for 2 hours while maintaining the temperature, and 13 g of trimethoxyboronic acid was dropped. After completion of dropping, the temperature was returned slowly to room temperature. After stirring at room temperature for 3 hours, disappearance of raw materials was confirmed by TLC. 5% sulfuric acid (100 ml) was added to terminate the reaction, and the mixture was stirred at room temperature for 12 hours. Water was added to this and washing thereof was performed, and the organic layer was extracted. The solvent was substituted by ethyl acetate, then, 5 ml of 30% hydrogen peroxide water was added, and the mixture was stirred at 40°C for 5 hours. Thereafter, the organic layer was extracted, and washed with a 10% ammonium iron(II) sulfate aqueous solution, then, dried to remove the solvent, obtaining 4.43 g of a brown solid. Accordiing to LC-MS measurement, by-products such as a dimer and the like were produced, and the purity of the compound T-1 was 77% (LC area percentage). MS(APCI(-)): (M-H)⁻ 215

### (Synthesis of compound T-2)

Under an inert atmosphere, the compound T-1 (142.0 g), i-pentyl bromide (297.5 g) and potassium carbonate (399.3 g) were charged, and methyl isobutyl ketone (355.0 g) was added as a solvent, and the mixture was refluxed by heating at 110°C for 6.5 hours. After completion of the reaction, a solid component was filtrated, and separation into toluene and water was performed, and the organic layer was extracted, further, washed with water twice, then, the organic layer was concentrated. The resultant solid was purified by a silica gel column (developing solvent: hexane/chloroform = 5/1) to obtain 55.4 g (yield 33.7%, purity 91.4%) of a compound T-2.

### (Synthesis of compound T-3)

Under an inert atmosphere, 1.22 g of tungsten, 5.6 ml of water and 11 ml of 30% hydrogen peroxide water were added, and 2086 ml of ethanol was added. Thereafter, 79.0 g of the compound T-2 and 237 ml of ethanol were added into the system, and 55.3 ml of 30% hydrogen peroxide water was dropped. After completion of dropping, the mixture was stirred at 45°C for 4 hours, and after completion of the reaction, the mixture was cooled down to room temperature, then, 711 ml of a 6% sodium thiosulfate aqueous solution was dropped, and a solid component was filtrated, and washed with 500 ml of water, then, repulp washing with water was carried out, to obtain 80.1 g (purity 97%, yield 93%) of a compound T-3.

### (Synthesis of compound T-4)

Under an inert atmosphere, 80.0 g of the compound T-3 and 640 g of an acetic acid/chloroform (= 1:1) mixed solution were added, and stirred at 80°C to cause dissolution thereof. Subsequently, 115.2 g of bromine was dissolved in 114 ml of the above-described solvent and this solution was dropped, and the mixture was stirred for 1.75 hours. After completion of the reaction, the mixture was dropped into 1308 ml of methanol, and the generated solid was filtrated. The resultant solid was dissolved in 500 ml of chloroform, and, and washed with 400 ml of a 2% sodium thiosulfate aqueous solution, 300 ml of a 2% sodium carbonate aqueous solution and 300 ml of water twice , and the organic layer was concentrated. Thereafter, repulp washing was performed with 300 ml of methanol, to obtain 98.1 g (purity 98.4%, yield 83.6%) of a compound T-4.

### (Synthesis of compound DBT-1)

Under an inert atmosphere, 98.1 g of the compound T-4 and 2255 ml of dehydrated ether were added, the temperature thereof was adjusted to 20°C, then, 8.0 g of lithium aluminum hydride was added portion-wise in four times and the mixture was stirred.
Three hours after, further 1.0 g of lithium aluminum hydride was added, and the mixture was stirred for 1 hour. Thereafter, the mixture was cooled down to 2°C, then, 739 ml of 5% hydrochloric acid was dropped, and the organic layer was extracted. The resultant organic layer was washed with 700 ml of water, then, dried over sodium sulfate, then, filtrated and concentrated. The resultant solid was separated and purified by a silica gel column (developing solvent: toluene/cyclohexane = 1/109), and the resultant solid was subjected to re-crystallization repeatedly with ethanol/hexane, to obtain a compound DBT-1 (49.1 g, purity 99.8%).

### (Example 3)

### Synthesis of polymer compound <P-3>

The compound DBT-1 (0.72 g), 3,7-dibromo-N-octylphenoxazine (0.51 g) and 2, 2'-bipyridyl (0.63 g) were charged in a reaction vessel, then, the atmosphere in the reaction system was purged with a nitrogen gas. To this was added 50 g of tetrahydrofuran (dehydrating solvent) which had been deaerated in advance with bubbling with an argon gas. Then, to this mixed solution was added 1.15 g of bis(1,5-cyclooctadiene)nickel(0), and the mixture was reacted at 60°C for 3 hours. The reaction was carried out under a nitrogen gas atmosphere. After the reaction, this solution was cooled down, then, a mixed solution consisting of 50 ml of methanol/50 ml of ion exchanged water was poured, and the mixture was stirred for about 1 hour. Next, the generated precipitate was recovered by filtration.
Next, this precipitate was dried under reduced pressure, then, dissolved in toluene. To the toluene solution was added radiolite, the solution was stirred, then, this toluene solution was filtrated to remove insoluble materials, then, this toluene solution was passed through a column filled with alumina, thereby attaining purification thereof. Next, this toluene solution was washed with ca. 5% hydrochloric acid aqueous solution, and allowed to stand still, subjected to liquid-separation, then, the toluene solution was recovered, then, washed with ca. 5% ammonia water, and allowed to stand still, subjected to liquid-separation, then, the toluene solution was recovered, then, this toluene solution was washed with water, and allowed to stand still, subjected to liquid-separation, then, the toluene solution was recovered. Next, this toluene solution was poured into methanol, to cause re-precipitation. Next, the generated precipitate was recovered, and this precipitate was dried under reduced pressure, to obtain 0.05 g of a polymer. This polymer is called a polymer compound <P-3>. The polymer compound <P-3> had a polystyrene-equivalent number average molecular weight of 2.1×10⁵, and a polystyrene-equivalent weight average molecular weight of 5.8×10⁵.

### (Synthesis Example 6)

### Synthesis of polymer compound <P-4>

2,7-dibromo-9,9-dioctylfluorene (0.77 g), 3,7-dibromo-N-octylphenoxazine (0.51 g) and 2, 2'-bipyridyl (0.63 g) were charged in a reaction vessel, then, the atmosphere in the reaction system was purged with a nitrogen gas. To this was added 50 g of tetrahydrofuran (dehydrating solvent) which had been deaerated in advance with bubbling with an argon gas. Then, to this mixed solution was added 1.15 g of bis(1,5-cyclooctadiene)nickel(0), and the mixture was reacted at 60°C for 3 hours. The reaction was carried out under a nitrogen gas atmosphere.
After the reaction, this solution was cooled down, then, a mixed solution consisting of 50 ml of methanol/50 ml of ion exchanged water was poured, and the mixture was stirred for about 1 hour. Next, the generated precipitate was recovered by filtration.
Next, this precipitate was dried under reduced pressure, then, dissolved in toluene. To the toluene solution was added radiolite, the solution was stirred, then, this toluene solution was filtrated to remove insoluble materials, then, this toluene solution was passed through a column filled with alumina, thereby attaining purification thereof. Next, this toluene solution was washed with ca. 5% hydrochloric acid aqueous solution, and allowed to stand still, subjected to liquid-separation, then, the toluene solution was recovered, then, washed with ca. 5% ammonia water, and allowed to stand still, subjected to liquid-separation, then, the toluene solution was recovered, then, this toluene solution was washed with water, and allowed to stand still, subjected to liquid-separation, then, the toluene solution was recovered. Next, this toluene solution was poured into methanol, to cause re-precipitation. Next, the generated precipitate was recovered, and this precipitate was dried under reduced pressure, to obtain 0.12 g of a polymer. This polymer is called a polymer compound <P-4>. The polymer compound <P-4> had a polystyrene-equivalent number average molecular weight of 3.5×10⁵, and a polystyrene-equivalent weight average molecular weight of 9.2×10⁵.

### (Synthesis Example 7) Synthesis of compound (Monomer-2)

A 100 mL four-necked flask was purged with an argon gas, then, the compound (Monomer-1)(3.2 g, 5.3 mmol), bispinacolatediboron (3.8 g, 14.8 mmol), PdCl₂(dppf) (0.39 g, 0.45 mmol), bis(diphenylphosphino)ferrocene (0.27 g, 0.45 mmol) and potassium acetate (3.1 g, 32 mmol) were charged, and 45 ml of dehydrated dioxane was added. Under an argon atmosphere, the mixture was heated up to 100°C and reacted for 36 hours. After allowing to cool, filtration was performed with a pre-coating with 2 g of celite, and concentrated to obtain a black solution. This was dissolved in 50 g of hexane and colored components were removed by activated carbon, to obtain 37 g of a pale yellow solution (in filtration, pre-coated with 5 g of radiolite (manufactured by Showa Chemical Industry Co., Ltd.)).
Thereafter, 6 g of ethyl acetate, 12 g of dehydrated methanol and 2 g of hexane were added, and immersed in a dry ice-methanol bath, to obtain 2.1 g of a compound (Monomer-2) as a colorless crystal.

### (Example 4)

### Synthesis of polymer compound <P-5>

Monomer-2 (1.63 g), 2,7-dibromo-9,9-dioctylfluorene (1.19 g), 3,7-dibromo-N-octylphenoxazine (0.16 g), palladium acetate (0.2 mg), tri(2-methoxyphenyl)phosphine (1.7 mg), Aliquat 336 (0.30 g, manufactured by Aldrich) and toluene (23 ml) were mixed, and under an inert atmosphere, the mixture was heated up to 105°C. Into this reaction solution, a 2M Na₂CO₃ aqueous solution (6.4 ml) was dropped, and refluxed for 4 hours. After the reaction, phenylboric acid (30 mg) was added, and the mixture was further refluxed for 1 hour. Then, a sodium diethyldithiacarbamate aqueous solution was added and the mixture was stirred at 80°C for 2 hours. After cooling, the mixture was washed with water (25 ml) twice, with a 3% acetic acid aqueous solution (25 ml) twice and with water (25 ml) twice, and purified by passing through an alumina column and a silica gel column. The resultant toluene solution was dropped into methanol (800 ml), and the mixture was stirred for 1 hour, then, the resultant solid was filtrated and dried. The yielded amount of the resultant polymer compound <P-5> was 1.68 g.
The polymer compound <P-5> had a polystyrene-equivalent number average molecular weight of 1.1×10⁵ and a polystyrene-equivalent weight average molecular weight of 2.6×10⁵.

### (Synthesis Example 8)

### Synthesis of polymer compound <P-6>

Under an inert atmosphere, 2,7-bis(1,3,2-dioxaborolan-2-yl)-9,9-dioctylfluorene (1.37 g), 2,7-dibromo-9,9-dioctylfluorene (1.22 g), 3,7-dibromo-N-octylphenoxazine (0.18 g), palladium acetate (0.4 mg), tri(2-methoxyphenyl)phosphine (4.6 mg), Aliquat 336 (0.24 g, manufactured by Aldrich) and toluene (20 ml) were mixed, and heated up to 105°C. Into this reaction solution, a 2M Na₂CO₃ aqueous solution (3.6 ml) was dropped, and refluxed for 4 hours. After the reaction, phenylboric acid (22 mg) was added, and the mixture was further refluxed for 1 hour. Then, a sodium diethyldithiacarbamate aqueous solution was added and the mixture was stirred at 80°C for 2 hours. After cooling, the mixture was washed with water (25 ml) twice, with a 3% acetic acid aqueous solution (25 ml) twice and with water (25 ml) twice, and purified by passing through an aluminum column and a silica gel column. The resultant toluene solution was dropped into methanol (800 ml), and the mixture was stirred for 1 hour, then, the resultant solid was filtrated and dried. The yielded amount of the resultant polymer compound <P-6> was 1.86 g.
The polymer compound <P-6> had a polystyrene-equivalent number average molecular weight of 9.1×10⁴ and a polystyrene-equivalent weight average molecular weight of 2.1×10⁵.

### (Synthesis Example 9)

### Synthesis of polymer compound <P-7>

In a 200 ml separable flask, 0.91 g of Aliquat 336, 5.23 g of the compound D and 4.55 g of the compound E were placed, and the atmosphere in the flask was purged with nitrogen. Toluene (70 ml) was added, and 2.0 mg of palladium acetate and 15.1 mg of tris(o-tolyl)phosphine were added, and the mixture was refluxed. A sodium carbonate aqueous solution (19 ml) was dropped, then, the mixture was stirred overnight under reflux, then, 0.12 g of phenylboric acid was added and the mixture was stirred for 7 hours. Toluene (30 ml) was added and the reaction solution was separated, and the organic phase was washed with an acetic acid aqueous solution and water, then, a sodium N,N-diethyl carbamate aqueous solution was added and the mixture was stirred for 4 hours. After liquid-separation, the solution was passed through a silica gel-alumina column, and washed with toluene. The resultant solution was dropped into methanol, to cause precipitation of a polymer. After filtration and drying under reduced pressure, the polymer was dissolved in toluene, and the resultant toluene solution was dropped into methanol, to cause precipitation of a polymer. The polymer was subjected to filtration and drying under reduced pressure, to obtain 6.33 g of a polymer. This polymer is called a polymer compound <P-7>. The polymer compound had a polystyrene-equivalent number average molecular weight of 8.8×10⁴ and a polystyrene-equivalent weight average molecular weight of 3.2×10⁵.

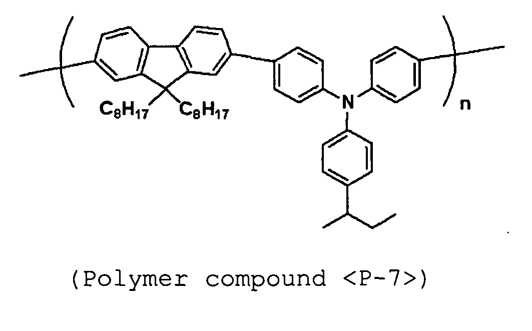

### (Preparation Example 1)

### Preparation of solution of polymer compound <P-7>

The polymer compound <P-7> was dissolved in xylene, to prepare a solution 1 having a polymer concentration of 0.5 wt%.

### (Example 5)

### Preparation of solution of polymer compound <P-1>

The polymer compound <P-1> obtained above was dissolved in xylene, to prepare a solution 2 having a polymer concentration of 1.4 wt%.

### (Example 6) Fabrication of polymer light-emitting device

On a glass substrate carrying thereon an ITO film having a thickness of 150 nm formed by a sputtering method, a suspension of poly(3,4)ethylenedioxythiophene/polystyrenesulfonic acid (manufactured by Starck) was spin-coated to form a film with a thickness of about 65 nm, and dried on a hot plate at 200°C for 15 minutes. Next, the solution 1 was used and spin-coated to form a film having a thickness of about 10 nm, then, dried at 200°C for 1 hour under a nitrogen atmosphere having an oxygen concentration and a water concentration of 10 ppm or less (by weight). Then, the solution 2 was used and spin-coated to form a film having a thickness of about 100 nm. The film was dried at 130°C for 20 minutes under a nitrogen atmosphere having an oxygen concentration and a water concentration of 10 ppm or less (by weight). After pressure reduction to 1.0×10⁻⁴ Pa or less, barium was vapor-deposited with a thickness of about 5 nm, then, aluminum was vapor-deposited with a thickness of about 80 nm, as a cathode. After vapor deposition, encapsulation was performed using a glass substrate, to fabricate a polymer light-emitting device. The device constitution includes: ITO/BaytronP (about 65 nm)/<P-7> (10 nm)/<P-1> (about 100 nm)/Ba/Al

### Performance of polymer light-emitting device

By applying voltage on the resultant device, EL emission was obtained from this device. The resultant polymer light-emitting device showed a maximum light emitting efficiency of 9.27 cd/A at 9.2 V.

### (Preparation Example 2)

### Preparation of solution of polymer compound <P-4>

The polymer compound <P-4> obtained above was dissolved in xylene, to prepare a solution 3 having a polymer concentration of 0.5 wt%.

### (Comparative Example 1) Fabrication of polymer light-emitting device

Using the solution 3 instead of the solution 2, a polymer light-emitting device was fabricated in the same manner as in Example 6.
The thickness of the light emitting layer was about 105 nm. The device constitution includes: ITO/BaytronP (about 65 nm)/<P-7> (10 nm)/<P-4> (about 105 nm)/Ba/Al

### Performance of polymer light-emitting device

By applying voltage on the resultant device, EL emission was obtained from this device. The resultant polymer light-emitting device showed a maximum light emitting efficiency of 6.62 cd/A at 10.0 V.

### (Example 7)

### Preparation of solution of polymer compound <P-2>

The polymer compound <P-2> obtained above was dissolved in xylene, to prepare a solution 4 having a polymer concentration of 1.5 wt%.

### (Example 8) Fabrication of polymer light-emitting device

Using the solution 4 instead of the solution 2, a polymer light-emitting device was fabricated in the same manner as in Example 6.
The thickness of the light emitting layer was about 90 nm. The device constitution includes: ITO/BaytronP (about 65 nm)/<P-7> (10 nm)/<P-2> (about 90 nm)/Ba/Al

### Performance of polymer light-emitting device

By applying voltage on the resultant device, EL emission was obtained from this device. The resultant polymer light-emitting device showed a maximum light emitting efficiency of 7.03 cd/A at 7.6 V.

### (Example 9)

### Preparation of solution of polymer compound <P-5>

The polymer compound <P-5> obtained above was dissolved in xylene, to prepare a solution 5 having a polymer concentration of 1.4 wt%.

### (Example 10) Fabrication of polymer light-emitting device

Using the solution 5 instead of the solution 2, a polymer light-emitting device was fabricated in the same manner as in Example 6.
The thickness of the light emitting layer was about 95 nm. The device constitution includes: ITO/BaytronP (about 65 nm)/<P-7> (10 nm)/<P-5> (about 95 nm)/Ba/Al

### Performance of polymer light-emitting device

By applying voltage on the resultant device, EL emission was obtained from this device. The resultant polymer light-emitting device showed a maximum light emitting efficiency of 8.25 cd/A at 10.2 V.

### (Preparation Example 3)

### Preparation of solution of polymer compound <P-6>

The polymer compound <P-6> obtained above was dissolved in xylene, to prepare a solution 6 having a polymer concentration of 1.2 wt%.

### (Comparative Example 2) Fabrication of polymer light-emitting device

Using the solution 6 instead of the solution 2, a polymer light-emitting device was fabricated in the same manner as in Example 6.
The thickness of the light emitting layer was about 110 nm. The device constitution includes: ITO/BaytronP (about 65 nm)/<P-7> (10 nm)/<P-6> (about 110 nm)/Ba/Al

### Performance of polymer light-emitting device

By applying voltage on the resultant device, EL emission was obtained from this device. The resultant polymer light-emitting device showed a maximum light emitting efficiency of 5.88 cd/A at 9.6 V.

The maximum light emitting efficiencies of the fabricated polymer light-emitting devices are shown in Table 1. The polymer light-emitting devices of the examples showed higher maximum light emitting efficiencies than the polymer light-emitting devices of the comparative examples.

**Table 1**

| | Polymer compound | Maximum light emitting efficiency (cd/A) |
|---|---|---|
| Example 6 | Polymer compound <P-1> | 9.27 |
| Comparative Example 1 | Polymer compound <P-4> | 6.62 |
| Example 8 | Polymer compound <P-2> | 7.03 |
| Example 10 | Polymer compound <P-5> | 8.25 |
| Comparative Example 2 | Polymer compound <P-6> | 5.88 |

### Industrial Applicability

When the polymer compound of the present invention is used as a light emitting material for a polymer light-emitting device, the polymer light-emitting device shows increased light emitting efficiency.

## Claims

1. A polymer compound comprising a repeating unit of the formula (1), and at least one repeating unit selected from the group consisting of a repeating unit of the formula (2) and a repeating unit of the formula (3): 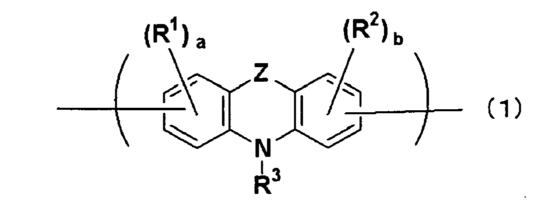 [in the formula (1), R³ represents an alkyl group, R¹ and R² represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, cyano group or nitro group, a and b represent each independently an integer of 0 to 3. Z represents -O- or - S-. When there exists a plurality of R¹, they may be the same or different. When there exists a plurality of R², they may be the same or different.] 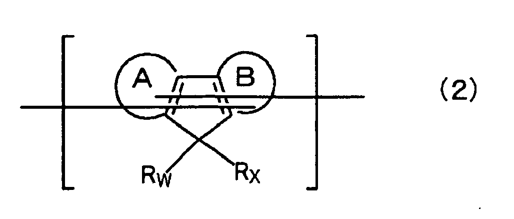 [in the formula (2), ring A and ring B represent each independently an aromatic hydrocarbon ring optionally having a substituent, at least one of ring A and ring B is an aromatic hydrocarbon ring obtained by condensation of two or more benzene rings, two connecting bonds are respectively present on ring A or ring B. R_{w} and Rₓ represent each independently a hydrogen atom, alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group or cyano group. R_{w} and Rₓ may be mutually connected to form a ring.] 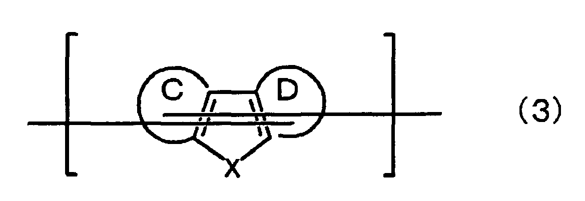 [in the formula (3), ring C and ring D represent each independently an aromatic ring optionally having a substituent, two connecting bonds are respectively present on ring C or ring D. X represents -O-, -S-, -S(=O)-, - S(=O)₂-, -Si(R⁴)₂-Si(R⁴)₂-, -Si(R⁴)₂-, -B(R⁴)-, -P(R⁴)-, - P(=O)(R⁴)-, -O-C(R⁴)₂- or -N=C(R⁴)-, R⁴ represents a hydrogen atom, alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group or cyano group. When there exists a plurality of R⁴, they may be the same or different.]

2. The polymer compound according to Claim 1, wherein the repeating unit of the formula (1) is a repeating unit of the formula (4): 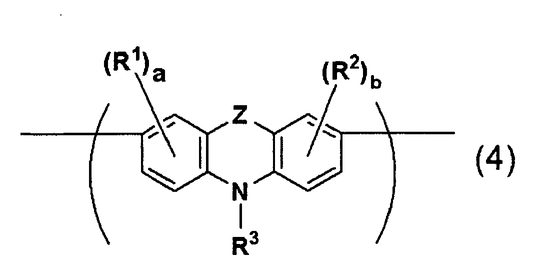 [in the formula (4), R¹, R², R³, a, b and Z represent the same meaning as described above.]

3. The polymer compound according to Claim 1 or 2, wherein a is 0 and b is 0.

4. The polymer compound according to any one of Claims 1 to 3, wherein Z is -O-.

5. The polymer compound according to any one of Claims 1 to 4, wherein the repeating unit of the formula (2) is a repeating unit selected from the group consisting of a repeating unit of the formula (2-1), a repeating unit of the formula (2-2), a repeating unit of the formula (2-3) and a repeating unit of the formula (2-4): 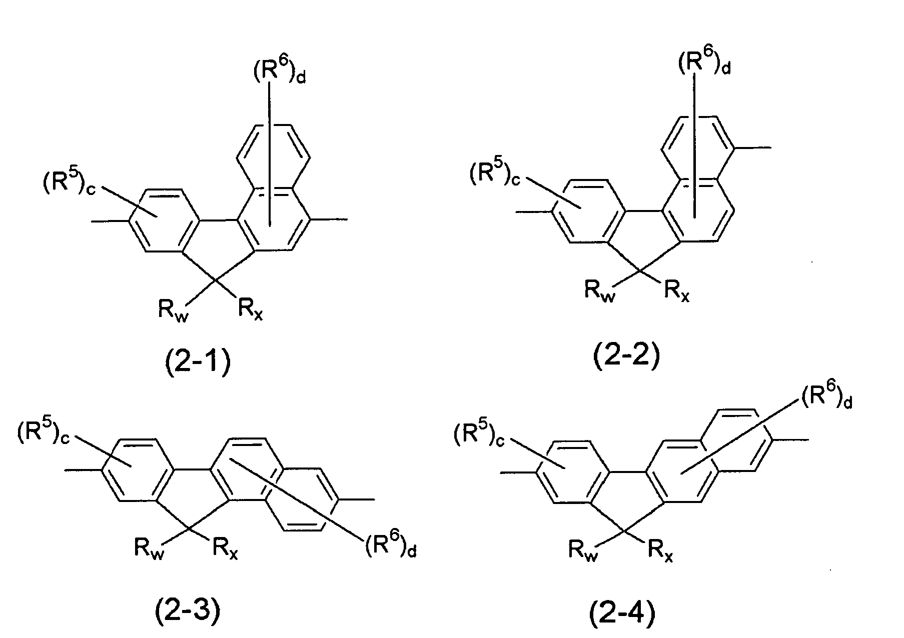 [in the formulae (2-1) to (2-4), R⁵ and R⁶ represent each independently an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group or cyano group. c represents an integer of 0 to 3, and d represents an integer of 0 to 5. When there exists a plurality of R⁵, they may be the same or different. When there exists a plurality of R⁶, they may be the same or different. R_{w} and Rₓ represent the same meaning as described above, R_{w} and Rₓ may be mutually connected to form a ring.]

6. The polymer compound according to Claim 5, wherein the repeating unit of the formula (2-1) is a repeating unit of the formula (2-5): 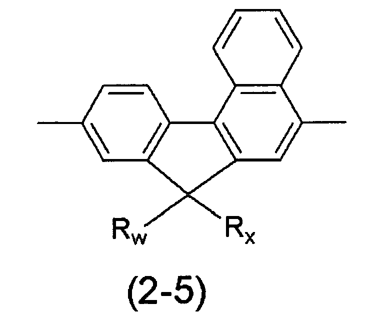 [in the formula (2-5), R_{w} and Rₓ represent the same meaning as described above.]

7. The polymer compound according to Claim 6, wherein R_{w} and Rₓ represent an alkyl group.

8. The polymer compound according to any one of Claims 1 to 7, wherein the repeating unit of the formula (3) is a repeating unit selected from the group consisting of a repeating unit of the formula (3-A), a repeating unit of the formula (3-B) and a repeating unit of the formula (3-C): 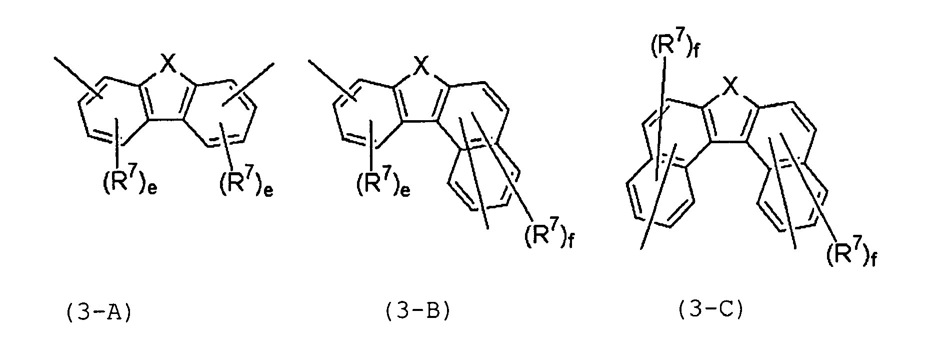 [in the formulae (3-A) to (3-C), X represents the same meaning as described above, R⁷ represents an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group or cyano group. e represents an integer of 0 to 3, and f represents an integer of 0 to 5. When there exists a plurality of e, they may be the same or different, and when there exists a plurality of f, they may be the same or different. When there exists a plurality of R⁷, they may be the same or different.]

9. The polymer compound according to Claim 8, wherein the repeating unit of the formula (3-A) is a repeating unit of the formula (3-D): 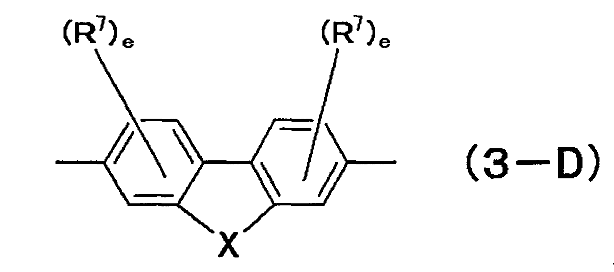 (in the formula (3-D), X, R⁷ and e represent the same meaning as described above.)

10. The polymer compound according to Claim 8 or 9, wherein X is -O- or -S-.

11. The polymer compound according to any one of Claims 1 to 10, wherein the polystyrene-equivalent number average molecular weight is 10³ to 10⁸.

12. A composition comprising the polymer compound as described in any one of Claims 1 to 11.

13. A polymer light-emitting device having electrodes consisting of an anode and a cathode, and a layer containing the polymer compound as described in any one of Claims 1 to 11 between the electrodes.

14. A display comprising the polymer light-emitting device as described in Claim 13.

15. A liquid composition comprising the polymer compound as described in any one of Claims 1 to 11 and a solvent.

16. A thin film comprising the polymer compound as described in any one of Claims 1 to 11.

17. An organic transistor comprising the polymer compound as described in any one of Claims 1 to 11.

18. A solar battery comprising the polymer compound as described in any one of Claims 1 to 11.
